# EUROPEAN PATENT APPLICATION

(11) **EP 3 051 703 A1**
(43) Date of publication of application: **03.08.2016**
(21) Application number: 14848190.6
(22) Date of filing: 12.09.2014
(51) Int. Cl.: H03M 13/19, H03M 13/27

(54) **DATA PROCESSING DEVICE AND DATA PROCESSING METHOD**

(30) Priority: 26.09.2013 JP 2013199086
(71) Applicant: Sony Corporation, Tokyo 108-0075 (JP)
(72) Inventor: SHINOHARA Yuji, Tokyo 108-0075 (JP); YAMAMOTO Makiko, Tokyo 108-0075 (JP)
(74) Representative: Witte, Weller & Partner Patentanwälte mbB
(86) International application number: PCT/JP2014/074197
(87) International publication number: WO 2015/045898

(57) **Abstract**

The present technology relates to a data processing device and a data processing method that make it possible to ensure good communication quality in a data transmission using LDPC codes. In group-wise interleave, an LDPC code whose code length is 16200 bits and code rate is 6/15, 7/15, 8/15, or 9/15 is interleaved in a 360-bit group unit. In group-wise deinterleave, a sequence of the LDPC code after group-wise interleave obtained from data transmitted from a transmitting device to the original sequence. The present technology can be applied, for example, to data transmission or the like using the LDPC codes.

## Description

### Technical Field

The present technology relates to a data processing device and a data processing method. In particular, the present technology relates to a data processing device and a data processing method that make it possible to ensure good communication quality in a data transmission using LDPC codes.

### Background Art

Some of the information to be published in this specification and drawings, Samsung Electronics Co. to conduct joint development with Sony Corporation, Ltd. (hereinafter, referred to as Samsung) is one that has received the offer from the (explicitly in the drawings).

LDPC (Low Density Parity Check) code has high error correction capabilities, and is widely used in recent years in a transmission system including a digital broadcasting such as DVB (Digital Video Broadcasting)-S.2, DVB-T.2, DVB-C.2 in Europe, and ATSC (Advanced Television Systems Committee)3.0 in the United States (for example, refer to Non-Patent Document 1).

Recent studies has revealed that as the code length of the LDPC code is prolonged, the LDPC code achieves the performance as close as the Shannon limit similar to the turbo code or the like. Also, the LDPC code has a property that the minimum distance is proportional to the code length. As the advantageous features of the LDPC code, the block error probability characteristic is good, and a so-called error floor phenomenon that is observed in the decoding characteristic of the turbo code or the like is less likely to occur.

Non-Patent Document 1: DVB-S.2: ETSI EN 302 307 V1.2.1 (2009-08)

### Summary of Invention

### Problem to be solved by the Invention

Data transmission using an LDPC code, for example, LDPC codes, is a symbol of QPSK (Quadrature Phase Shift Keying) orthogonal modulation such as (digital modulation) (is symbolized), the symbol, the signal points of orthogonal modulation it is mapped to be transmitted.

The data transmission using the LDPC code as described above, it is becoming spread worldwide and is requested to ensure a satisfactory communication quality.

The present technology has been made in view of such circumstances, and, in the data transmission using the LDPC code, is to ensure good communication quality.

### Means for solving the Problem

The first data processing device/data processing method of the present technology includes a group-wise interleave unit/step of performing group-wise interleave of interleaving in a 360-bit group unit an LDPC code whose code length is 16200 bits and code rate is 6/15, 7/15, 8/15 or 9/15, the (i + 1)th bit group from the beginning of the LDPC code of the 16200 bits being as a bit group i, and in the group-wise interleave, a sequence of bit group 0 to 44 of the 16200 bits of the LDPC code being interleaved into the following sequence of the bit group: 15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

The first data processing device/data processing method of the present technology performs group-wise interleave of interleaving in a 360-bit group unit the LDPC code whose code length is 16200 bits and code rate is 6/15, 7/15, 8/15 or 9/15. In the group-wise interleave, the sequence of the 16200 bits of the LDPC code bit group 0 to 44 is interleaved into the following sequence of the bit group: 15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

The second data processing device/data processing method of the present technology includes a group-wise interleave unit of performing group-wise interleave of interleaving in a 360-bit group unit an LDPC code whose code length is 16200 bits and code rate is 6/15, 7/15, 8/15 or 9/15, and a group-wise deinterleave unit/step of returning a sequence of the LDPC code after the group-wise interleave obtained from data transmitted from a transmitting device to the original sequence, the (i + 1)th bit group from the beginning of the LDPC code of the 16200 bits being as a bit group i, and in the group-wise interleave, a sequence of bit group 0 to 44 of the 16200 bits of the LDPC code being interleaved into the following sequence of the bit group: 15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

The second data processing device/data processing method of the present technology includes a group-wise interleave unit of performing group-wise interleave of interleaving in a 360-bit group unit an LDPC code whose code length is 16200 bits and code rate is 6/15, 7/15, 8/15 or 9/15, and of returning the sequence of the LDPC code after the group-wise interleave obtained from data transmitted from a transmitting device to the original sequence, the (i + 1)th bit group from the beginning of the LDPC code of the 16200 bits being as a bit group i, and in the group-wise interleave, a sequence of bit group 0 to 44 of the 16200 bits of the LDPC code being interleaved into the following sequence of the bit group: 15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

The data processing apparatus may be an independent apparatus or may be an internal block making up one device.

### Effects of the Invention

According to the present technology, in the data transmission using the LDPC code, it is possible to ensure good communication quality.

Here, the effects described in are not necessarily limited, it may be any of the effects described in the present disclosure.

### Brief Description of Drawings

[Fig. 1] A diagram illustrating a parity check matrix H of an LDPC code.
[Fig. 2] A flowchart illustrating a decoding procedure of an LDPC code.
[Fig. 3] A diagram illustrating an example of an LDPC code of the parity check matrix.
[Fig. 4] A diagram illustrating a Tanner graph of the parity check matrix.
[Fig. 5] A diagram showing a variable node.
[Fig. 6] A diagram showing a check node.
[Fig. 7] A diagram illustrating an example configuration of an embodiment of a transmission system to which the present technology is applied.
[Fig. 8] A block diagram showing a configuration example of the transmitting apparatus 11.
[Fig. 9] A block diagram showing a configuration example of the bit interleaver 116.
[Fig. 10] A diagram illustrating a parity check matrix [Fig. 11] A diagram illustrating a parity matrix.
[Fig. 12] A diagram illustrating a parity check matrix of an LDPC code prescribed in the standard of the DVB-T.2.
[Fig. 13] A diagram illustrating a parity check matrix of an LDPC code prescribed in the standard of the DVB-T.2.
[Fig. 14] A diagram illustrating a Tanner graph for decoding of LDPC codes.
[Fig. 15] A diagram showing a parity matrix H_{T} having a staircase structure and a diagram illustrating a Tanner graph corresponding to the parity matrix H_{T}.
[Fig. 16] A diagram illustrating a parity matrix H_{T} of the parity check matrix H corresponding to the LDPC code after the parity interleave.
[Fig. 17] A flowchart for explaining the processing performed by a bit interleaver 116 and a mapper 117.
[Fig. 18] A block diagram showing a configuration example of an LDPC encoder 115.
[Fig. 19] A flowchart illustrating a process of the LDPC encoder 115.
[Fig. 20] A diagram illustrating an example of a parity check matrix initial value table of a code rate of 1/4 and a code length of 16200.
[Fig. 21] A diagram for explaining a method of determining a parity check matrix H from the parity check matrix initial value table.
[Fig. 22] A diagram showing a parity check matrix initial value table of a first new LDPC code whose code length N is 64k bits and code rate r is 7/15.
[Fig. 23] A diagram showing a parity check matrix initial value table of a first new LDPC code whose code length N is 64k bits and code rate r is 7/15.
[Fig. 24] A diagram showing a parity check matrix initial value table of a first new LDPC code whose code length N is 64k bits and code rate r is 7/15.
[Fig. 25] A diagram showing a parity check matrix initial value table of a first new LDPC code whose code length N is 64k bits and code rate r is 9/15.
[Fig. 26] A diagram showing a parity check matrix initial value table of a first new LDPC code whose code length N is 64k bits and code rate r is 9/15.
[Fig. 27] A diagram showing a parity check matrix initial value table of a first new LDPC code whose code length N is 64k bits and code rate r is 9/15.
[Fig. 28] A diagram showing a parity check matrix initial value table of a first new LDPC code whose code length N is 64k bits and code rate r is 11/15.
[Fig. 29] A diagram showing a parity check matrix initial value table of a first new LDPC code whose code length N is 64k bits and code rate r is 11/15.
[Fig. 30] A diagram showing a parity check matrix initial value table of a first new LDPC code whose code length N is 64k bits and code rate r is 11/15.
[Fig. 31] A diagram showing a parity check matrix initial value table of a first new LDPC code whose code length N is 64k bits and code rate r is 13/15.
[Fig. 32] A diagram showing a parity check matrix initial value table of a first new LDPC code whose code length N is 64k bits and code rate r is 13/15.
[Fig. 33] A diagram showing a parity check matrix initial value table of a first new LDPC code whose code length N is 64k bits and code rate r is 13/15.
[Fig. 34] A diagram showing a parity check matrix initial value table of a first new LDPC code whose code length N is 16k bits and code rate r is 6/15.
[Fig. 35] A diagram showing a parity check matrix initial value table of a first new LDPC code whose code length N is 16k bits and code rate r is 8/15.
[Fig. 36] A diagram showing a parity check matrix initial value table of a first new LDPC code whose code length N is 16k bits and code rate r is 10/15.
[Fig. 37] A diagram showing a parity check matrix initial value table of a first new LDPC code whose code length N is 16k bits and code rate r is 12/15.
[Fig. 38] A diagram showing a parity check matrix initial value table of a first other new LDPC code whose code length N is 16k bits and code rate r is 10/15.
[Fig. 39] A diagram showing a parity check matrix initial value table of a first other new LDPC code whose code length N is 16k bits and code rate r is 12/15.
[Fig. 40] A diagram showing a parity check matrix initial value table of a second new LDPC code whose code length N is 64k bits and code rate r is 6/15.
[Fig. 41] A diagram showing a parity check matrix initial value table of a second new LDPC code whose code length N is 64k bits and code rate r is 6/15.
[Fig. 42] A diagram showing a parity check matrix initial value table of a second new LDPC code whose code length N is 64k bits and code rate r is 8/15.
[Fig. 43] A diagram showing a parity check matrix initial value table of a second new LDPC code whose code length N is 64k bits and code rate r is 8/15.
[Fig. 44] A diagram showing a parity check matrix initial value table of a second new LDPC code whose code length N is 64k bits and code rate r is 8/15.
[Fig. 45] A diagram showing a parity check matrix initial value table of a second new LDPC code whose code length N is 64k bits and code rate r is 10/15.
[Fig. 46] A diagram showing a parity check matrix initial value table of a second new LDPC code whose code length N is 64k bits and code rate r is 10/15.
[Fig. 47] A diagram showing a parity check matrix initial value table of a second new LDPC code whose code length N is 64k bits and code rate r is 10/15.
[Fig. 48] A diagram showing a parity check matrix initial value table of a second new LDPC code whose code length N is 64k bits and code rate r is 12/15.
[Fig. 49] A diagram showing a parity check matrix initial value table of a second new LDPC code whose code length N is 64k bits and code rate r is 12/15.
[Fig. 50] A diagram showing a parity check matrix initial value table of a second new LDPC code whose code length N is 64k bits and code rate r is 12/15.
[Fig. 51] A diagram showing a parity check matrix initial value table of a second new LDPC code whose code length N is 16k bits and code rate r is 7/15.
[Fig. 52] A diagram showing a parity check matrix initial value table of a second new LDPC code whose code length N is 16k bits and code rate r is 9/15.
[Fig. 53] A diagram showing a parity check matrix initial value table of a second new LDPC code whose code length N is 16k bits and code rate r is 11/15.
[Fig. 54] A diagram showing a parity check matrix initial value table of a second new LDPC code whose code length N is 16k bits and code rate r is 13/15.
[Fig. 55] A diagram illustrating an example of a Tanner graph of an ensemble of a degree sequence in which a column weight is 3 and a row weight is 6.
[Fig. 56] A diagram showing an example of the Tanner graph of a multi-edge type ensemble.
[Fig. 57] A diagram showing a minimum cycle length and a performance threshold of the parity check matrix of the first new LDPC code whose code length N is 64k bits and code rate r is 7/15, 9/15, 11/15 or 13/15.
[Fig. 58] A diagram showing a minimum cycle length and a performance threshold of the parity check matrix of the first new LDPC code whose code length N is 64k bits and code rate r is 7/15, 9/15, 11/15 or 13/15.
[Fig. 59] A diagram showing a minimum cycle length and a performance threshold of the parity check matrix of the first new LDPC code whose code length N is 64k and code rate r is 7/15, 9/15, 11/15 or 13/15.
[Fig. 60] A diagram showing a simulation result of measurement of BER/FER about the first new LDPC code whose code length N is 64k bits and code rate r is 7/15.
[Fig. 61] A diagram showing a simulation result of measurement of BER/FER about the first new LDPC code whose code length N is 64k bits and code rate r is 9/15.
[Fig. 62] A diagram showing a simulation result of measurement of BER/FER about the first new LDPC code whose code length N is 64k bits and code rate r is 11/15.
[Fig. 63] A diagram showing a simulation result of measurement of BER/FER about the first new LDPC code whose code length N is 64k bits and code rate r is 13/15.
[Fig. 64] A diagram showing a minimum cycle length and a performance threshold of the parity check matrix of the first new LDPC code whose code length N is 16k bits and code rate r is 6/15, 8/15, 10/15 or 12/15.
[Fig. 65] A diagram illustrating the parity check matrix of the first new LDPC code whose code length N is 16k bits and code rate r is 6/15, 8/15, 10/15 or 12/15.
[Fig. 66] A diagram illustrating the parity check matrix of the first new LDPC code whose code length N is 16k bits and code rate r is 6/15, 8/15, 10/15 or 12/15.
[Fig. 67] A diagram showing a simulation result of measurement of BER/FER about the first new LDPC code whose code length N is 64k bits and code rate r is 6/15.
[Fig. 68] A diagram showing a simulation result of measurement of BER/FER about the first new LDPC code whose code length N is 64k bits and code rate r is 8/15.
[Fig. 69] A diagram showing a simulation result of measurement of BER/FER about the first new LDPC code whose code length N is 64k bits and code rate r is 10/15.
[Fig. 70] A diagram showing a simulation result of measurement of BER/FER about the first new LDPC code whose code length N is 64k bits and code rate r is 12/15.
[Fig. 71] A diagram showing a minimum cycle length and a performance threshold of the parity check matrix of the first other new LDPC code whose code length N is 16k bits and code rate r is 10/15.
[Fig. 72] A diagram showing a minimum cycle length and a performance threshold of the parity check matrix of the first other new LDPC code whose code length N is 16k bits and code rate r is 10/15.
[Fig. 73] A diagram showing a minimum cycle length and a performance threshold of the parity check matrix of the first other new LDPC code whose code length N is 16k bits and code rate r is 10/15.
[Fig. 74] A diagram showing a simulation result of measurement of BER/FER about the first other new LDPC code whose code length N is 16k bits and code rate r is 10/15.
[Fig. 75] A diagram showing a simulation result of measurement of BER/FER about the first other new LDPC code whose code length N is 16k bits and code rate r is 12/15.
[Fig. 76] A diagram illustrating the parity check matrix of the first other new LDPC code whose code length N is 16k bits and code rate r is 12/15.
[Fig. 77] A diagram illustrating the parity check matrix of the first other new LDPC code whose code length N is 16k bits and code rate r is 12/15.
[Fig. 78] A diagram showing a simulation result of measurement of BER/FER about the first other new LDPC code whose code length N is 16k bits and code rate r is 12/15.
[Fig. 79] A diagram illustrating the parity check matrix of the second new LDPC code whose code length N is 64k bits and code rate r is 6/15, 8/15, 10/15, 12/15.
[Fig. 80] A diagram illustrating the parity check matrix of the second new LDPC code whose code length N is 64k bits and code rate r is 6/15, 8/15, 10/15, 12/15.
[Fig. 81] A diagram showing a simulation result of measurement of BER/FER about the second new LDPC code whose code length N is 64k bits and code rate r is 6/15.
[Fig. 82] A diagram showing a simulation result of measurement of BER/FER about the second new LDPC code whose code length N is 64k bits and code rate r is 8/15.
[Fig. 83] A diagram showing a simulation result of measurement of BER/FER about the second new LDPC code whose code length N is 64k bits and code rate r is 10/15.
[Fig. 84] A diagram showing a simulation result of measurement of BER/FER about the second new LDPC code whose code length N is 64k bits and code rate r is 12/15.
[Fig. 85] A diagram illustrating the parity check matrix of the second new LDPC code whose code length N is 16k bits and code rate r is 7/15, 9/15, 11/15, 13/15.
[Fig. 86] A diagram illustrating the parity check matrix of the second new LDPC code whose code length N is 16k bits and code rate r is 7/15, 9/15, 11/15, 13/15.
[Fig. 87] A diagram showing a simulation result of measurement of BER/FER about the second new LDPC code whose code length N is 16k bits and code rate r is 7/15.
[Fig. 88] A diagram showing a simulation result of measurement of BER/FER about the second new LDPC code whose code length N is 16k bits and code rate r is 9/15.
[Fig. 89] A diagram showing a simulation result of measurement of BER/FER about the second new LDPC code whose code length N is 16k bits and code rate r is 11/15.
[Fig. 90] A diagram showing a simulation result of measurement of BER/FER about the second new LDPC code whose code length N is 16k bits and code rate r is 13/15.
[Fig. 91] A diagram showing illustrative types of the constellation.
[Fig. 92] A diagram showing an example of a constellation for eight code rates r of the LDPC code when the modulation scheme is 16QAM.
[Fig. 93] A diagram showing an example of a constellation for eight code rates r of the LDPC code when the modulation scheme is 64QAM.
[Fig. 94] A diagram showing an example of a constellation for eight code rates r of the LDPC code when the modulation scheme is 256QAM.
[Fig. 95] A diagram showing an example of a constellation for eight code rates r of the LDPC code when the modulation scheme is 1024QAM.
[Fig. 96] A diagram showing a simulation result of measurement of BER where UC, 1D NUC or 2D NUC is used as constellation when the modulation scheme is 16QAM.
[Fig. 97] A diagram showing a simulation result of measurement of BER where UC, 1D NUC or 2D NUC is used as constellation when the modulation scheme is 64QAM.
[Fig. 98] A diagram showing a simulation result of measurement of BER where UC, 1D NUC or 2D NUC is used as constellation when the modulation scheme is 256QAM.
[Fig. 99] A diagram showing a simulation result of measurement of BER where UC, 1D NUC or 2D NUC is used as constellation when the modulation scheme is 1024QAM.
[Fig. 100] A diagram showing coordinates of the signal points of UC commonly used for eight code rates r of the LDPC code when the modulation scheme is QPSK.
[Fig. 101] A diagram showing coordinates of the signal points of 2D NUC commonly used for eight code rates r of the LDPC code when the modulation scheme is 16QAM.
[Fig. 102] A diagram showing coordinates of the signal points of 2D NUC commonly used for eight code rates r of the LDPC code when the modulation scheme is 64QAM.
[Fig. 103] A diagram showing coordinates of the signal points of 2D NUC commonly used for eight code rates r of the LDPC code when the modulation scheme is 256QAM.
[Fig. 104] A diagram showing coordinates of the signal points of 1D NUC commonly used for eight code rates r of the LDPC code when the modulation scheme is 1024QAM.
[Fig. 105] A diagram showing a relationship between a real part Re(z_{q}) and an imaginary part Im(z_{q}) of a complex number as a coordinate of a symbol y and a signal point z_{q} of 1D NUC corresponding to the symbol y.
[Fig. 106] A block diagram showing a configuration example of a block interleaver 25.
[Fig. 107] A diagram showing a column number C of parts 1 and 2 for a combination of a code length N and a modulation scheme and part column lengths R1 and R2.
[Fig. 108] A diagram for illustrating a block interleave performed in the block interleaver 25.
[Fig. 109] A diagram for illustrating group-wise interleave performed in a group-wise interleaver 24.
[Fig. 110] A diagram showing a first example of a GW pattern for the LDPC code whose code length N is 64k bits.
[Fig. 111] A diagram showing a second example of the GW pattern for the LDPC code whose code length N is 64k bits.
[Fig. 112] A diagram showing a third example of the GW pattern for the LDPC code whose code length N is 64k bits.
[Fig. 113] A diagram showing a fourth example of the GW pattern for the LDPC code whose code length N is 64k bits.
[Fig. 114] A diagram showing a first example of a GW pattern for the LDPC code whose code length N is 16k bits.
[Fig. 115] A diagram showing a second example of the GW pattern for the LDPC code whose code length N is 16k bits.
[Fig. 116] A diagram showing a third example of the GW pattern for the LDPC code whose code length N is 16k bits.
[Fig. 117] A diagram showing a fourth example of the GW pattern for the LDPC code whose code length N is 16k bits.
[Fig. 118] A block diagram showing a configuration example of the receiving device 12.
[Fig. 119] A block diagram showing a configuration example of a bit deinterleaver 165.
[Fig. 120] A flowchart illustrating processes performed by a demapper 164, the bit deinterleaver 165, and an LDPC decoder 166.
[Fig. 121] A diagram showing an example of the parity check matrix of the LDPC code.
[Fig. 122] A diagram illustrating a matrix (conversion parity check matrix) obtained by applying row permutation and column permutation to the parity check matrix.
[Fig. 123] A diagram illustrating the conversion parity check matrix divided into 5 x 5 units.
[Fig. 124] A block diagram showing a configuration example of a decoding device, which collectively performs P node operations.
[Fig. 125] A block diagram showing a configuration example of the LDPC decoder 166.
[Fig. 126] A block diagram showing a configuration example of a block deinterleaver 54.
[Fig. 127] A block diagram showing other configuration example of the bit deinterleaver 165.
[Fig. 128] A block diagram showing a first configuration example of a receiving system to which the receiving device 12 may be applied.
[Fig. 129] A block diagram showing a second configuration example of the receiving system to which the receiving device 12 may be applied.
[Fig. 130] A block diagram showing a third configuration example of the receiving system to which the receiving device 12 may be applied.
[Fig. 131] A block diagram showing a configuration example of one embodiment of a computer to which the present technology is applied.

### Modes for Carrying Out the Invention

Hereinafter, embodiments of the present technology will be described. Before that, an LDPC code will be described.

### <LDPC code>

The LDPC code is a linear code and is not necessarily required to be a binary code; however, it is herein described supposing that this is the binary code.

The greatest characteristic of the LDPC code is that a parity check matrix defining the LDPC code is sparse. Herein, the sparse matrix is the matrix in which the number of elements "1" of the matrix is very small (most of elements are 0).

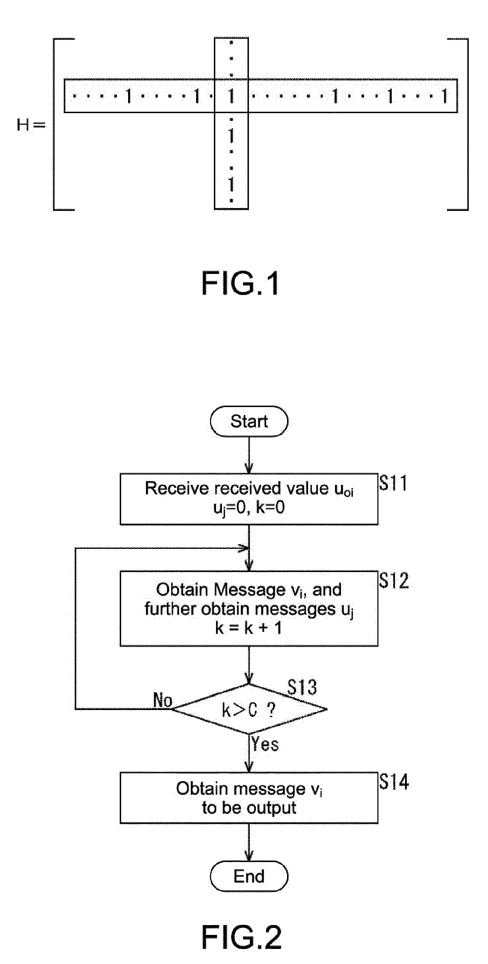

Fig. 1 is a view showing an example of a parity check matrix H of the LDPC code.

In the parity check matrix H in Fig. 1, a weight of each column (column weight) (the number of "1") is "3" and the weight of each row (row weight) is "6".

In encoding by the LDPC code (LDPC encoding), a code word (LDPC code) is generated by generation of a generator matrix G based on the parity check matrix H and multiplication of the generator matrix G by a binary information bit, for example.

Specifically, an encoding device, which performs the LDPC encoding, first calculates the generator matrix G satisfying an equation GH^{T} = 0 between the same and a transposed matrix H^{T} of the parity check matrix H. Herein, when the generator matrix G is a K × N matrix, the encoding device multiplies a bit column (vector u) of K bits by the generator matrix G to generate a code word c (= uG) configured of N bits. The code word (LDPC code) generated by the encoding device is received on a receiving side through a predetermined communication channel.

Decoding of the LDPC code may be performed by an algorithm suggested by Gallager as probabilistic decoding being a message passing algorithm by belief propagation on a so-called Tanner graph configured of a variable node (also referred to as a message node) and a check node. Hereinafter, the variable node and the check node are appropriately and simply referred to as a node.

Fig. 2 is a flowchart showing a procedure of the decoding of the LDPC code.

A real value (received LLR) representing likelihood of a value to be "0" of an i-th code bit of the LDPC code (one cord word) received on the receiving side by a log likelihood ratio is hereinafter appropriately referred to as a received value u₀ᵢ. A message output from the check node is set to uⱼ and the message output from the variable node is set to vᵢ.

First, in the decoding of the LDPC code, as shown in Fig. 2, the LDPC code is received, the message (check node message) uⱼ is initialized to "0", and a variable k being an integer as a counter of a repetitive process is initialized to "0" at step S11 and the procedure shifts to step S12. At step S12, the message (variable node message) vᵢ is obtained by an operation (variable node operation) represented in equation (1) based on the received value u₀ᵢ obtained by receiving the LDPC code and the message uⱼ is obtained by an operation (check node operation) represented in equation (2) based on the message vᵢ.
[Equation 1] ${v}_{i} = {u}_{0 i} + {\sum }_{j = 1}^{{d}_{v} - 1} {u}_{j}$
[Equation 2] $tanh \left(\frac{{u}_{j}}{2}\right) = {\prod }_{i = 1}^{{d}_{c} - 1} tanh \left(\frac{{v}_{i}}{2}\right)$

Herein, dᵥ and d_{c} in equations (1) and (2) are parameters indicating the numbers of "1" in a vertical direction (column) and a horizontal direction (row) of the parity check matrix H, which may be optionally selected. For example, it is set that dᵥ = 3 and d_{c} = 6 in the case of the LDPC code ((3, 6) LDPC code) for the parity check matrix H in which the column weight is 3 and the row weight is 6 as shown in Fig. 1.

In the variable node operation in equation (1) and the check node operation in equation (2), the message input from an edge (line connecting the variable node and the check node to each other) from which the message is to be output is not a target of the operation, so that a range of the operation is 1 to dᵥ-1 or 1 to d_{c}-1. Also, a table of a function R(v₁, v₂) represented in equation (3) defined by one output with respect to two inputs v₁ and v₂ is created in advance and this is continuously (recursively) used as represented in equation (4) for actually performing the check node operation in equation (2).
[Equation 3] $x = 2 {tanh}^{- 1} \left\{tanh\left({v}_{1}/2\right) tanh\left({v}_{2}/2\right)\right\} = R \left({v}_{1}, {v}_{2}\right)$${u}_{j} = R \left({v}_{1},R\left({v}_{2},R\left({v}_{3},⋯R\left({v}_{{d}_{c} - 2}, {v}_{{d}_{c} - 1}\right)\right)\right)\right)$

At step S12, the variable k is incremented by 1 and the procedure shifts to step S13. At step S13, it is judged whether the variable k is larger than a predetermined number of times of repetitive decoding C. When it is judged that the variable k is not larger than C at step S13, the procedure returns to step S12 and a similar process is hereinafter repeatedly performed.

Also, when it is judged that the variable k is larger than C at step S13, the procedure shifts to step S14 to perform an operation represented in equation (5), so that the message vᵢ as a decoding result to be finally output is obtained to be output and a decoding process of the LDPC code is finished.
[Equation 5] ${v}_{i} = {u}_{0 i} + {\sum }_{j = 1}^{{d}_{v}} {u}_{j}$

Herein, different from the variable node operation in equation (1), the operation in equation (5) is performed using the messages uⱼ from all the edges connected to the variable node.

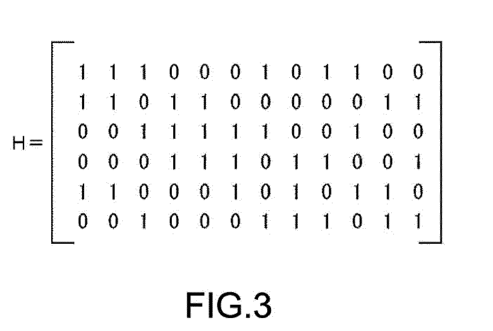

Fig. 3 is a view showing an example of the parity check matrix H of the (3, 6) LDPC code (code rate 1/2 and code length 12).

In the parity check matrix H in Fig. 3, the weight of the column is 3 and the weight of the row is 6 as in Fig. 1.

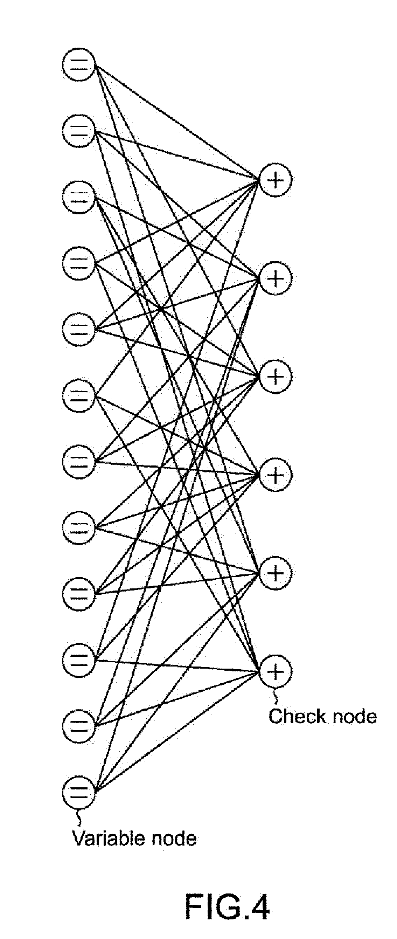

Fig. 4 is a view showing the Tanner graph of the parity check matrix H in Fig. 3.

Herein, in Fig. 4, the check node is represented by plus "+" and the variable node is represented by equal "=". The check node and the variable node correspond to the row and the column of the parity check matrix H, respectively. A connection between the check node and the variable node is the edge, which corresponds to the element "1" of the parity check matrix.

That is to say, when a j-th row i-th column element of the parity check matrix is 1, in Fig. 4, an i-th variable node (node of "=") from the top and a j-th check node (node of "+") from the top are connected to each other by the edge. The edge indicates that the code bit corresponding to the variable node has a constraint condition corresponding to the check node.

In a sum product algorithm being the decoding method of the LDPC code, the variable node operation and the check node operation are repeatedly performed.

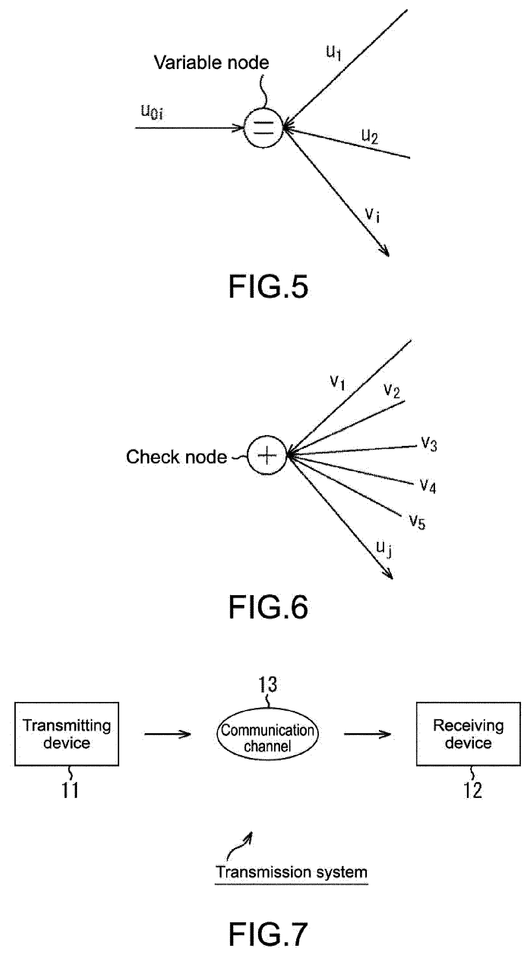

Fig. 5 is a view showing the variable node operation performed in the variable node.

In the variable node, the message vᵢ corresponding to the edge to be calculated is obtained by the variable node operation in equation (1) using the messages u₁ and u₂ from other edges connected to the variable node and the received value u₀ᵢ. The message corresponding to another edge is similarly obtained.

Fig. 6 illustrates the check node operation performed in the check node.

Herein, the check node operation in equation (2) may be rewritten as equation (6) using relationship of an equation a × b = exp{ln(|a|) + ln(|b|)} × sign(a) × sign(b). Sign(x) is 1 when x => 0 is satisfied and -1 when x < 0 is satisfied.

[Equation 6] $\begin{matrix}{u}_{j} & = 2 {tanh}^{- 1} \left({\prod }_{i = 1}^{{d}_{c} - 1} tanh \left(\frac{{v}_{i}}{2}\right)\right) \\ & = 2 {tanh}^{- 1} \left[exp\left\{{\sum }_{i = 1}^{{d}_{c} - 1} ln \left(\left|tanh\left(\frac{{v}_{i}}{2}\right)\right|\right)\right\}\times {\prod }_{i = 1}^{{d}_{c} - 1} sign \left(tanh\left(\frac{{v}_{i}}{2}\right)\right)\right] \\ & = 2 {tanh}^{- 1} \left[exp\left\{-\left({\sum }_{i = 1}^{{d}_{c} - 1} - ln \left(tanh\left(\frac{\left|{v}_{i}\right|}{2}\right)\right)\right)\right\}\right] \times {\prod }_{i = 1}^{{d}_{c} - 1} sign \left({v}_{i}\right)\end{matrix}$

When a function (ϕ)(x) is defined by an equation ϕ(x) = ln (tan h(x/2)) when x => 0 is satisfied, an equation ϕ⁻¹(x) = 2 tan h⁻¹(e^{-x}) is satisfied, so that equation (6) may be deformed to equation (7).
[Equation 7] ${u}_{j} = {φ}^{- 1} \left({\sum }_{i = 1}^{{d}_{c} - 1} φ \left(\left|{v}_{i}\right|\right)\right) \times {\prod }_{i = 1}^{{d}_{c} - 1} sign \left({v}_{i}\right)$

In the check node, the check node operation in equation (2) is performed according to equation (7).

That is to say, in the check node, the message uⱼ corresponding to the edge to be calculated is obtained by the check node operation in equation (7) using messages v₁, v₂, v₃, v₄, and v₅ from other edges connected to the check node as illustrated in Fig. 6. The message corresponding to another edge is similarly obtained.

The function ϕ(x) in equation (7) may be represented by an equation ϕ(x) = ln (e^{x}+1)/(e^{x}-1)) and ϕ(x) = ϕ⁻¹(x) when x > 0 is satisfied. When the functions ϕ(x) and ϕ⁻¹(x) are implemented in hardware, there is a case in which they are implemented using LUT (look up table), and the same LUT is used for both of them.

### <Configuration example of transmission system to which the present technology is applied>

Fig. 7 illustrates a configuration example of one embodiment of a transmission system (the term "system" is intended to mean a logical assembly of a plurality of devices and it does not matter whether the devices of each configuration are in the same housing) to which the present technology is applied.

In Fig. 7, the transmission system is configured of a transmitting device 11 and a receiving device 12.

The transmitting device 11 transmits (broadcasts) (transmits) a program of television broadcasting. That is to say, the transmitting device 11 encodes target data to be transmitted such as image data and audio data as the program, for example, into an LDPC code and transmits the same through a communication channel 13 such as a satellite circuit, a terrestrial wave, and a cable (wire circuit).

The receiving device 12 receives the LDPC code transmitted from the transmitting device 11 through the communication channel 13 and decodes the same to the target data to output.

Herein, it is known that the LDPC code used in the transmission system in Fig. 7 exhibits an extremely high ability in an AWGN (additive white Gaussian noise) communication channel.

However, a burst error and erasure might occur in the communication channel 13 such as the terrestrial wave. For example, especially when the communication channel 13 is a terrestrial wave, in an OFDM (orthogonal frequency division multiplexing) system, there is a case in which power of a specific symbol reaches 0 (erasure) according to delay of an echo (a path other than a main path) in a multipath environment in which a D/U (desired to undesired ratio) is 0 dB (power of undesired (= echo) is equal to power of desired (= main path)).

There is a case in which the power of all the symbols of the OFDM at a specific time reaches 0 (erasure) by a Doppler frequency when the D/U is 0 dB also in a flutter (communication channel in which a Doppler frequency-shifted echo whose delay is 0 is added).

Further, the burst error might occur due to a wiring status from a receiver (not shown) such as an antenna, which receives a signal from the transmitting device 11, to the receiving device 12 and instability of a power supply of the receiving device 12 on a side of the receiving device 12.

On the other hand, in decoding of the LDPC code, a variable node operation in equation (1) including addition of (a received value u₀ᵢ of) a code bit of the LDPC code is performed as illustrated above in Fig. 5 in a variable node corresponding to a column of a parity check matrix H and eventually the code bit of the LDPC code, so that, when the error occurs in the code bit used in the variable node operation, accuracy of an obtained message is deteriorated.

In the decoding of the LDPC code, a check node operation in equation (7) is performed in the check node using the message obtained in the variable node connected to the check node, so that decoding performance is deteriorated when the number of check nodes, in which (the code bits of the LDPC code corresponding to) a plurality of variable nodes connected thereto have the error (including the erasure) at the same time, increases.

That is to say, when the erasure occurs in two or more of the variable nodes connected to the check node at the same time, the check node returns the message indicating that probability that the value is 0 and the probability that the value is 1 are equal to all the variable nodes, for example. In this case, the check node, which returns the message of the equal probability, does not contribute to a single decoding process (one set of the variable node operation and the check node operation), and as a result, this requires a large number of repetitions of the decoding process, so that the decoding performance is deteriorated and further, power consumption of the receiving device 12, which decodes the LDPC code, increases.

Therefore, the transmission system in Fig. 7 is configured to improve resistance to burst error and erasure while maintaining performance in the AWGN communication channel (AWGN channel).

### [Configuration example of transmitting device 11]

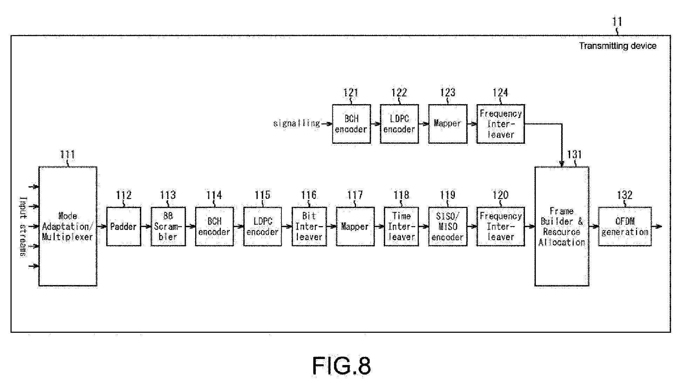

Fig. 8 is a block diagram showing a configuration example of the transmitting device 11 in Fig. 7.

In the transmitting device 11, one or more input streams as the target data are supplied to a mode adaptation/multiplexer 111.

The mode adaptation/multiplexer 111 selects a mode, multiplexes the one or more input streams supplied thereto, and supplies the data obtained as a result to a padder 112.

The padder 112 performs necessary zero padding (null insertion) to the data from the mode adaptation/multiplexer 111 and supplies the data obtained as a result to a BB scrambler 113.

The BB scrambler 113 applies BB scramble (Base-Band Scrambling) to the data from the padder 112 and supplies the data obtained as a result to a BCH encoder 114.

The BCH encoder 114 performs BCH encoding of the data from the BB scrambler 113 and supplies the data obtained as a result to an LDPC encoder 115 as LDPC target data being a target of LDPC encoding.

The LDPC encoder 115 performs the LDPC encoding of the LDPC target data from the BCH encoder 114 according to a parity check matrix in which a parity matrix being a part corresponding to a parity bit of the LDPC code has a stepwise structure and outputs the LDPC code in which an information bit is the LDPC target data.

That is to say, the LDPC encoder 115 performs the LDPC encoding to encode the LDPC target data into the LDPC code (corresponding to the parity check matrix) such as the LDPC code specified in a predetermined standard such as a DVB-S.2 standard, a DVB-T.2 standard and a DVB-C.2 standard or the LDPC code expected to be specified by ATSC3.0 (corresponding to the parity check matrix), for example, and outputs the LDPC code obtained as a result.

In the LDPC code specified in the DVB-T.2 standard or the LDPC code expected to be specified by ATSC3.0 is an IRA (irregular repeat-accumulate) code and the parity matrix in the parity check matrix of the LDPC code has the stepwise structure. The parity matrix and the stepwise structure are described later. The IRA code is described in "Irregular Repeat-Accumulate Codes, " H. Jin, A. Khandekar, and R. J. McEliece, in Proceedings of 2nd International Symposium on Turbo Codes and Related Topics, pp. 1-8, Sept. 2000, for example.

The LDPC code output by the LDPC encoder 115 is supplied to a bit interleaver 116.

The bit interleaver 116 performs bit interleave to be described later of the LDPC code from the LDPC encoder 115 and supplies the LDPC code after the bit interleave to a mapper 117.

The mapper 117 maps the LDPC code from the bit interleaver 116 onto a signal point indicating one symbol of orthogonal modulation in units of one or more code bits of the LDPC code (symbol unit) to perform the orthogonal modulation (multilevel modulation).

That is to say, the mapper 117 maps the LDPC code from the bit interleaver 116 onto the signal point defined by a modulation scheme for performing the orthogonal modulation of the LDPC code on an IQ plane (IQ constellation) defined by an I axis representing an I component in phase with a carrier wave and a Q axis representing a Q component orthogonal to the carrier wave and performs the orthogonal modulation.

If the number of signal points prescribed by orthogonal modulation of a modulation scheme which is performed by the mapper 117 is 2^{m}, the mapper 117 maps the LDPC code from the bit interleaver 116 in a symbol unit onto the signal point indicating the symbol of the 2m signal points as the m code bit of the LDPC code for a symbol (1 symbol).

Herein, the modulation scheme of the orthogonal modulation performed by the mapper 117 includes the modulation scheme including the modulation scheme specified in the DVB-T.2 standard, for example, the modulation scheme expected to be specified by ATSC3.0, and other modulation schemes, that is to say, BPSK (Binary Phase Shift Keying), QPSK (quadrature phase shift keying), 8PSK (Phase-Shift Keying), 16APSK (Amplitude Phase-Shift Keying), 32APSK, 16QAM (quadrature amplitude modulation), 16QAM, 64QAM, 256QAM, 1024QAM, 4096QAM, 4PAM (Pulse Amplitude Modulation) and the like, for example. The modulation scheme with which the orthogonal modulation is performed by the mapper 117 is set in advance according to operation of an operator of the transmitting device 11, for example.

The data (symbol mapped onto the signal point) obtained by the process by the mapper 117 is supplied to a time interleaver 118.

The time interleaver 118 performs time interleave (interleave in a time direction) in a symbol unit of the data from the mapper 117 and supplies the data obtained as a result to a SISO/MISO (Single Input Single Output/Multiple Input Single Output) encoder 119.

The SISO/MISO encoder 119 applies time-space encoding to the data from the time interleaver 118 to supply to a frequency interleaver 120.

The frequency interleaver 120 performs frequency interleave (interleave in a frequency direction) for the unit of the data from the SISO/MISO encoder 119 in a symbol unit, and supplies it to a frame builder & resource allocation 131.

On the other hand, control data for transmission control (signaling) such as Base Band Signaling, BB Header and the like is supplied to the BCH encoder 121, for example.

The BCH encoder 121 performs the BCH encoding of the control data supplied thereto in the same manner as the BCH encoder 114 and supplies the data obtained as a result to an LDPC encoder 122.

The LDPC encoder 122 performs the LDPC encoding of the data from the BCH encoder 121 as the LDPC target data in the same manner as the LDPC encoder 115 and supplies the LDPC code obtained as a result to a mapper 123.

The mapper 123 maps the LDPC code from the LDPC encoder 122 onto the signal point indicating one symbol of the orthogonal modulation in units of one or more code bits of the LDPC code (symbol unit) to perform the orthogonal modulation and supplies the data obtained as a result to a frequency interleaver 124 in the same manner as the mapper 117.

The frequency interleaver 124 performs the frequency interleave of the data from the mapper 123 in a symbol unit to supply to the frame builder & resource allocation 131 in the same manner as the frequency interleaver 120.

The frame builder & resource allocation 131 inserts a pilot symbol into a required position of the data (symbol) from the frequency interleavers 120 and 124 and constitutes a frame configured of a predetermined number of symbols (for example, a PL (Physical Layer) frame, a T2 frame, a C2 frame and the like) from the data (symbol) obtained as a result to supply to an OFDM generation 132.

The OFDM generation 132 generates an OFDM signal corresponding to the frame from the frame from the frame builder & resource allocation 131 and transmits the same through the communication channel 13 (Fig. 7).

The transmitting device 11 may be configured without including some of the blocks shown in Fig. 8, e.g., the time interleaver 118, the SISO/MISO encoder 119, the frequency interleaver 120, and frequency interleaver 124.

### <Configuration example of bit interleaver 116>

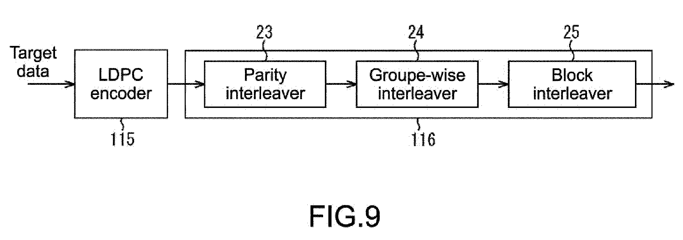

Fig. 9 is block diagram showing a configuration example of the bit interleaver 116 in Fig. 8.

The bit interleaver 116 has a function to interleave the data, and is configured of a parity interleaver 23, a group-wise interleaver 24, and a block interleaver 25.

The parity interleaver 23 performs parity interleave to interleave the parity bit of the LDPC code from the LDPC encoder 115 to a position of another parity bit and supplies the LDPC code after the parity interleave to the group-wise interleaver 24.

The group-wise interleaver 24 performs group-wise interleave of the LDPC code from the parity interleaver 23 and supplies the LDPC code after the group-wise interleave to the block interleaver 25.

Here, in the group-wise interleave, the LDPC code for one code is divided into a 360-bit unit equal to the number of columns P being the unit of the cyclic structure as described later from the beginning. One division, i.e., 360-bit, is considered as a bit group. The LDPC code from the parity interleaver 23 is interleaved in a bit group unit.

When the group-wise interleave is performed, the bit error rate can be improved as compared with the case that no group-wise interleave is performed. As a result, in the data transmission, it is possible to ensure good communication quality.

The block interleaver 25 performs the block interleave for demultiplexing the LDPC code from the group-wise interleaver 24, symbolizes the LDPC code for one code into the m bit symbol in a mapping unit, and supplies it to the mapper 117 (Fig. 8).

Here, there is a storage region where columns for storing a predetermined number of bits in a column (vertical) direction are arranged in equal numbers to the bit numbers m of the symbol in a row (horizontal) direction. In the block interleave, the LDPC code from the group-wise interlever 24 is written in the column direction and read in the row direction, thereby symbolizing the LDPC code for one code into the m bit symbol.

### <Parity check matrix of LDPC code>

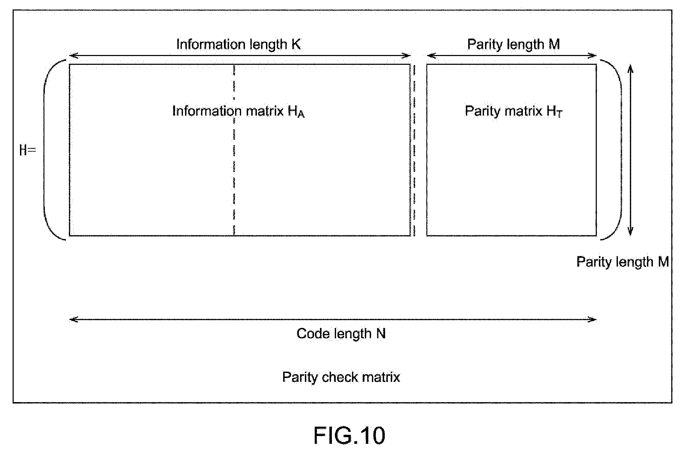

Fig. 10 shows the parity check matrix H used by the LDPC encoder 115 in Fig. 8.

The parity check matrix H has an LDGM (low-density generation matrix) structure and this may be represented by an equation H = [H_{A}|H_{T}] (a matrix in which a left element is an element of an information matrix H_{A} and a right element is an element of a parity matrix H_{T}) by the information matrix H_{A} of a part corresponding to the information bit and the parity matrix H_{T} corresponding to the parity bit out of the code bits of the LDPC code.

Herein, the number of information bits and the number of parity bits out of the code bits of one LDPC code (one code word) are referred to as an information length K and a parity length M, respectively, and the number of code bits of one LDPC code is referred to as a code length N (= K + M).

The information length K and the parity length M of the LDPC code of a certain code length N are determined according to the code rate. The parity check matrix H is an M x N (row x column) matrix. The information matrix H_{A} is an M x K matrix and the parity matrix H_{T} is an M x M matrix.

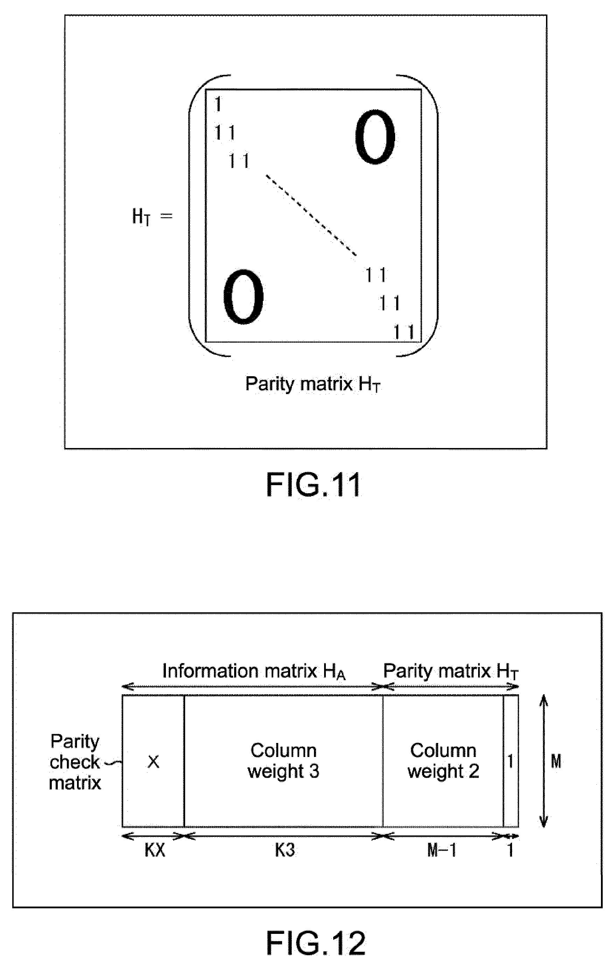

Fig. 11 is a drawing showing an example of the parity matrix H_{T} of the parity check matrix H used for the LDPC encoding by the LDPC encoder 115 in Fig. 8.

The parity matrix H_{T} of the parity check matrix H used for the LDPC encoding by the LDPC encoder 115 is similar to the parity matrix H_{T} of the parity check matrix H of the LDPC code specified in the DVB-T.2 standard.

The parity matrix H_{T} of the parity check matrix H of the LDPC code specified in the DVB-T.2 standard has a lower bidiagonal matrix in which elements of 1 are arranged in a so-called stepwise manner as shown in Fig. 11. A row weight of the parity matrix H_{T} is 1 for a first row and 2 for all other rows. A column weight is 1 for a last column and 2 for all other columns.

As described above, the LDPC code of the parity check matrix H in which the parity matrix H_{T} has the stepwise structure may be easily generated using the parity check matrix H.

That is to say, the LDPC code (one code word) is represented by a row vector c and a column vector obtained by transposing the row vector is represented as c^{T}. A part of the information bit of the row vector c, which is the LDPC code, is represented by a row vector A and a part of the parity bit is represented by a row vector T.

In this case, the row vector c may be represented by an equation c = [A|T] (row vector in which a left element is an element of the row vector A and a right element is an element of the row vector T) by the row vector A as the information bit and the row vector T as the parity bit.

The parity check matrix H and the row vector c = [A|T] as the LDPC code are required to satisfy an equation Hc^{T} = 0 and it is possible to sequentially obtain (in order) the row vector T as the parity bit configuring the row vector c = [A|T] satisfying such equation Hc^{T} = 0 by setting the element of each row to 0 in order from the element of a first row of the column vector Hc^{T} in the equation Hc^{T} = 0 when the parity matrix H_{T} of the parity check matrix H = [H_{A}|H_{T}] has the stepwise structure illustrated in Fig. 11.

Fig. 12 is a view illustrating the parity check matrix H of the LDPC code specified in the DVB-T.2 standard.

The column weight is X for first to KX-th columns, the column weight is 3 for next K3 columns, the column weight is 2 for next M-1 columns, and the column weight is 1 for a last column in the parity check matrix H of the LDPC code specified in the DVB-T.2 standard.

Herein, KX + K3 + M - 1 + 1 equals to the code length N.

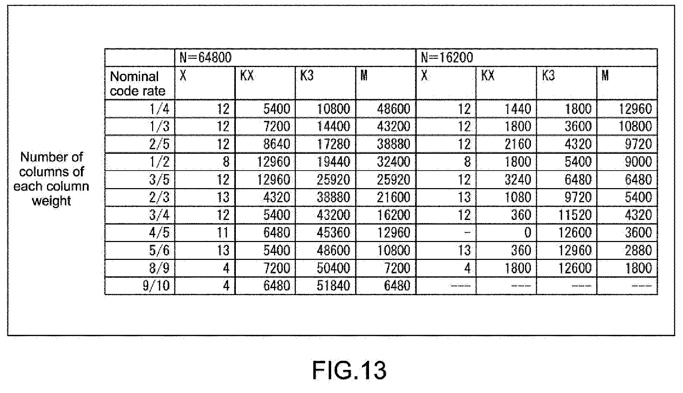

Fig. 13 is a view showing the numbers of columns KX, K3, and M and the column weight X for each code rate r of the LDPC code specified in the DVB-T.2 standard.

The LDPC codes whose code lengths N are 64800 bits and 16200 bits are specified in the DVB-T.2 standard.

For the LDPC code whose code length N is 64800 bits, 11 code rates (nominal rates) 1/4, 1/3, 2/5, 1/2, 3/5, 2/3, 3/4, 4/5, 5/6, 8/9, and 9/10 are specified, and for the LDPC code whose code length N is 16200 bits, 10 code rates 1/4, 1/3, 2/5, 1/2, 3/5, 2/3, 3/4, 4/5, 5/6, and 8/9 are specified.

The code length N of 64800 bits is hereinafter also referred to as 64k bits and the code length of 16200 bits is also referred to as 16k bits.

As for the LDPC code, it is known that a bit error rate of the code bit corresponding to the column whose column weight is larger of the parity check matrix H is lower.

In the parity check matrix H specified in the DVB-T.2 standard illustrated in Figs. 12 and 13, the column weight of the column closer to a top (leftmost) column tends to be larger, therefore, as for the LDPC code corresponding to the parity check matrix H, the code bit closer to a top code bit closer to a top code bit tends to be more tolerant to error (resistant to error) and the code bit closer to a last code bit tends to be less tolerant to error.

### <Parity interleave>

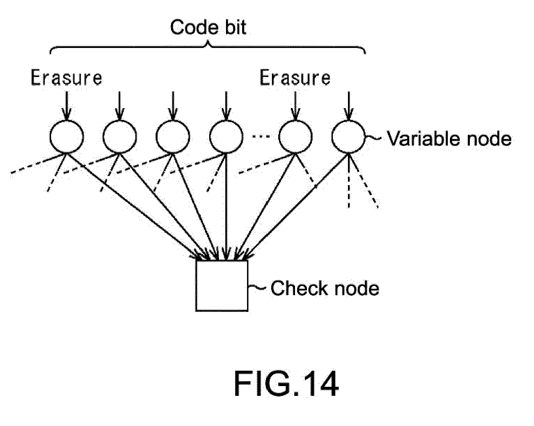

Referring to Fig. 14 to Fig. 16, the parity interleave by the parity interleaver 23 in Fig. 9 is described.

Fig. 14 shows (a part of) a Tanner graph of the parity check matrix of the LDPC code.

The check node returns the message indicating that the probability that the value is 0 and the probability that the value is 1 are equal to all the variable nodes connected to the check node when the error such as the erasure occurs in a plurality (for example, two) of (code bits corresponding to the) variable nodes connected to the check node at the same time as illustrated in Fig. 14. Therefore, when the erasure and the like occur at the same time in a plurality of variable nodes connected to the same check node, the decoding performance is deteriorated.

The LDPC code specified in the DVB-S.2 standard output by the LDPC encoder 115 in Fig. 8 is the IRA code and the parity matrix H_{T} of the parity check matrix H has the stepwise structure as illustrated in Fig. 11.

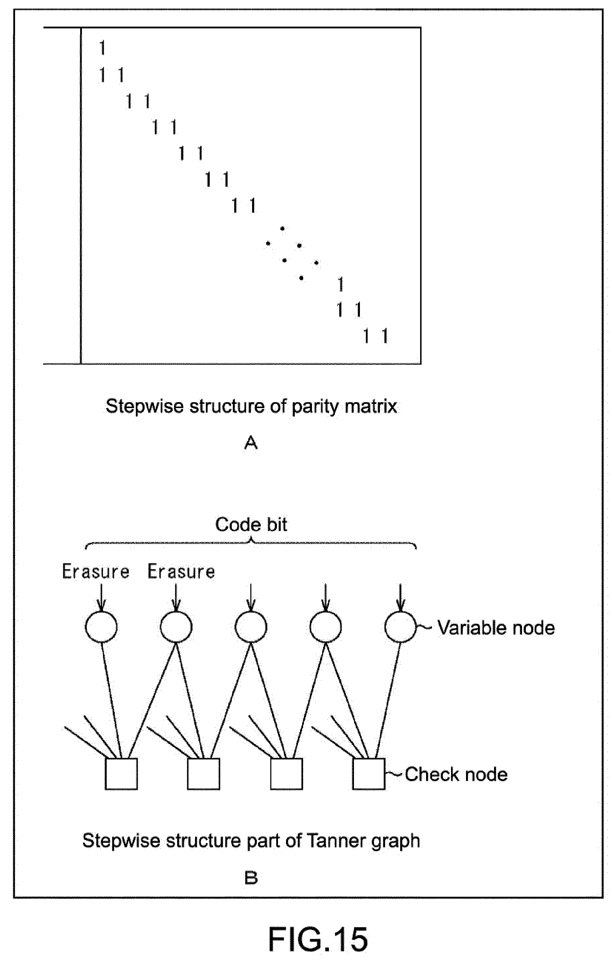

Fig. 15 shows the parity matrix H_{T} having the stepwise structure and the Tanner graph corresponding to the parity matrix H_{T}, as shown in Fig. 11.

Fig. 15A shows the parity matrix H_{T} having the stepwise structure and Fig. 15B shows the Tanner graph corresponding to the parity matrix H_{T} in Fig. 15A.

In the parity matrix H_{T} having the stepwise structure, the elements of 1 are adjacent to each other in each row (except the first row). Therefore, in the Tanner graph of the parity matrix H_{T}, two adjacent variable nodes corresponding to the columns of the two adjacent elements whose value is 1 of the parity matrix H_{T} are connected to the same check node.

Therefore, when the error occurs in the parity bits corresponding to the above-described adjacent two variable nodes at the same time due to the burst error, the erasure and the like, the check node connected to the two variable nodes (the variable nodes, which obtain the message using the parity bits) corresponding to the two parity bits in which the error occurs returns the message indicating that the probability that the value is 0 and the probability that the value is 1 are equal to the variable nodes connected to the check node, whereby the decoding performance is deteriorated. When a burst length (the number of parity bits in which the error is successively occurs) increases, the number of check nodes, which return the message of the equal probability, increases and the decoding performance is further deteriorated.

Then, the parity interleaver 23 (Fig. 9) performs the parity interleave to interleave the parity bit of the LDPC code from the LDPC encoder 115 to the position of another parity bit in order to prevent the above-described deterioration in decoding performance.

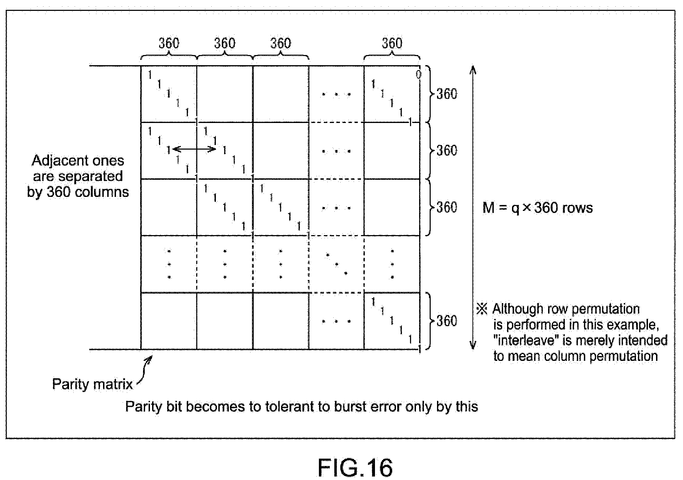

Fig. 16 shows the parity matrix H_{T} of the parity check matrix H corresponding to the LDPC code after the parity interleave performed by the parity interleaver 23 in Fig. 9.

Herein, the information matrix H_{A} of the parity check matrix H corresponding to the LDPC code output by the LDPC encoder 115 has a cyclic structure, similar to the information matrix of the parity check matrix H corresponding to the LDPC code specified in the DVB-T.2 standard.

The term "cyclic structure" is intended to mean a structure in which a certain column is identical to a column obtained by a cyclic shift of another column and includes a structure in which a position of 1 in each row of P columns is set to a position obtained by the cyclic shift of a first column of the P columns in the column direction by a value proportional to a value q obtained by dividing the parity length M for each P columns, for example. Hereinafter, P in the cyclic structure is appropriately referred to as the number of columns being a unit of the cyclic structure.

There are two types of LDPC codes whose code lengths N are 64800 bits and 16200 bits as the LDPC code specified in the DVB-T.2 standard as illustrated in Figs. 12 and 13, and the number of columns P being the unit of the cyclic structure is set to 360, which is one of submultiples other than 1 and M out of the submultiples of the parity length M for both of the two LDPC codes.

The parity length M is set to a value other than a prime number represented by an equation M = q x P = q x 360 using the value q different according to the code rate. Therefore, as the number of columns P being the unit of the cyclic structure, the value q also is another submultiple other than 1 and M out of the submultiples of the parity length M and this may be obtained by dividing the parity length M by the number of columns P being the unit of the cyclic structure (a product of P and q being the submultiples of the parity length M is the parity length M).

When the information length is K, an integer not smaller than 0 and smaller than P is x, and an integer not smaller than 0 and smaller than q is y, the parity interleaver 23 interleaves a K + qx + y + 1-th code bit out of the code bits of the N-bit LDPC code to a position of a K + Py + x + 1-th code bit as the parity interleave as described above.

Both the K + qx + y + 1-th code bit and the K + Py + x + 1-th code bit are the code bits after a K + 1-th code bit, so that they are the parity bits, therefore, the position of the parity bit of the LDPC code is moved by the parity interleave.

According to such parity interleave, (the parity bits corresponding to) the variable nodes connected to the same check node are apart from each other by the number of columns P being the unit of the cyclic structure, that is to say, herein 360 bits, so that a situation in which the error occurs in a plurality of variable nodes connected to the same check node at the same time may be avoided in a case in which the burst length is shorter than 360 bits, and as a result, the resistance to burst error may be improved.

The LDPC code after the parity interleave to interleave the K + qx + y + 1-th code bit to the position of the K + Py + x + 1-th code bit is identical to the LDPC code of the parity check matrix obtained by performing column permutation to change the K + qx + y + 1-th column of the original parity check matrix H to the K + qx + x + 1-th column (hereinafter, also referred to as a conversion parity check matrix).

Also, a quasi-cyclic structure in units of P columns (360 columns in Fig. 16) appears in the parity matrix of the conversion parity check matrix as illustrated in Fig. 16.

Herein, the term "quasi-cyclic structure" is intended to mean a structure in which a portion except a part has the cyclic structure.

In the conversion parity check matrix obtained by applying the column permutation corresponding to the parity interleave to the parity check matrix of the LDPC code specified in the DVB-T.2 standard, one element 1 is lacking (there is an element 0) in a portion of 360 rows × 360 columns in a right corner of the conversion parity check matrix (a shift matrix to be described later), so that this does not have the (complete) cyclic structure and has the so-called quasi-cyclic structure in this point.

The conversion parity check matrix of the parity check matrix of the LDPC code output by the LDPC encoder 115 has a quasi-cyclic structure, similar to the conversion parity check matrix of the parity check matrix H of the LDPC code specified in the DVB-T.2 standard.

The conversion parity check matrix in Fig. 16 is the matrix obtained by applying permutation of the row (row permutation) for allowing the conversion parity check matrix to be configured of a constitutive matrix to be described later to the original parity check matrix H in addition to the column permutation corresponding to the parity interleave.

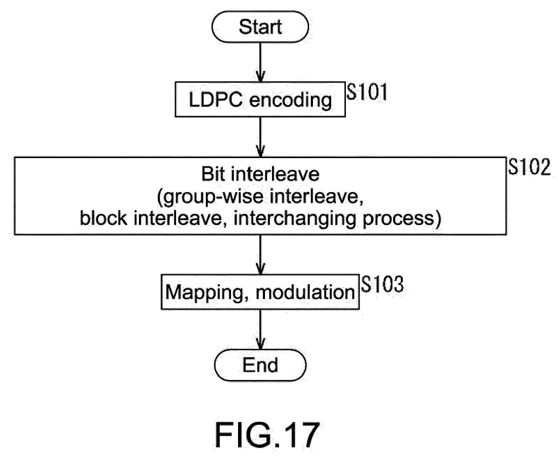

Fig. 17 is a flowchart for explaining the processing performed by the LDPC encoder 115, the bit interleaver 116 and the mapper 117 in Fig. 8.

The LDPC encoder 115 encodes the LDPC target data into the LDPC code at step S101 after waiting for supply of the LDPC target data from the BCH encoder 114 and supplies the LDPC code to the bit interleaver 116, then the process shifts to step S102.

The bit interleaver 116 performs the bit interleave of the LDPC code from the LDPC encoder 115 and supplies the symbol obtained by the bit interleave to the mapper 117 at step S102, then the process shifts to step S103.

That is to say, at step S102, in the bit interleaver 116 (Fig. 9), the parity interleaver 23 performs the parity interleave of the LDPC code from the LDPC encoder 115 and supplies the LDPC code after the parity interleave to the group-wise interleaver 24.

The group-wise interleaver 24 performs the group-wise interleave of the LDPC code from the parity interleaver 23 to supply to the block interleaver 25.

The block interleaver 25 performs the block interleave of the LDPC code after the group-wise interleave by the group-wise interleaver 24 and supplies the m bit symbol obtained as a result to the mapper 117.

The mapper 117 maps the symbol from the block interleaver 25 onto any of the 2m signal points defined by the modulation scheme of the orthogonal modulation performed by the mapper 117 to perform the orthogonal modulation and supplies the data obtained as a result to the time interleaver 118 at step S103.

As described above, it is possible to improve the error rate in a case in which a plurality of code bits of the LDPC code is transmitted as one symbol by performing the parity interleave and the group-wise interleave.

Herein, the parity interleaver 23, which is a block to perform the parity interleave, and the group-wise interleaver 24, which is a block to perform the group-wise interleave, are separately formed in Fig. 9 for convenience of description; however, the parity interleaver 23 and the group-wise interleaver 24 may be integrally formed.

That is to say, the parity interleave and the group-wise interleave may be performed by the writing and the reading of the code bit to and from the memory and may be represented by a matrix to convert the address at which the code bit is written (write address) to the address at which the code bit is read (read address).

Therefore, by obtaining the matrix obtained by multiplying the matrix representing the parity interleave by the matrix representing the group-wise interleave, it is possible to obtain a result of performing the parity interleave and performing the group-wise interleave of the LDPC code after the parity interleave by converting the code bit by the matrix.

It is also possible to integrally form the block interleaver 25 in addition to the parity interleaver 23 and the group-wise interleaver 24.

That is to say, the block interleave performed by the block interleaver 25 may also be represented by the matrix to convert the write address of the memory, which stores the LDPC code, to the read address.

Therefore, by obtaining the matrix obtained by multiplying the matrix representing the parity interleave, the matrix representing the group-wise interleave, and the matrix representing the block interleave together, it is possible to collectively perform the parity interleave, the group-wise interleave, and the block interleave by the matrix.

### <Configuration example of LDPC encoder 115>

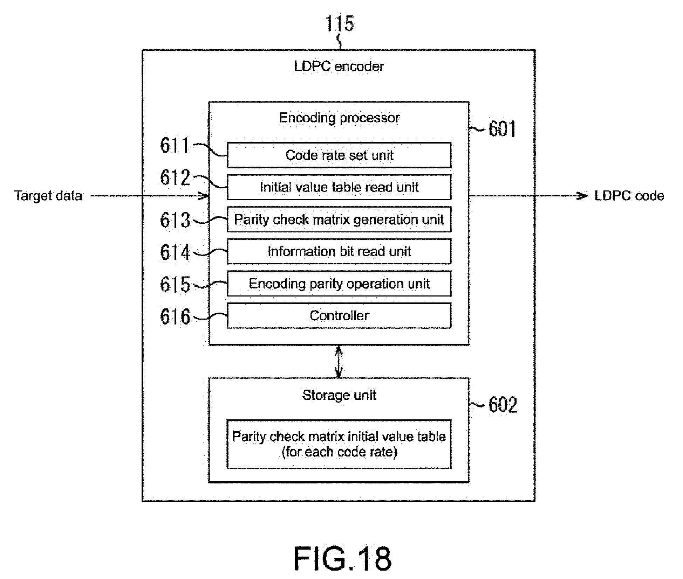

Fig. 18 is a block diagram illustrating a configuration example of the LDPC encoder 115 in Fig. 8.

The LDPC encoder 122 in Fig. 8 also is configured in the same manner.

As illustrated in Figs. 12 and 13, the LDPC codes of the two code lengths N of 64800 bits and 16200 bits are specified in the DVB-S.2 standard.

As for the LDPC code whose code length N is 64800 bits, 11 code rates 1/4, 1/3, 2/5, 1/2, 3/5, 2/3, 3/4, 4/5, 5/6, 8/9, and 9/10 are specified, and as for the LDPC code whose code length N is 16200 bits, 10 code rates 1/4, 1/3, 2/5, 1/2, 3/5, 2/3, 3/4, 4/5, 5/6 and 8/9 are specified (refer to Figs. 12 and 13).

The LDPC encoder 115 may perform the encoding (error correction encoding) by such LDPC code of each code rate whose code lengths N are 64800 bits or 16200 bits according to the parity check matrix H prepared for each code length N and each code rate, for example.

The LDPC encoder 115 is configured of an encoding processor 601 and a storage unit 602.

The encoding processor 601 is configured of a code rate set unit 611, an initial value table read unit 612, a parity check matrix generation unit 613, an information bit read unit 614, an encoding parity operation unit 615, and a controller 616, and this performs the LDPC encoding of the LDPC target data supplied to the LDPC encoder 115 and supplies the LDPC code obtained as a result to the bit interleaver 116 (Fig. 8).

That is to say, the code rate set unit 611 sets the code length N and the code rate of the LDPC code according to the operation of the operator and the like, for example.

The initial value table read unit 612 reads a parity check matrix initial value table to be described later corresponding to the code length N and the code rate set by the code rate set unit 611 from the storage unit 602.

The parity check matrix generation unit 613 generates the parity check matrix H by arranging the element 1 of the information matrix H_{A} corresponding to the information length K (= code length N - parity length M) according to the code length N and the code rate set by the code rate set unit 611 with a period of 360 columns (the number of columns P being the unit of the cyclic structure) in the column direction based on the parity check matrix initial value table read by the initial value table read unit 612 and stores the same in the storage unit 602.

The information bit read unit 614 reads (extracts) the information bits as many as the information length K from the LDPC target data supplied to the LDPC encoder 115.

The encoding parity operation unit 615 reads the parity check matrix H generated by the parity check matrix generation unit 613 from the storage unit 602 and calculates the parity bit for the information bit read by the information bit read unit 614 based on a predetermined equation using the parity check matrix H, thereby generating the code word (LDPC code).

The controller 616 controls each block configuring the encoding processor 601.

A plurality of parity check matrix initial value tables and the like corresponding to a plurality of code rates and the like illustrated in Figs. 12 and 13 for each of the code lengths N such as 64800 bits and 16200 bits is stored in the storage unit 602, for example. The storage unit 602 temporarily stores the data required in the process of the encoding processor 601.

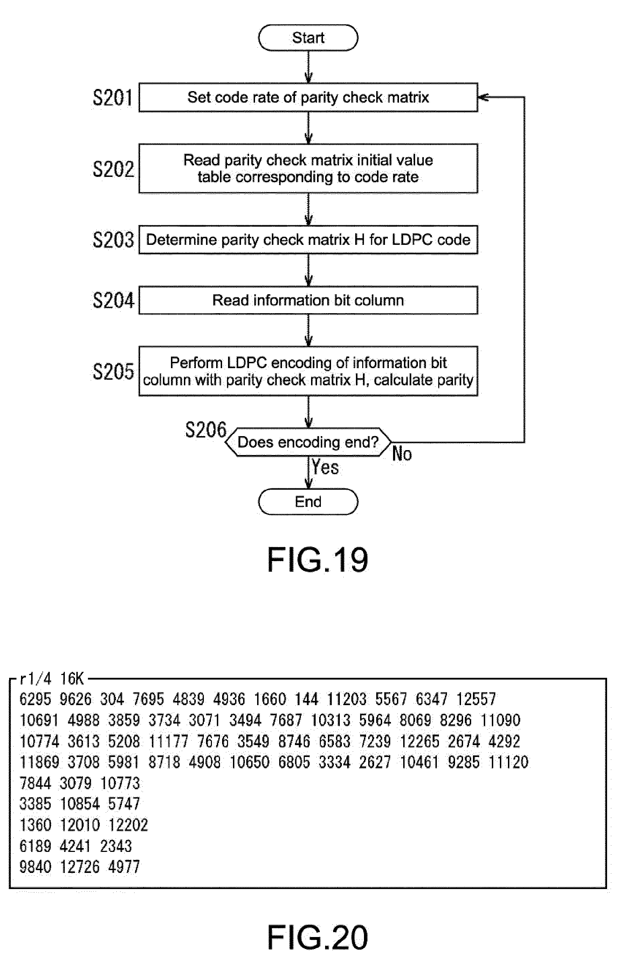

Fig. 19 is a flowchart illustrating the process of the LDPC encoder 115 in Fig. 18.

At step S201, the code rate set unit 611 determines (sets) the code length N and the code rate r with which the LDPC encoding is performed.

At step S202, the initial value table read unit 612 reads the parity check matrix initial value table determined in advance corresponding to the code length N and the code rate r determined by the code rate set unit 611 from the storage unit 602.

At step S203, the parity check matrix generation unit 613 obtains (generates) the parity check matrix H of the LDPC code whose code length N and the code rate r determined by the code rate set unit 611 using the parity check matrix initial value table read by the initial value table read unit 612 from the storage unit 602 and supplies the same to the storage unit 602 to store.

At step S204, the information bit read unit 614 reads the information bits of the information length K (= N x r) corresponding to the code length N and the code rate r determined by the code rate set unit 611 from the LDPC target data supplied to the LDPC encoder 115 and reads the parity check matrix H obtained by the parity check matrix generation unit 613 from the storage unit 602 to supply to the encoding parity operation unit 615.

At step S205, the encoding parity operation unit 615 sequentially calculates the parity bit of the code word c satisfying equation (8) using the information bit from the information bit read unit 614 and the parity check matrix H.${Hc}^{T} = 0$

In equation (8), c represents the row vector as the code word (LDPC code) and c^{T} represents transposition of the row vector c.

Herein, as described above, when the part of the information bit and the part of the parity bit of the row vector c as the LDPC code (one code word) are represented by the row vector A and the row vector T, respectively, the row vector c may be represented by the equation c = [A|T] by the row vector A as the information bit and the row vector T as the parity bit.

The parity check matrix H and the row vector c = [A|T] as the LDPC code are required to satisfy the equation Hc^{T} = 0 and it is possible to sequentially obtain the row vector T as the parity bit configuring the row vector c = [A|T] satisfying such equation Hc^{T} = 0 by setting the element of each row to 0 in order from the element of the first row of the column vector Hc^{T} in the equation Hc^{T} = 0 when the parity matrix H_{T} of the parity check matrix H = [H_{A}|H_{T}] has the stepwise structure illustrated in Fig. 11.

When the encoding parity operation unit 615 obtains the parity bit T for the information bit A from the information bit read unit, this outputs the code word c = [A|T] represented by the information bit A and the parity bit T as a result of the LDPC encoding of the information bit A.

Thereafter, at step S206, the controller 616 judges whether to finish the LDPC encoding. At step S206, when it is judged that the LDPC encoding is not finished, that is to say, when there still is the LDPC target data to be LDPC encoded, for example, the process returns to step S201 (or step S204) and the processes at steps S201 (or step S204) to S206 are hereinafter repeated.

When it is judged that the LDPC encoding is finished at step S206, that is to say, there is no LDPC target data to be LDPC encoded, for example, the LDPC encoder 115 finishes the process.

In this manner, the parity check matrix initial value table corresponding to each code length N and each code rate r is prepared, and the LDPC encoder 115 performs the LDPC encoding with a predetermined code length N and a predetermined code rate r using the parity check matrix H generated from the parity check matrix initial value table corresponding to the predetermined code length N and the predetermined code rate r.

### <Example of parity check matrix initial value table>

The parity check matrix initial value table is the table indicating the position of the element 1 of the information matrix H_{A} (Fig. 10) corresponding to the information length K according to the code length N and code rate r is the LDPC code (LDPC code defined by the parity check matrix H) of the parity check matrix for each 360 columns (the number of columns P being the unit of the cyclic structure) and is created in advance for each parity check matrix H of each code length N and each code rate r.

Fig. 20 is a view illustrating an example of the parity check matrix initial value table.

That is to say, Fig. 20 illustrates the parity check matrix initial value table for the parity check matrix H whose code length N is 16200 bits and code rate (code rate in notation of DVB-T.2) r is 1/4 specified in the DVB.T-2 standard.

The parity check matrix generation unit 613 (Fig. 18) obtains the parity check matrix H in a following manner using the parity check matrix initial value table.

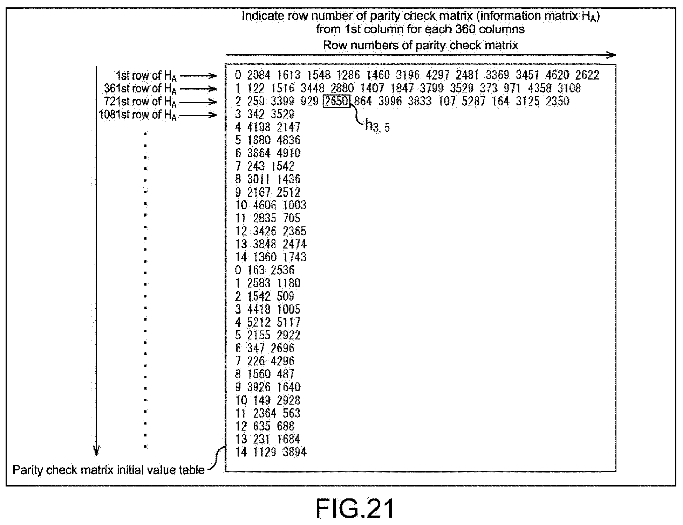

Fig. 21 illustrates a method of obtaining the parity check matrix H from the parity check matrix initial value table.

In other words, the parity check matrix initial value table in Fig. 21 illustrates the parity check matrix initial value table for the parity check matrix H whose code length N is 16200 bits and code rate r is 2/3 specified in the DVB.T-2 standard.

The parity check matrix initial value table is the table indicating the position of the element 1 of the information matrix H_{A} (Fig. 10) corresponding to the information length K according to the code length N and code rate r is the LDPC code for each 360 columns (the number of columns P being the unit of the cyclic structure) as described above in which row numbers (the row number of the first row of the parity check matrix H is 0) of the elements of 1 of a 1 + 360 × (i -1)-th column of the parity check matrix H as many as the number of column weights of the 1 + 360 × (i - 1)-th column are arranged in an i-th row.

Herein, the parity matrix H_{T} (Fig. 10) corresponding to the parity length M of the parity check matrix H is determined as illustrated in Fig. 15, so that the information matrix H_{A} (Fig. 10) corresponding to the information length K of the parity check matrix H is obtained according to the parity check matrix initial value table.

The number of rows k + 1 of the parity check matrix initial value table differs according to the information length K.

The information length K and the number of rows k + 1 of the parity check matrix initial value table satisfy relationship in equation (9).$K = \left(k+1\right) \times 360$

Herein, 360 in equation (9) is the number of columns P being the unit of the cyclic structure illustrated in Fig. 16.

In the parity check matrix initial value table in Fig. 21, 13 values are arranged in each of first to third rows and 3 values are arranged in each of fourth to k + 1-th rows (30th row in Fig. 21).

Therefore, the column weights of the parity check matrix H obtained from the parity check matrix initial value table in Fig. 21 are 13 from the first column to 1 + 360 × (3 - 1) -1-th column and 3 from the 1 + 360 × (3 - 1)-th column to a K-th column.

The first row of the parity check matrix initial value table in Fig. 21 is 0, 2084, 1613, 1548, 1286, 1460, 3196, 4297, 2481, 3369, 3451, 4620, and 2622 and this indicates that the element of the rows whose row numbers are 0, 2084, 1613, 1548, 1286, 1460, 3196, 4297, 2481, 3369, 3451, 4620, and 2622 is 1 (and other elements are 0) in the first column of the parity check matrix H.

Also, the second row of the parity check matrix initial value table in Fig. 21 is 1, 122, 1516, 3448, 2880, 1407, 1847, 3799, 3529, 373, 971, 4358, and 3108 and this indicates that the element of the rows whose row numbers are 1, 122, 1516, 3448, 2880, 1407, 1847, 3799, 3529, 373, 971, 4358, and 3108 are 1 in a 361 (= 1 + 360 × (2 - 1))-th column of the parity check matrix H.

As described above, the parity check matrix initial value table indicates the position of the element 1 of the information matrix H_{A} of the parity check matrix H for each 360 columns.

The column other than the 1 + 360 × (i - 1)-th column of the parity check matrix H, that is to say, each column from a 2 + 360 × (i - 1)-th column to a 360 × i-th column is obtained by periodically performing the cyclic shift to the element 1 of the 1 + 360 × (i - 1)-th column determined by the parity check matrix initial value table downward (in a direction toward a lower part of the column) according to the parity length M to arrange.

That is to say, the 2 + 360 × (i - 1)-th column is obtained by the cyclic shift of the 1 + 360 × (i - 1)-th column downward by M/360 (= q) and a next 3 + 360 × (i - 1)-th column is obtained by the cyclic shift of the 1 + 360 × (i - 1)-th column downward by 2 × M/360 (= 2 × q) (the cyclic shift of the 2 + 360 × (i - 1)-th column downward by M/360(= q)), for example.

Herein, if an i-th row (i-th row from the top) j-th column (j-th column from left) value of the parity check matrix initial value table is represented as hᵢ,ⱼ and the row number of a j-th element 1 of a w-th column of the parity check matrix H is represented as H_{w-j}, a row number H_{w-j} of the element 1 of the w-th column being the column other than the 1 + 360 × (i - 1)-th column of the parity check matrix H may be obtained by equation (10).${H}_{w - j} = mod { {h}_{i , j} + mod \left(\left(w-1\right), P\right) \times q , M )$

Herein, mod (x, y) represents a remainder obtained when x is divided by y.

Also, P represents the above-described number of columns being the unit of the cyclic structure, which is set to 360 as described above in the DVB-S.2 standard, the DVB-T.2 standard and the DVB-C.2 standard, for example. Further, q represents a value M/360 obtained by dividing the parity length M by the number of columns P (= 360) being the unit of the cyclic structure.

The parity check matrix generation unit 613 (Fig. 18) specifies the row number of the element 1 of the 1 + 360 × (i -1)-th column of the parity check matrix by the parity check matrix initial value table.

Further, the parity check matrix generation unit 613 (Fig. 18) obtains the row number H_{w-j} of the element 1 of the w-th column being the column other than the 1 + 360 × (i -1)-th column of the parity check matrix H according to equation (10) and generates the parity check matrix H in which an element of the row number obtained from above is 1.

### <New LDPC code>

At present, the standard for terrestrial digital television broadcasting which is called as ATSC3.0 is planned.

A planned LDPC code (hereinafter also referred to as a "new LDPC code") such as ATSC3.0 and other data broadcasting will be described.

As for the new LDPC code, the parity matrix H_{T} of the parity check matrix H has the stepwise structure (Fig. 11) as is the case with the LDPC code specified in DVB-T.2 from a viewpoint of maintaining compatibility with DVB-T.2 as far as possible.

Further, as for the new LDPC code, as is the case with the LDPC code specified in DVB-T.2, the information matrix H_{A} of the parity check matrix H has the cyclic structure and the number of columns P being the unit of the cyclic structure is set to 360.

The LDPC encoder 115 (Fig. 8, Fig. 18) performs the LDPC encoding to the new LDPC encoding using the parity check matrix H obtained from the parity check matrix initial value table of the new LDPC encoding whose code length N is 16k bits or 64k bits and any of the code rates r of 6/15, 7/15, 8/15, 9/15, 10/15, 11/15, 12/15 or 13/15 as described below.

In this case, the parity check matrix initial value table is stored in the storage unit 602 of the LDPC encoder 115 (Fig. 8).

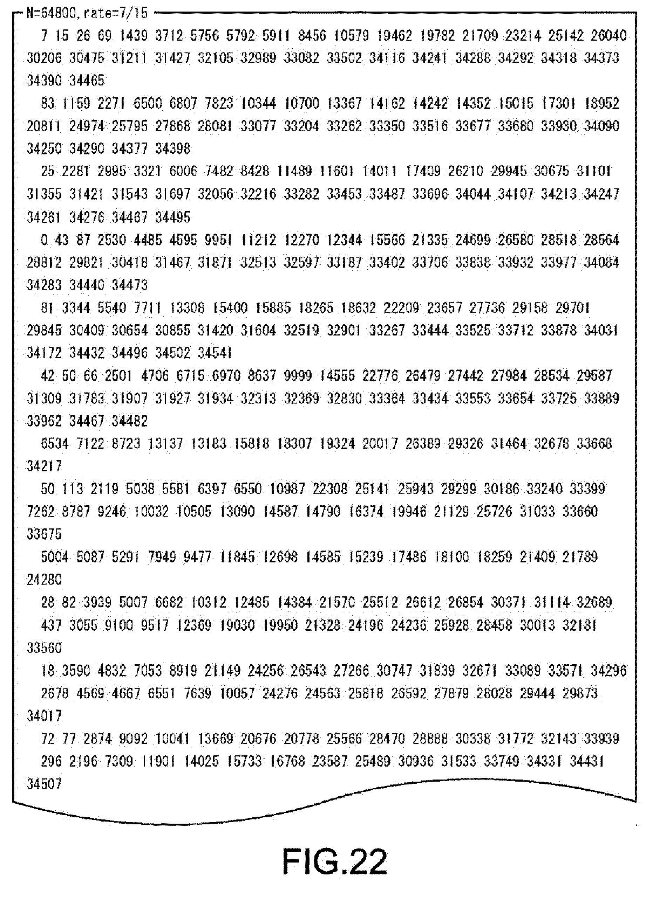

Fig. 22, Fig. 23 and Fig. 24 each is a diagram showing the parity check matrix initial value table of the parity check matrix H of a first new LDPC code whose code length N is 64k bits and code rate r is 7/15 (hereinafter also referred to as a "first new LDPC code of (64k, 7/15)).

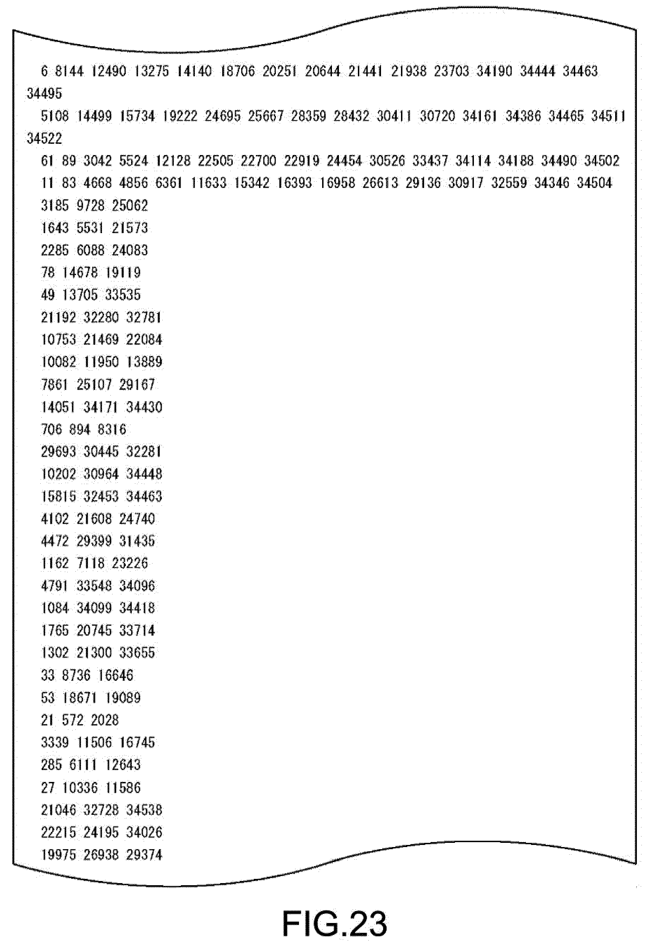

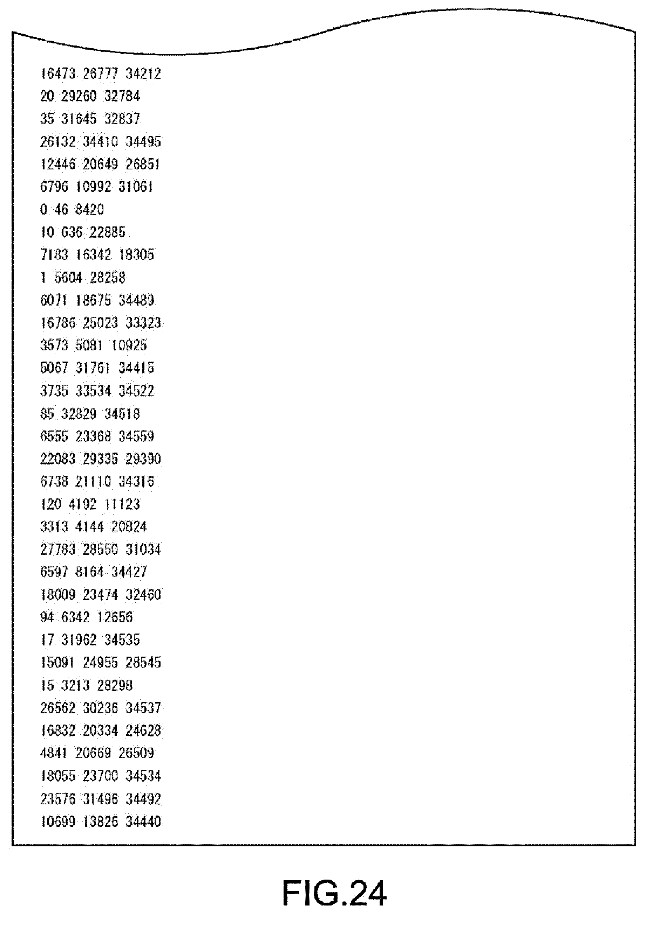

Fig. 23 follows Fig. 22. Fig. 24 follows Fig. 23.

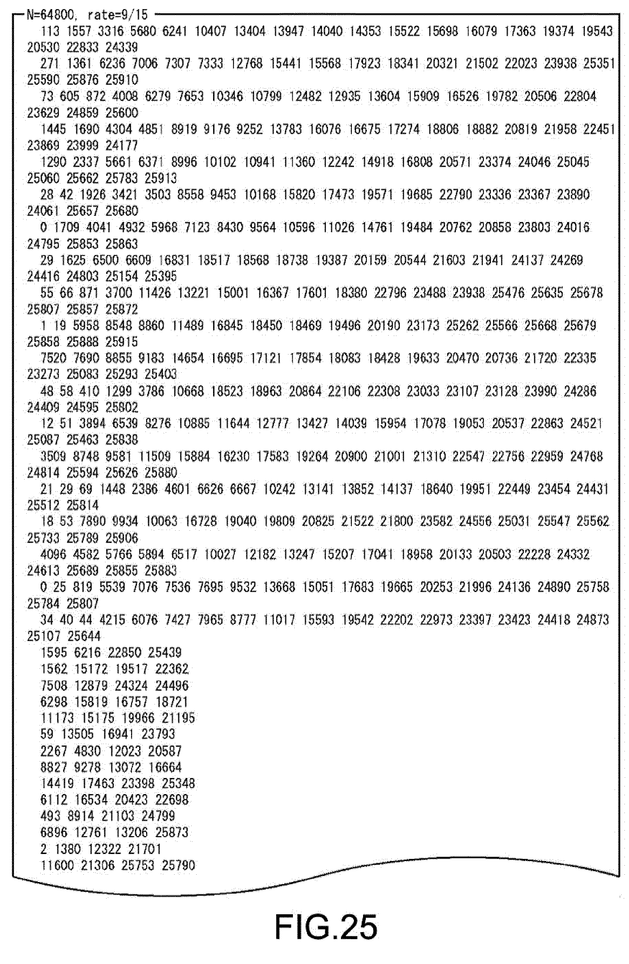

Fig. 25, Fig. 26 and Fig. 27 each is a diagram showing the parity check matrix initial value table of the parity check matrix H of a first new LDPC code whose code length N is 64k bits and code rate r is 9/15 (hereinafter also referred to as a "first new LDPC code of (64k, 9/15)).

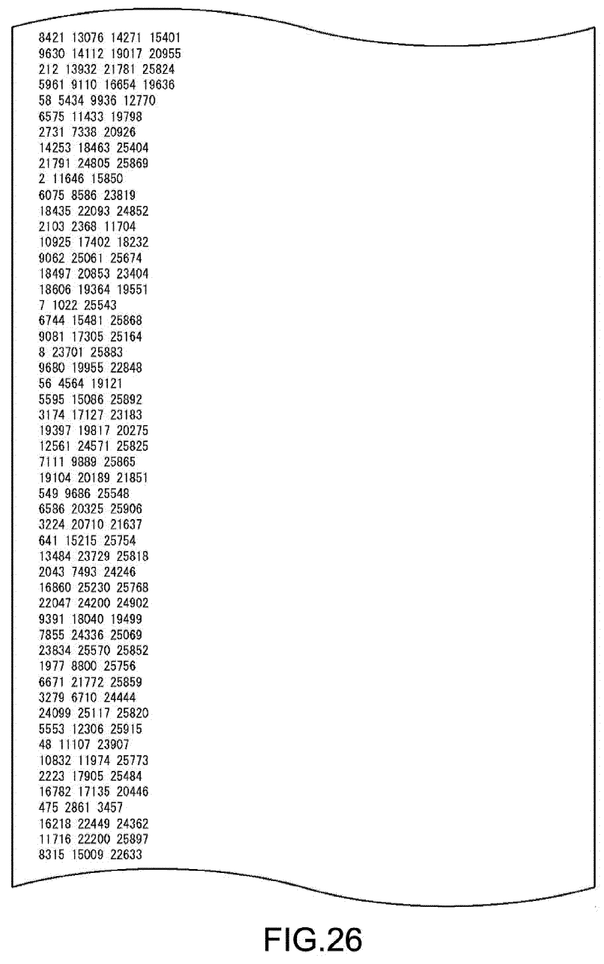

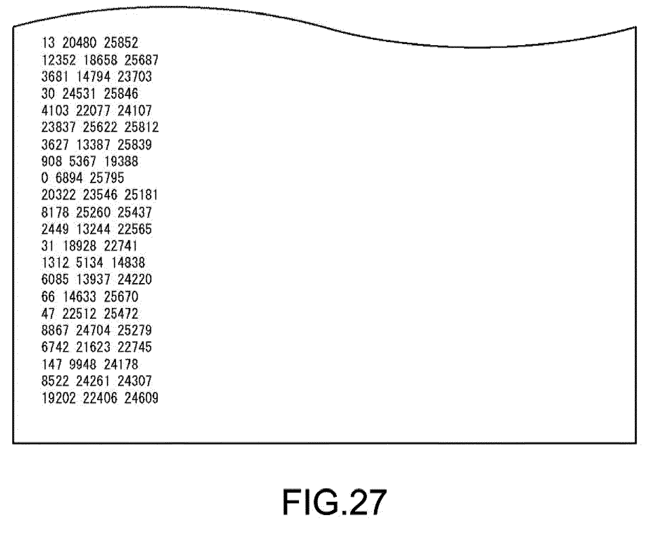

Fig. 26 follows Fig. 25. Fig. 27 follows Fig. 26.

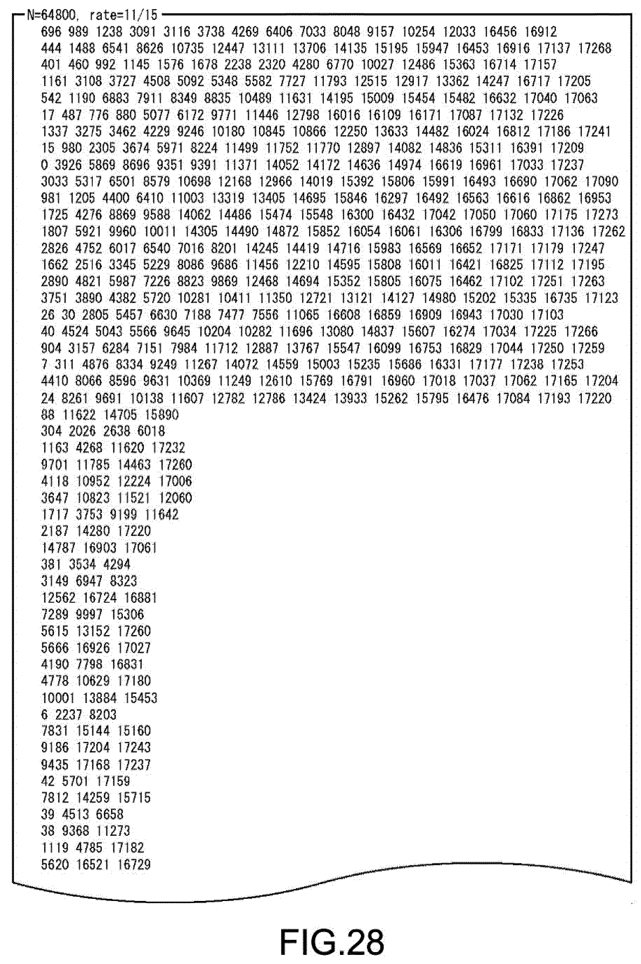

Fig. 28, Fig. 29 and Fig. 30 each is a diagram showing the parity check matrix initial value table of the parity check matrix H of a first new LDPC code whose code length N is 64k bits and code rate r is 11/15 (hereinafter also referred to as a "first new LDPC code of (64k, 11/15)).

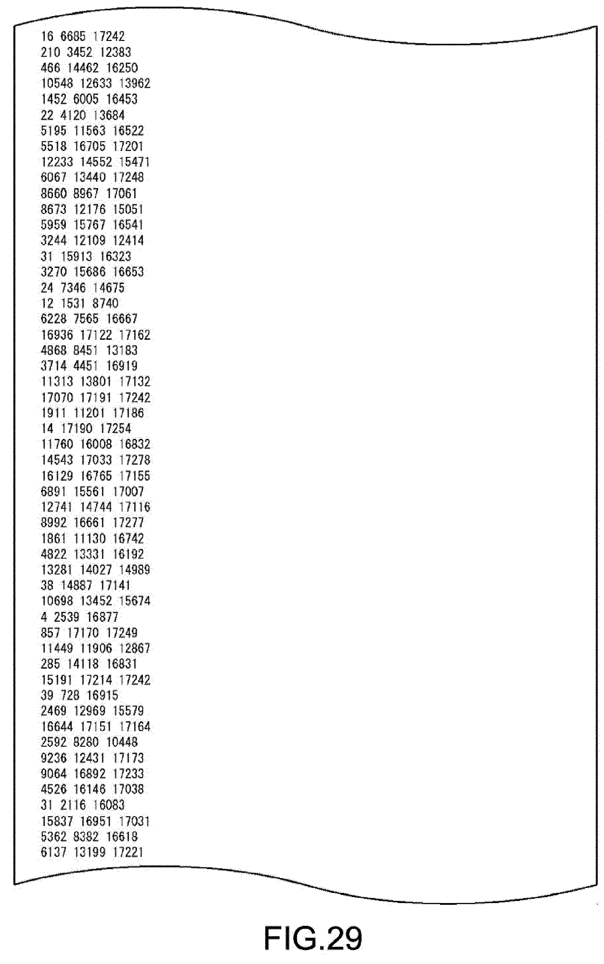

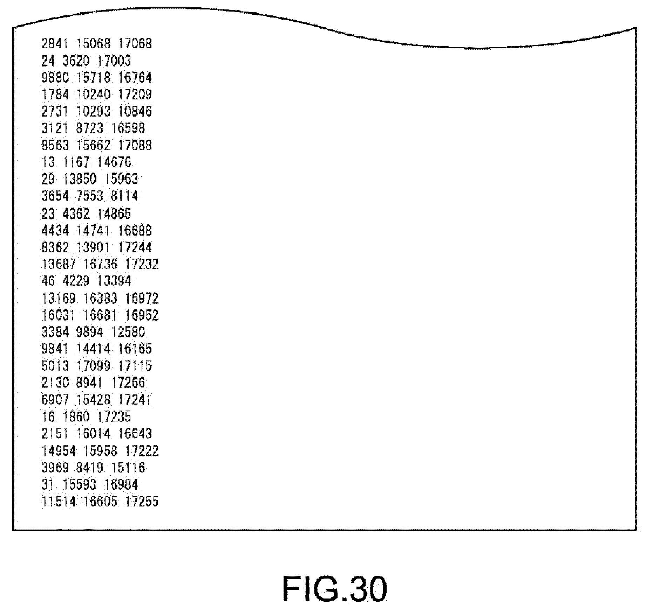

Fig. 29 follows Fig. 28. Fig. 30 follows Fig. 29.

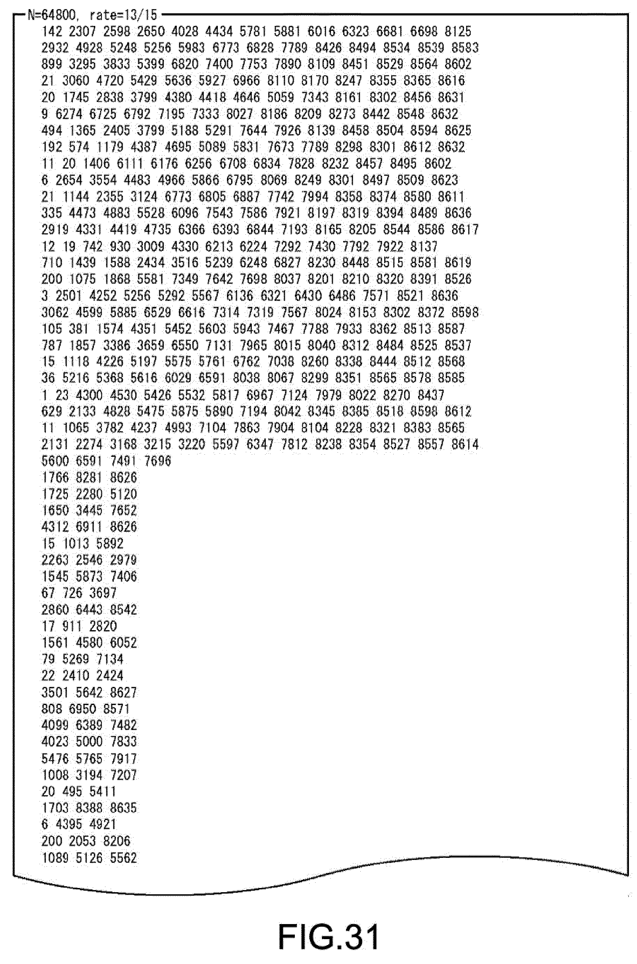

Fig. 31, Fig. 32 and Fig. 33 each is a diagram showing the parity check matrix initial value table of the parity check matrix H of a first new LDPC code whose code length N is 64k bits and code rate r is 13/15 (hereinafter also referred to as a "first new LDPC code of (64k, 13/15)).

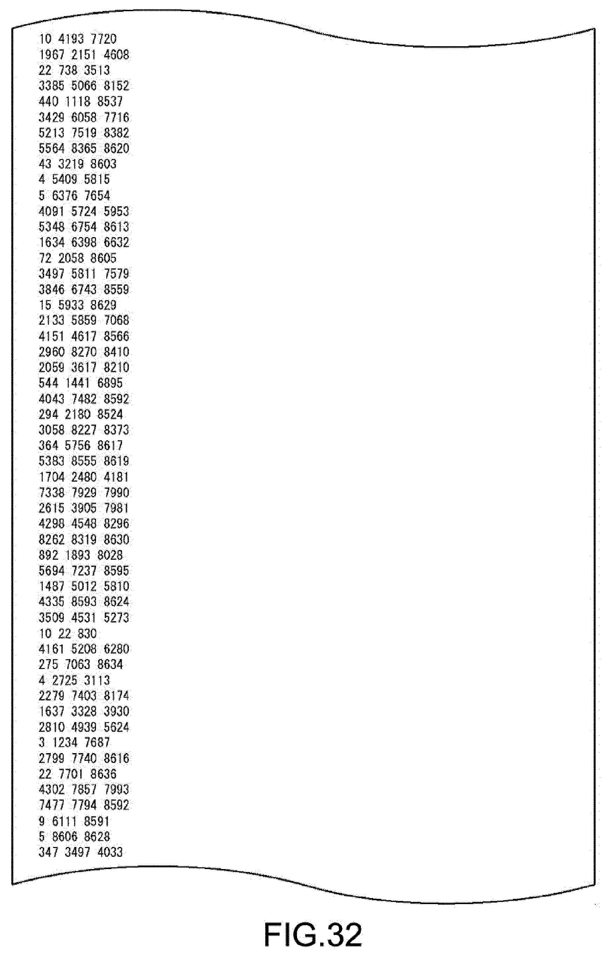

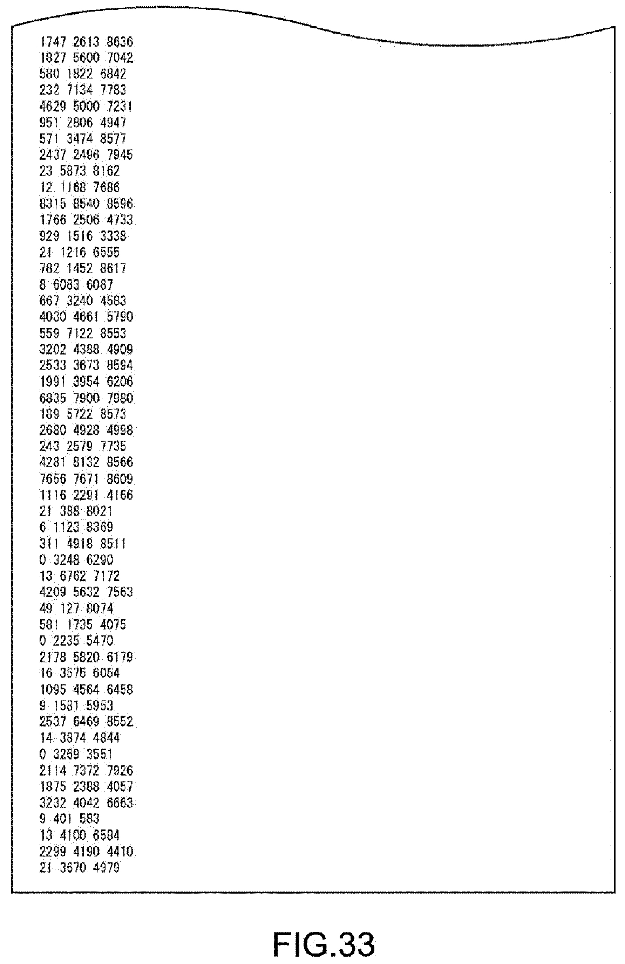

Fig. 32 follows Fig. 31. Fig. 33 follows Fig. 32.

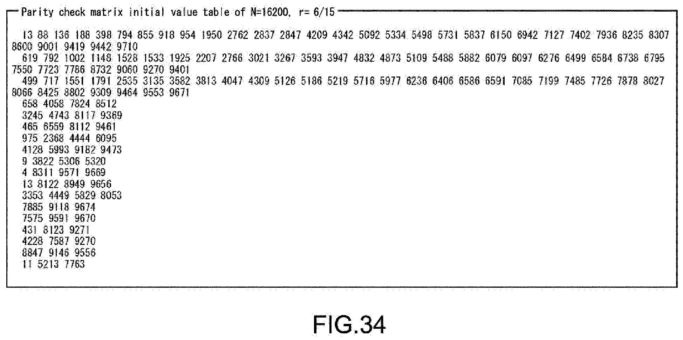

Fig. 34 is a diagram showing the parity check matrix initial value table of the parity check matrix H of a first new LDPC code whose code length N is 16k bits and code rate r is 6/15 (hereinafter also referred to as a "first new LDPC code of (16k, 6/15)).

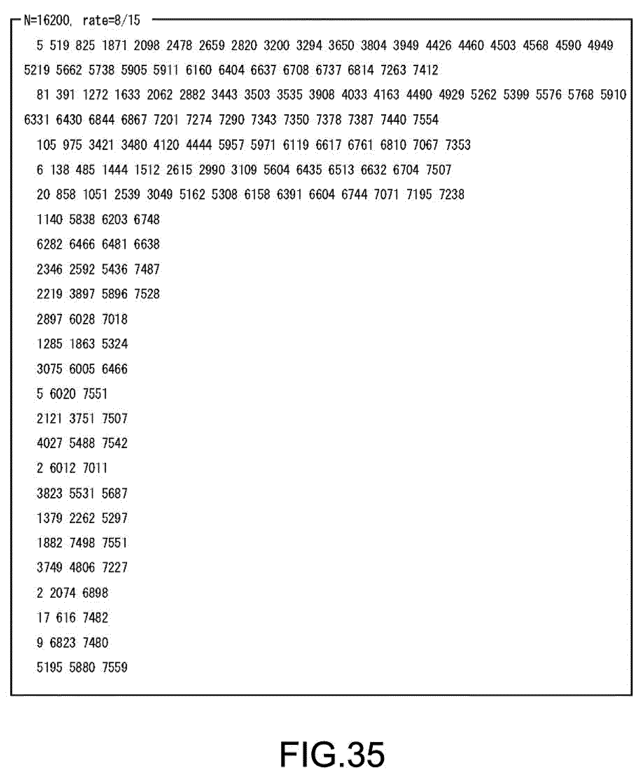

Fig. 35 is a diagram showing the parity check matrix initial value table of the parity check matrix H of a first new LDPC code whose code length N is 16k bits and code rate r is 8/15 (hereinafter also referred to as a "first new LDPC code of (16k, 8/15)).

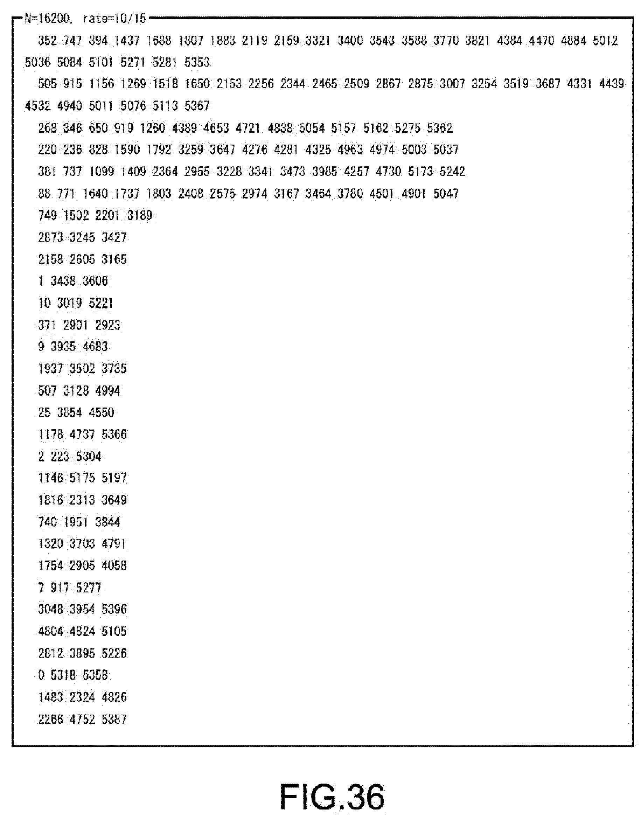

Fig. 36 is a diagram showing the parity check matrix initial value table of the parity check matrix H of a first new LDPC code whose code length N is 16k bits and code rate r is 10/15 (hereinafter also referred to as a "first new LDPC code of (16k, 10/15)).

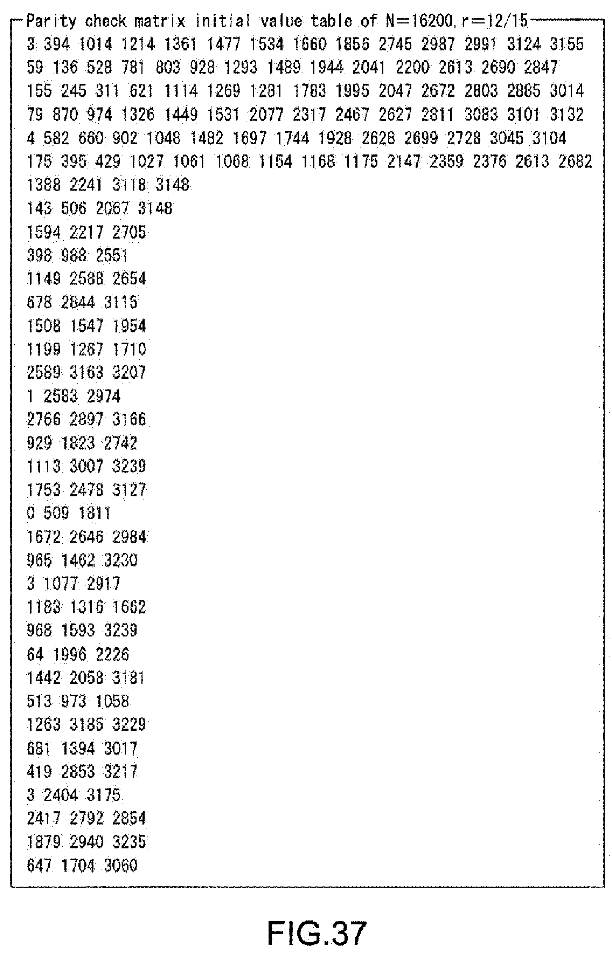

Fig. 37 is a diagram showing the parity check matrix initial value table of the parity check matrix H of a first new LDPC code whose code length N is 16k bits and code rate r is 12/15 (hereinafter also referred to as a "first new LDPC code of (16k, 12/15)).

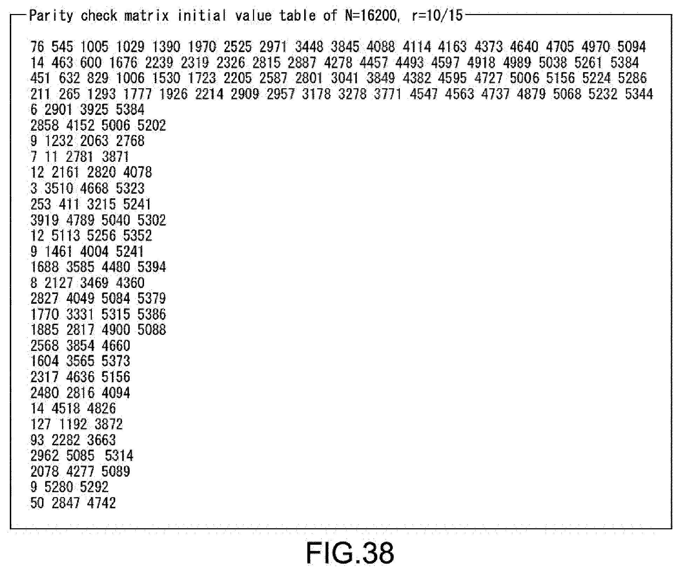

Fig. 38 is a diagram showing the parity check matrix initial value table of the parity check matrix H of a first other new LDPC code whose code length N is 16k bits and code rate r is 10/15 (hereinafter also referred to as a "first other new LDPC code of (16k, 10/15)).

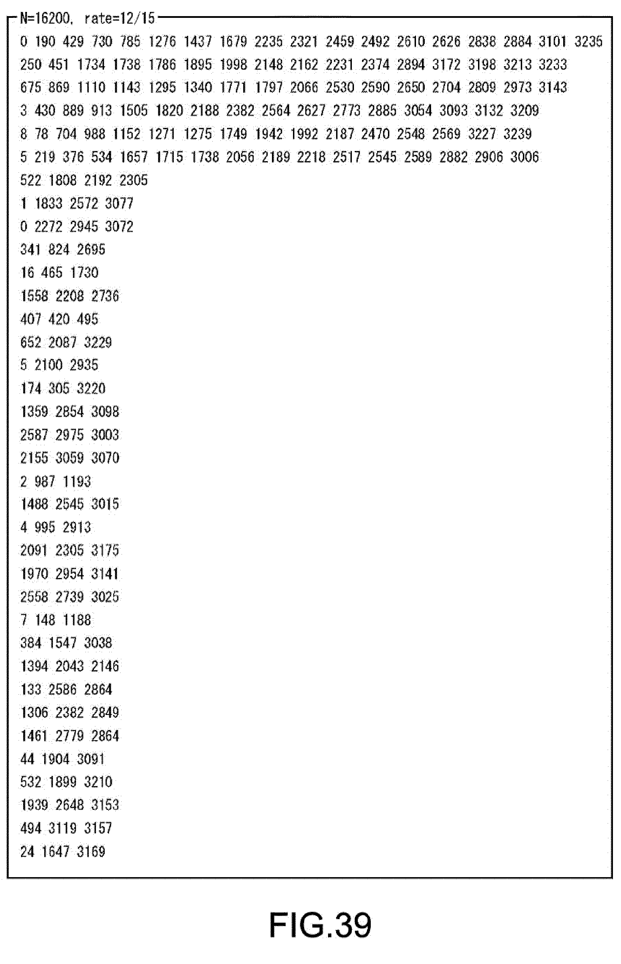

Fig. 39 is a diagram showing the parity check matrix initial value table of the parity check matrix H of a first other new LDPC code whose code length N is 16k bits and code rate r is 12/15 (hereinafter also referred to as a "first other new LDPC code of (16k, 12/15)).

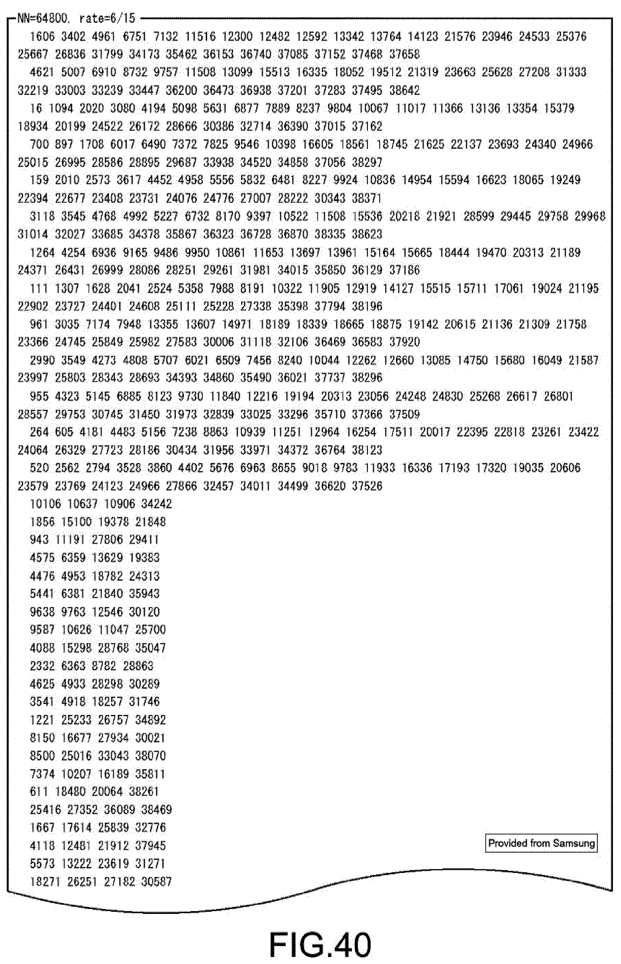

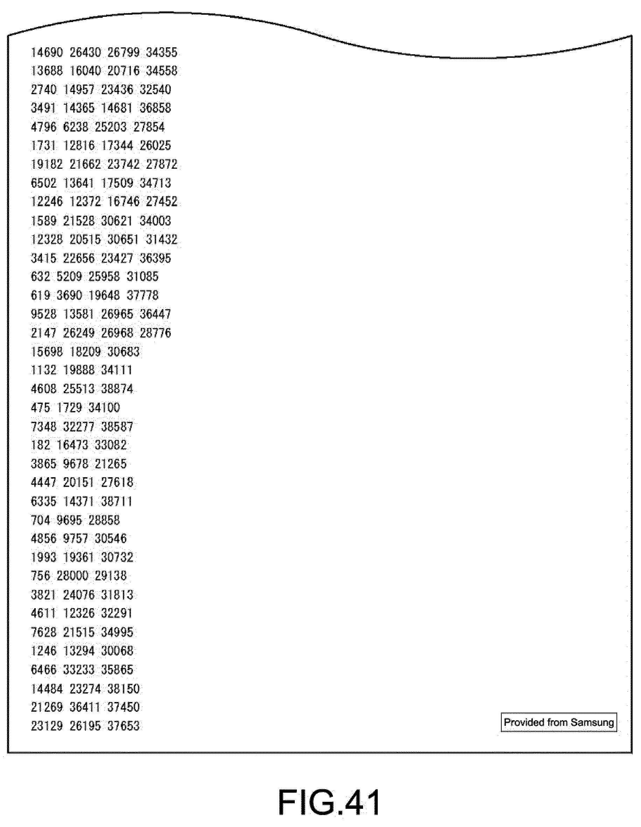

Fig. 40 and Fig. 41 each is a diagram showing the parity check matrix initial value table of the parity check matrix H of a second new LDPC code whose code length N is 64k bits and code rate r is 6/15 (hereinafter also referred to as a "second new LDPC code of (64k, 6/15)).

Fig. 41 follows Fig. 40.

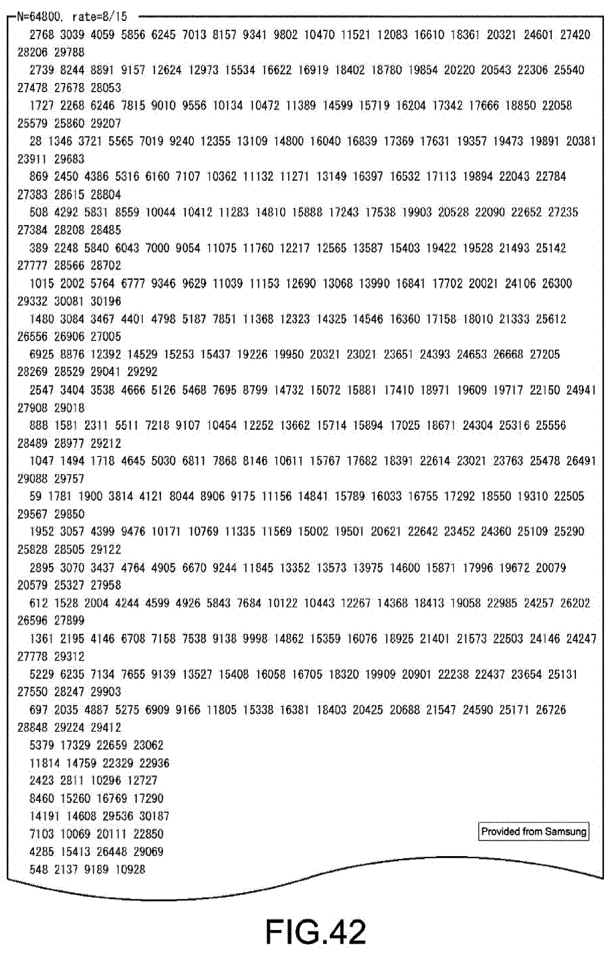

Fig. 42, Fig. 43 and Fig. 44 each is a diagram showing the parity check matrix initial value table of the parity check matrix H of a second new LDPC code whose code length N is 64k bits and code rate r is 8/15 (hereinafter also referred to as a "second new LDPC code of (64k, 8/15)).

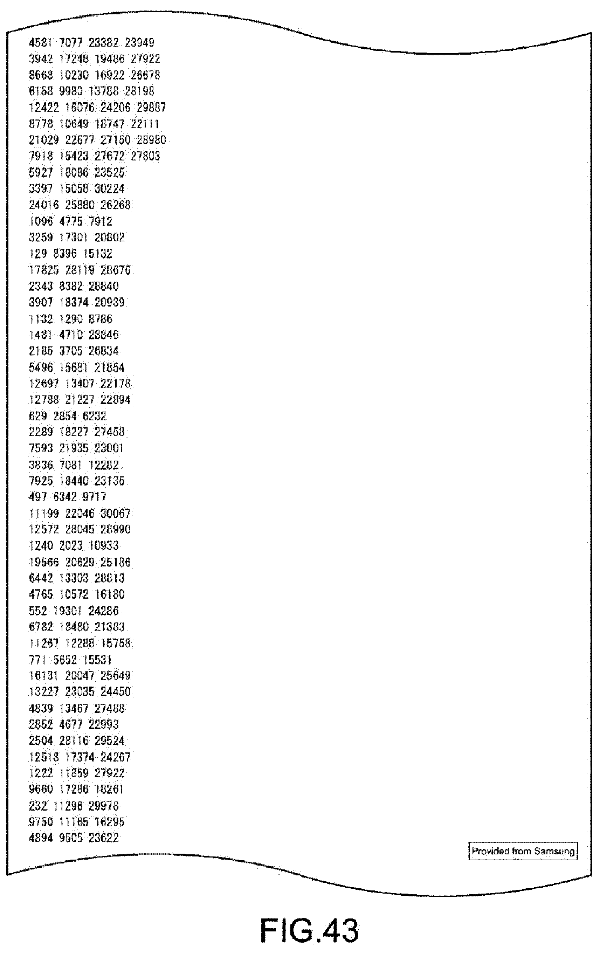

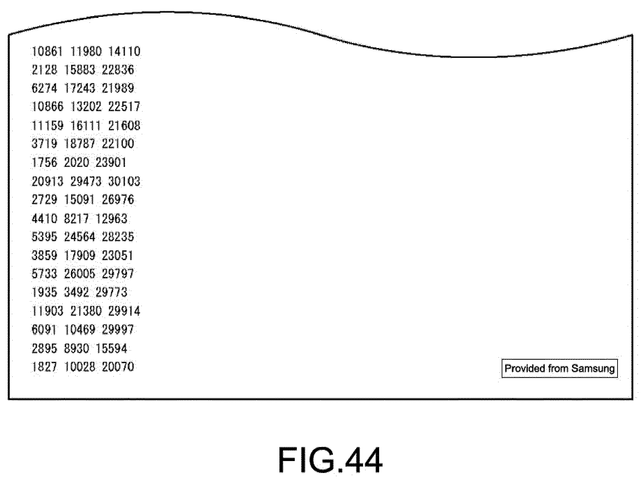

Fig. 43 follows Fig. 42. Fig. 44 follows Fig. 43.

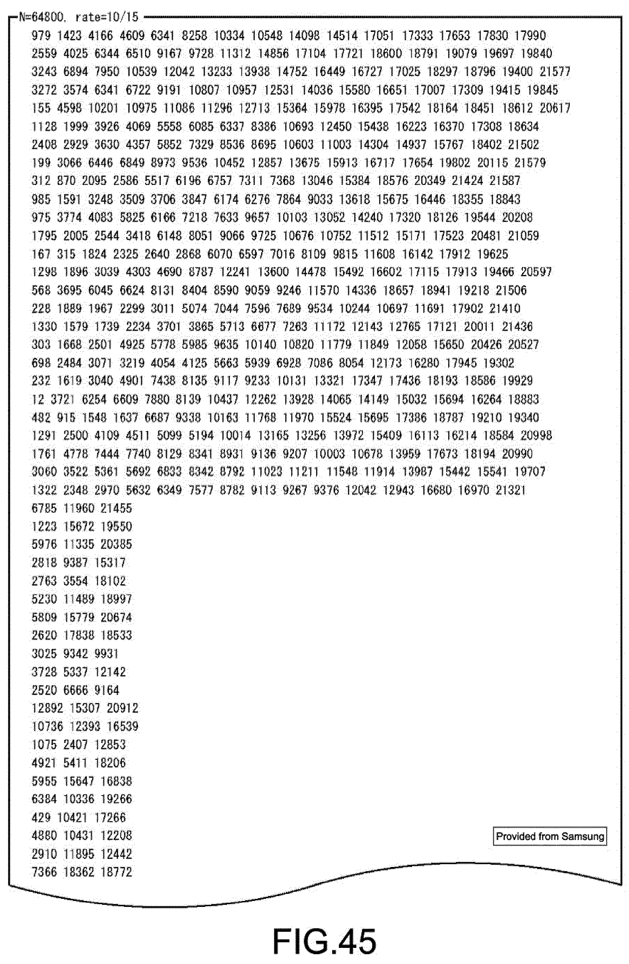

Fig. 45, Fig. 46 and Fig. 47 each is a diagram showing the parity check matrix initial value table of the parity check matrix H of a second new LDPC code whose code length N is 64k bits and code rate r is 10/15 (hereinafter also referred to as a "second new LDPC code of (64k, 10/15)).

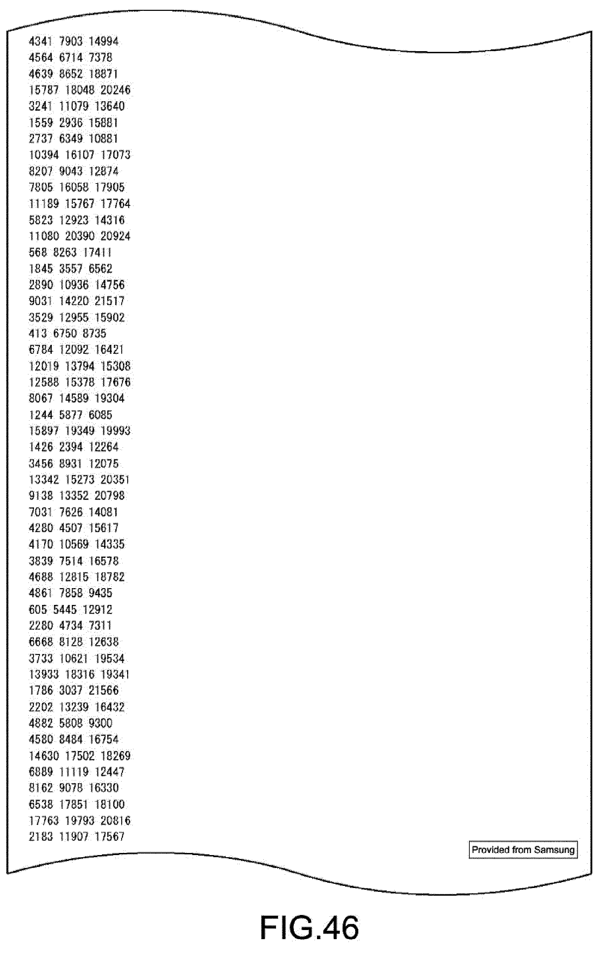

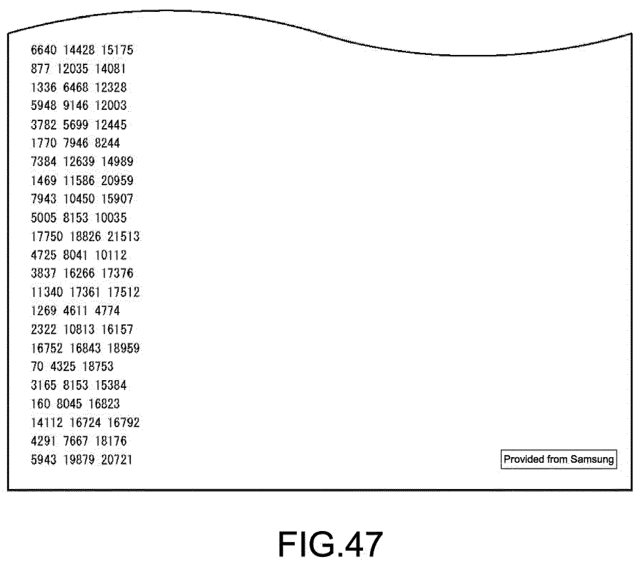

Fig. 46 follows Fig. 45. Fig. 47 follows Fig. 46.

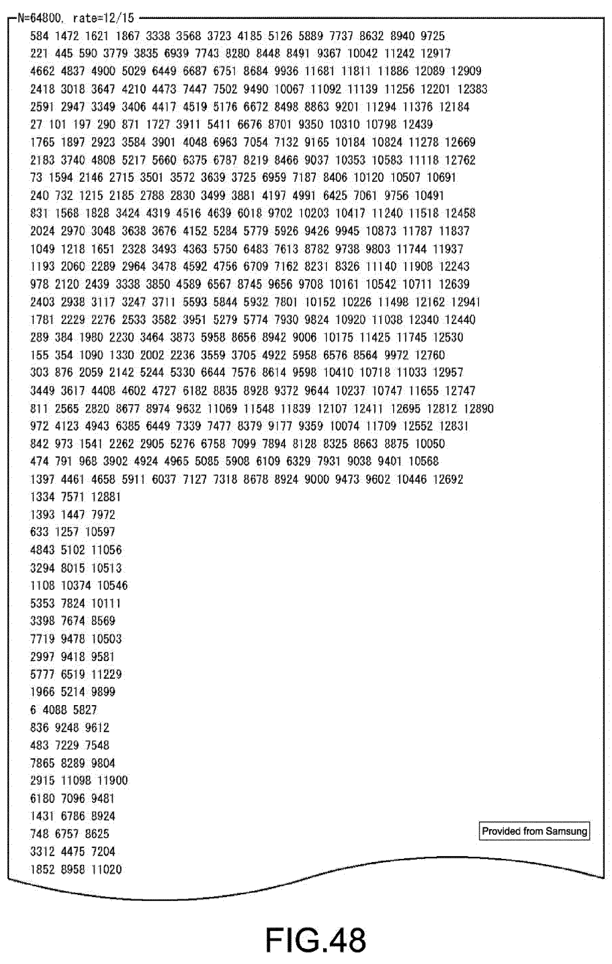

Fig. 48, Fig. 49 and Fig. 50 each is a diagram showing the parity check matrix initial value table of the parity check matrix H of a second new LDPC code whose code length N is 64k bits and code rate r is 12/15 (hereinafter also referred to as a "second new LDPC code of (64k, 12/15)).

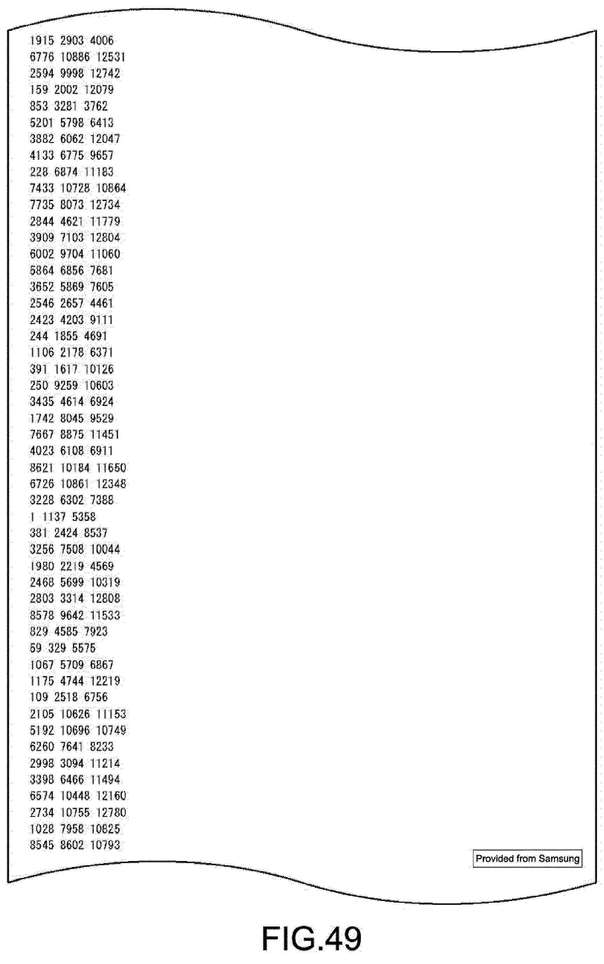

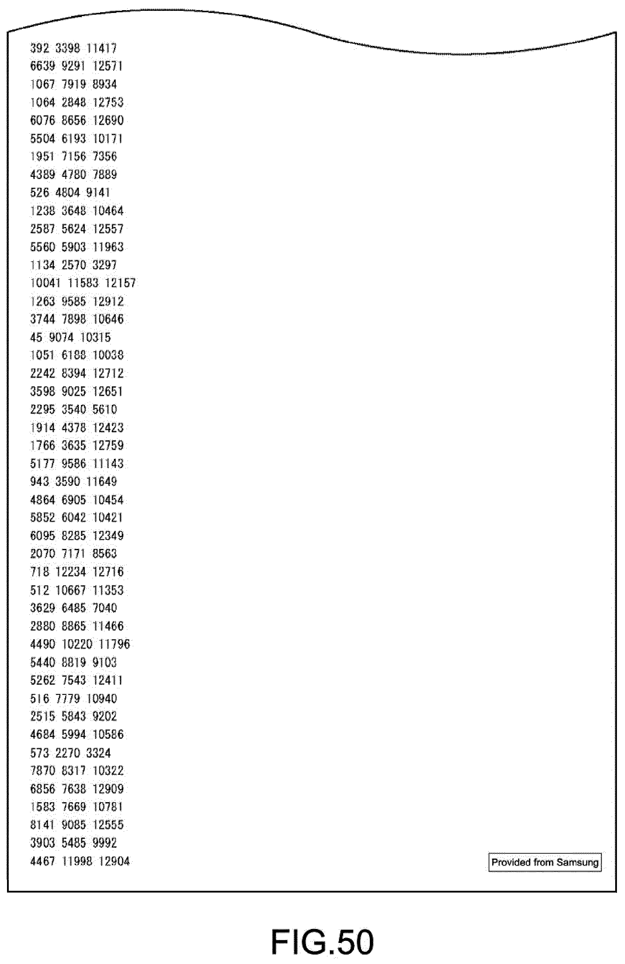

Fig. 49 follows Fig. 48. Fig. 50 follows Fig. 49.

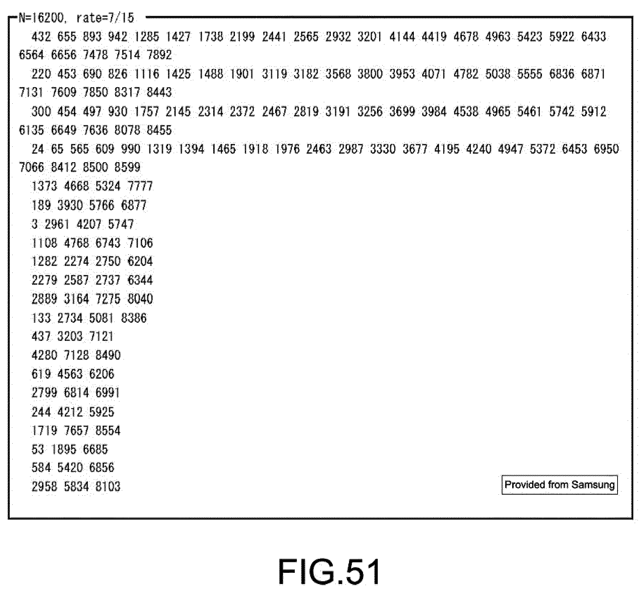

Fig. 51 is a diagram showing the parity check matrix initial value table of the parity check matrix H of a second new LDPC code whose code length N is 16k bits and code rate r is 7/15 (hereinafter also referred to as a "second new LDPC code of (16k, 7/15)).

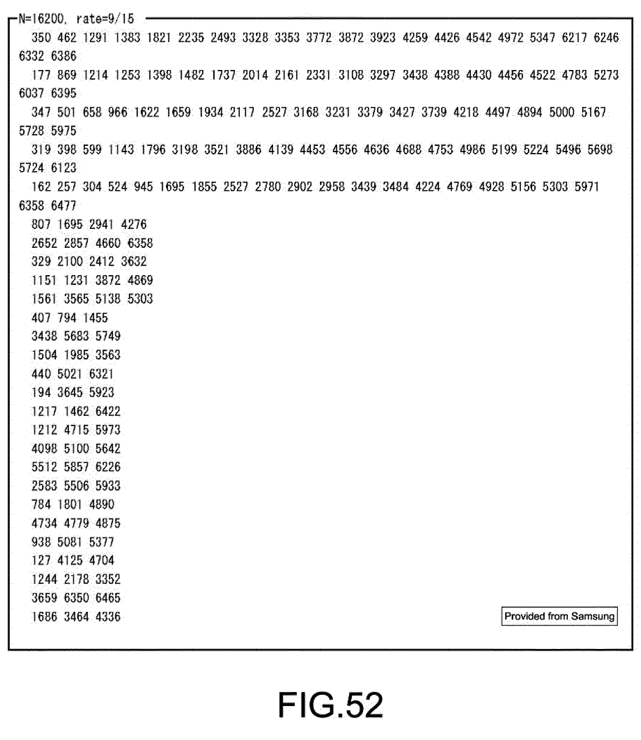

Fig. 52 is a diagram showing the parity check matrix initial value table of the parity check matrix H of a second new LDPC code whose code length N is 16k bits and code rate r is 9/15 (hereinafter also referred to as a "second new LDPC code of (16k, 9/15)).

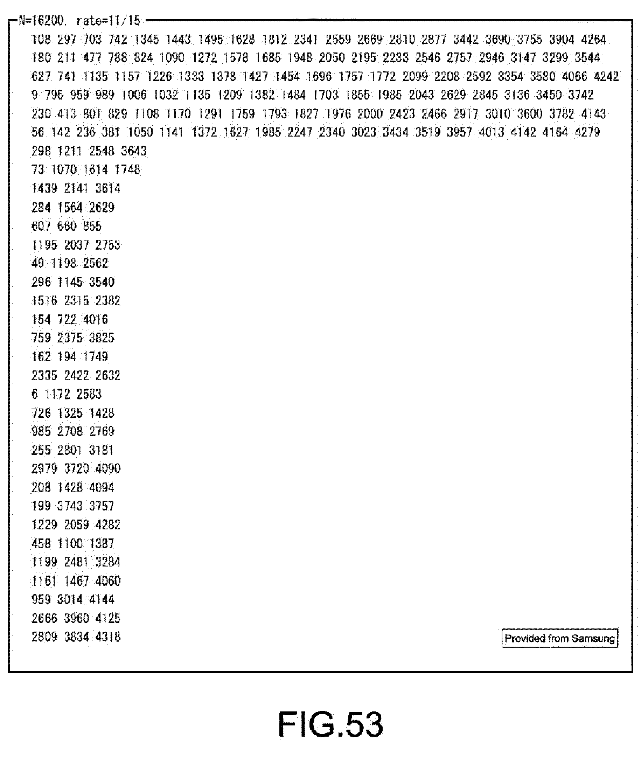

Fig. 53 is a diagram showing the parity check matrix initial value table of the parity check matrix H of a second new LDPC code whose code length N is 16k bits and code rate r is 11/15 (hereinafter also referred to as a "second new LDPC code of (16k, 11/15)).

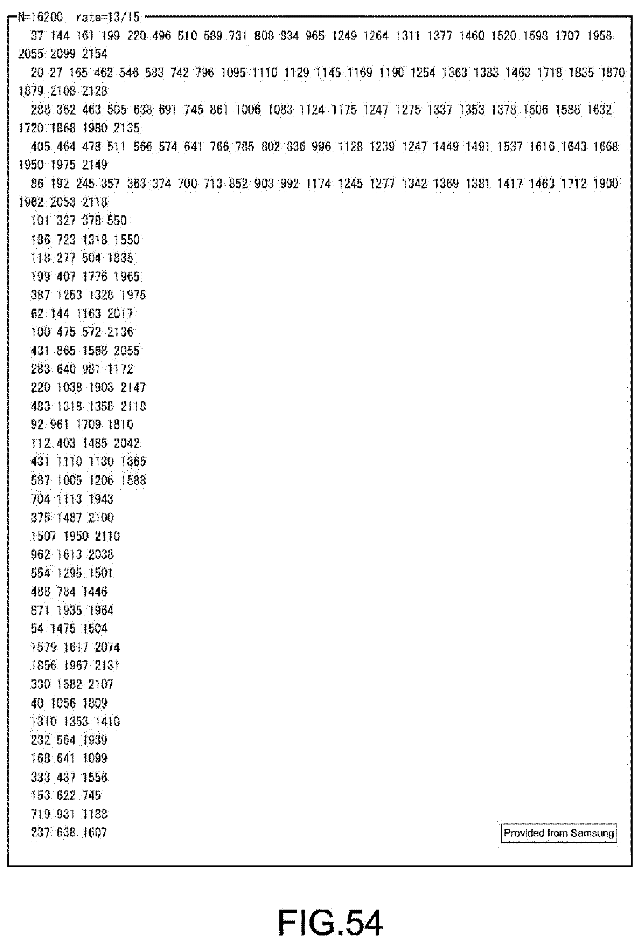

Fig. 54 is a diagram showing the parity check matrix initial value table of the parity check matrix H of a second new LDPC code whose code length N is 16k bits and code rate r is 13/15 (hereinafter also referred to as a "second new LDPC code of (16k, 13/15)).

(The parity check matrix initial value tables of the parity check matrices H of) the second new LDPC codes shown in Fig. 40 to Fig. 54 are provided from Samsung.

The first new LDPC codes and the first other new LDPC codes are high-performance LDPC codes.

Herein, the high-performance LDPC code is obtained from an appropriate parity check matrix H.

The term the "appropriate parity check matrix H" is intended to mean the parity check matrix, which satisfies a predetermined condition to make the BER (and FER) lower when the LDPC code obtained from the parity check matrix H is transmitted with low Es/No or Eb/No (signal power to noise power ratio per bit).

The appropriate parity check matrix H may be obtained by the simulation of the measurement of the BER at the time when the LDPC code obtained from the various parity check matrices satisfying the predetermined condition is transmitted with the low Es/No, for example.

The predetermined condition, which the appropriate parity check matrix H should satisfy, includes an excellent analysis result obtained by an analyzing method of performance of the code referred to as density evolution, absence of a loop of the elements of 1 referred to as cycle-4 and the like, for example.

Herein, it is known that the decoding performance of the LDPC code is deteriorated when the elements of 1 close up as the cycle-4 in the information matrix H_{A}, so that the absence of the cycle-4 is required as the predetermined condition, which the appropriate parity check matrix H should satisfy.

The predetermined condition, which the appropriate parity check matrix H should satisfy, may be appropriately determined from a viewpoint of improvement in the decoding performance of the LDPC code, facilitation (simplification) of the decoding process of the LDPC code and the like.

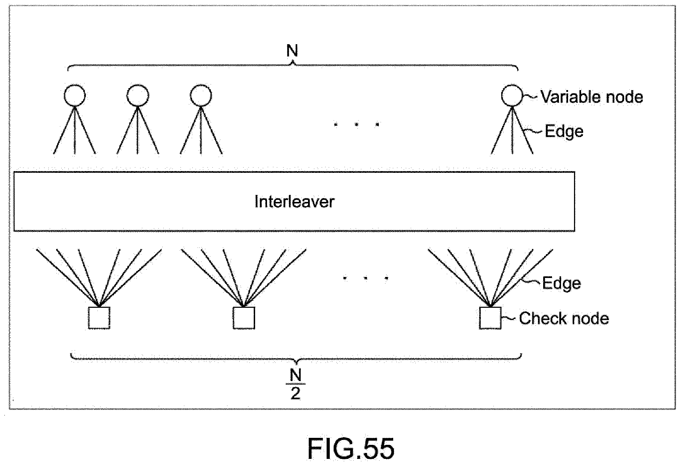

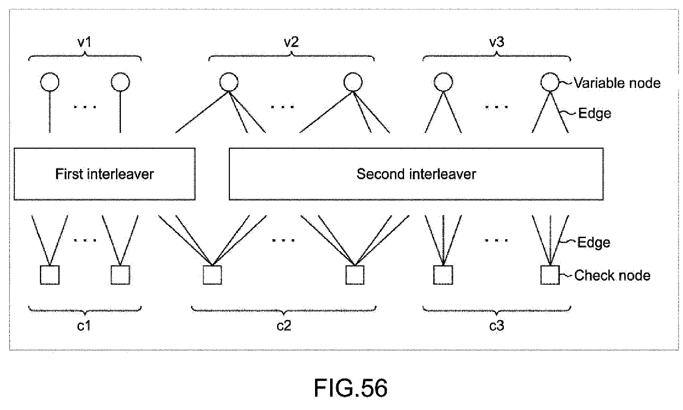

Fig. 55 and Fig. 56 are views illustrating the density evolution with which the analysis result as the predetermined condition, which the appropriate parity check matrix H should satisfy, is obtained.

The density evolution is the analyzing method of the code, which calculates an expected value of the error probability for an entire LDPC code (ensemble) whose code length N is ∞ characterized by a degree sequence to be described later.

For example, when a variance value of noise is set to be larger from 0 on the AWGN channel, the expected value of the error probability of a certain ensemble, which is initially 0, is no longer 0 when the variance value of the noise becomes a certain threshold or larger.

According to the density evolution, it is possible to determine whether performance of the ensemble (appropriateness of the parity check matrix) is excellent by comparing the threshold of the variance value of the noise (hereinafter, also referred to as a performance threshold) at which the expected value of the error probability is no longer 0.

It is possible to predict rough performance of a specific LDPC code by determining the ensemble to which the LDPC code belongs and performing the density evolution to the ensemble.

Therefore, when a high-performance ensemble is found, the high-performance LDPC code may be found from the LDPC codes belonging to the ensemble.

Herein, the above-described degree sequence indicates a ratio of the variable node and the check node having the weight of each value to the code length N of the LDPC code.

For example, a regular (3, 6) LDPC code whose code rate is 1/2 belongs to the ensemble characterized by the degree sequence in which the weight (column weight) of all the variable nodes is 3 and the weight (row weight) of all the check nodes is 6.

Fig. 55 shows the Tanner graph of such ensemble.

In the Tanner graph in Fig. 55, there are N (equal to the code length N) variable nodes represented by a circle (○) in the drawing and N/2 (equal to a product obtained by multiplying the code rate 1/2 by the code length N) check nodes represented by a square (0) in the drawing.

Three edges, the number of which is equal to the column weight, are connected to each variable node, so that there are a total of 3N edges connected to the N variable nodes.

Also, six edges the number of which is equal to the row weight, are connected to each check node, so that there are a total of 3N edges connected to the N/2 check nodes.

Further, there is one interleaver in the Tanner graph in Fig. 55.

The interleaver randomly rearranges the 3N edges connected to the N variable nodes and connects the rearranged edges to any of the 3N edges connected to the N/2 check nodes.

There are (3N)!(= (3N) × (3N - 1) × ··· × 1) rearranging patterns of rearranging the 3N edges connected to the N variable nodes by the interleaver. Therefore, the ensemble characterized by the degree sequence in which the weight of all the variable nodes is 3 and the weight of all the check nodes is 6 is a set of (3N)! LDPC codes.

In the simulation for obtaining the high-performance LDPC code (appropriate parity check matrix), a multi-edge type ensemble is used in the density evolution.

In the multi-edge type, the interleaver through which the edge connected to the variable node and the edge connected to the check node pass is divided into a multi-edge one, so that the ensemble is more strictly characterized.

Fig. 56 shows an example of the Tanner graph of the multi-edge type ensemble.

In the Tanner graph in Fig. 56, there are two interleavers, which are a first interleaver and a second interleaver.

In the Tanner graph in Fig. 56, there are v1 variable nodes with one edge connected to the first interleaver and no edge connected to the second interleaver, v2 variable nodes with one edge connected to the first interleaver and two edges connected to the second interleaver, and v3 variable nodes with no edge connected to the first interleaver and two edges connected to the second interleaver.

Further, in the Tanner graph in Fig. 56, there are c1 check nodes with two edges connected to the first interleaver and no edge connected to the second interleaver, c2 check nodes with two edges connected to the first interleaver and two edges connected to the second interleaver, and c3 check nodes with no edge connected to the first interleaver and three edges connected to the second interleaver.

Herein, the density evolution and implementation thereof are described in "On the Design of Low-Density Parity-Check Codes within 0.0045 dB of the Shannon Limit", S. Y. Chung, G. D. Forney, T. J. Richardson, and R. Urbanke, IEEE Communications Leggers, VOL. 5, NO. 2, Feb 2001, for example.

In the simulation for obtaining (the parity check matrix initial value table of) the first new LDPC codes and the first other new LDPC code, the ensemble in which the performance threshold being Eb/No (signal power to noise power ratio per bit) at which the BER starts to decrease (to be lower) is a predetermined value or smaller is found by multi-edge type density evolution and the LDPC code to decrease the BER is selected as the high-performance LDPC code out of the LDPC codes belonging to the ensemble.

The parity check matrix initial value tables of the above-described first new LDPC codes and first other new LDPC codes are determined by the above simulation.

Accordingly, by the first new LDPC codes and the first other new LDPC codes obtained from the parity check matrix initial value tables, it is possible to ensure a good communication quality in the data transmission.

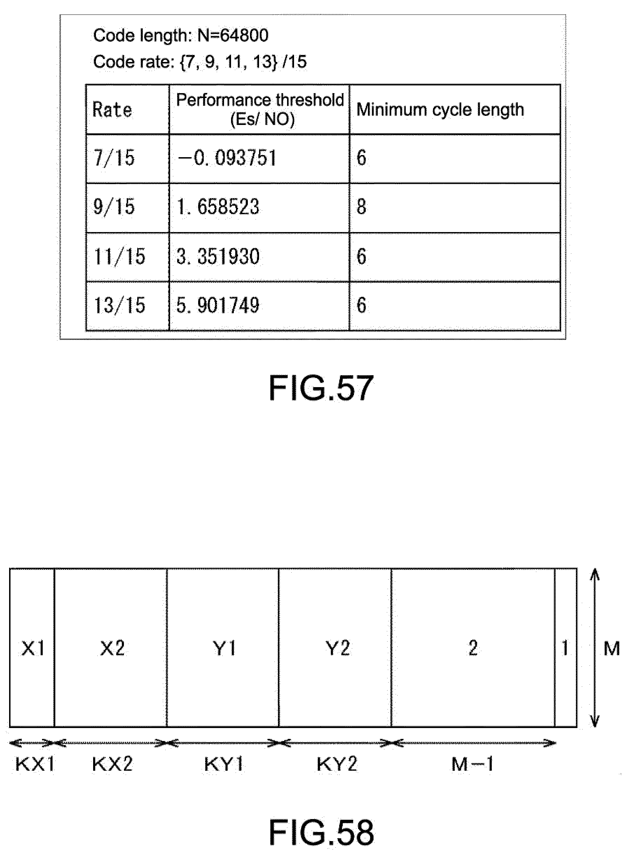

Fig. 57 is a view showing a minimum cycle length and a performance threshold of the parity check matrices H obtained from the parity check matrix initial value tables of the first new LDPC codes of (64k, 7/15), (64k, 9/15), (64k, 11/15) and (64k, 13/15) (hereinafter also referred to as "the parity check matrices H of the first new LDPC codes of (64k, 7/15), (64k, 9/15), (64k, 11/15) and (64k, 13/15)) shown in Fig. 22 to Fig. 33.

Here, the minimum cycle length (girth) means a minimum value of a length of a loop (loop length) configured of the elements of 1 in the parity check matrix H.

The parity check matrices H of the first new LDPC codes of (64k, 7/15), (64k, 9/15), (64k, 11/15) and (64k, 13/15) have no cycle-4 (the loop length of four, a loop of the elements of 1).

The performance threshold of the first new LDPC code of (64k, 7/15) is -0.093751, the performance threshold of the first new LDPC code of (64k, 9/15) is 1.658523, the performance threshold of the first new LDPC code of (64k, 11/15) is 3.351930 and the performance threshold of the first new LDPC code of (64k, 13/15) is 5.301749.

Fig. 58 is a view illustrating the parity check matrices H of the first new LDPC codes of (64k, 7/15), (64k, 9/15), (64k, 11/15) and (64k, 13/15) in Fig. 32 to Fig. 33.

The column weight is X1 for first to KX1-th columns of the parity check matrices H of the first new LDPC codes of (64k, 7/15), (64k, 9/15), (64k, 11/15) and (64k, 13/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 64800 bits of the first new LDPC codes of (64k, 7/15), (64k, 9/15), (64k, 11/15) and (64k, 13/15).

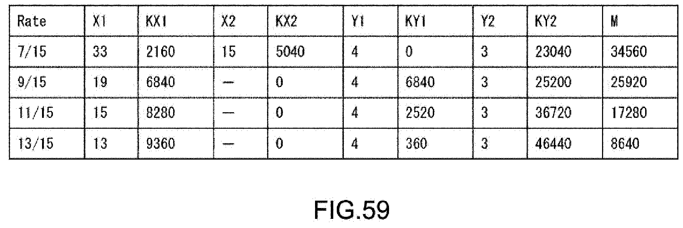

Fig. 59 is a view showing the numbers of columns KX1, KY2, KY1, KY2 and M, and the column weights X1, X2, Y1, and Y2 in Fig. 58 for the parity check matrices H of the first new LDPC codes of (64k, 7/15), (64k, 9/15), (64k, 11/15) and (64k, 13/15).

As for the parity check matrices H of the first new LDPC codes of (64k, 7/15), (64k, 9/15), (64k, 11/15) and (64k, 13/15), as is the case with the parity check matrix illustrated in Figs. 12 and 13, the column weight of the column closer to the top (left) column tends to be larger, so that the code bit closer to the top code bit of the new LDPC code tends to be more tolerant to error (have resistance to error).

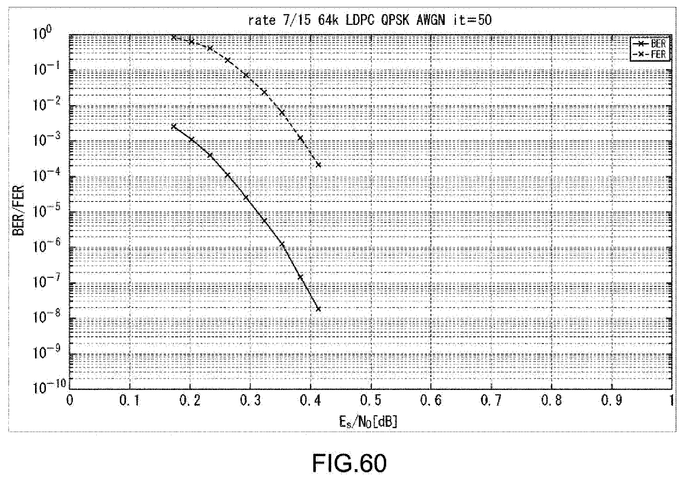

Fig. 60 is a view showing a simulation result of the BER/FER (bit error rate/frame error rate) of the first new LDPC code of (64k, 7/15) measured using the QPSK as the modulation scheme.

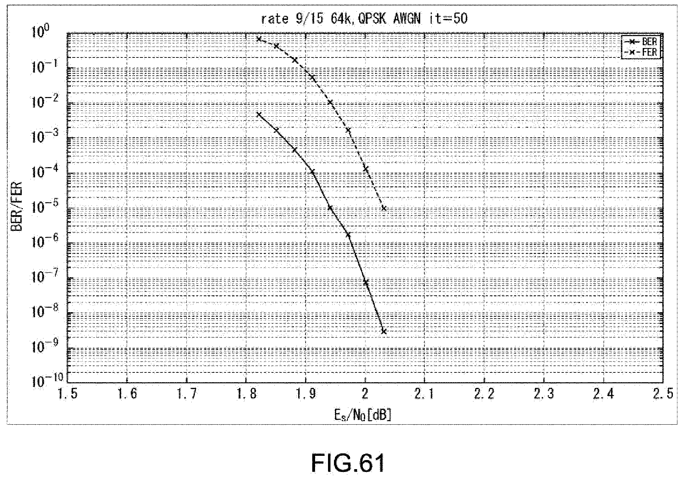

Fig. 61 is a diagram showing a simulation result of measurement of BER/FER about the first new LDPC code of (64k, 9/15) measured using the QPSK as the modulation scheme.

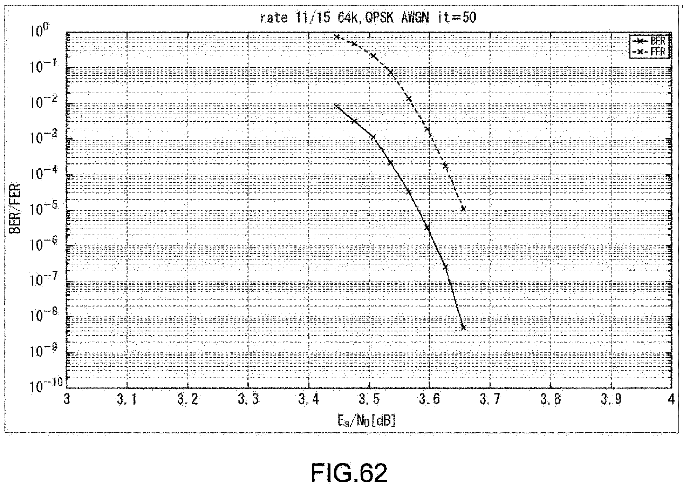

Fig. 62 is a view showing a simulation result of the BER/FER of the first new LDPC code of (64k, 11/15) measured using the QPSK as the modulation scheme.

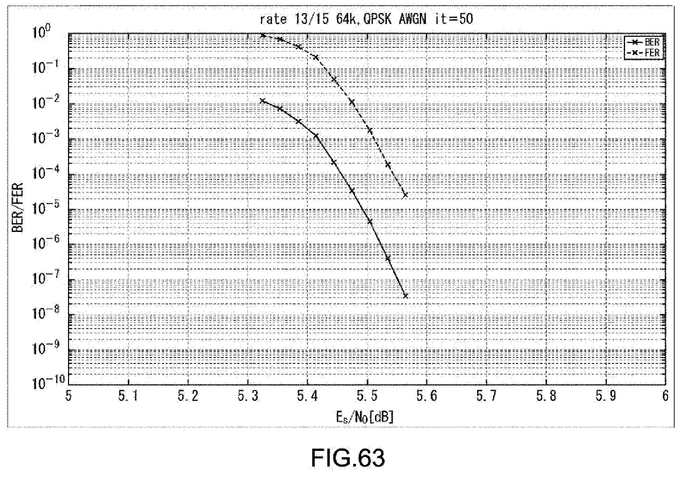

Fig. 63 is a view showing a simulation result of the BER/FER of the first new LDPC code of (64k, 13/15) measured using the QPSK as the modulation scheme.

In the simulation, the AWGN channel is supposed, and 50 times is adopted as the number of times of repetitive decoding C for decoding the LDPC code.

In Fig. 60 to Fig. 63, Es/No is plotted along the abscissa and the BER/FER is plotted along the ordinate. A solid line represents the BER, and a dotted line represents the FER.

According to Fig. 60 to Fig. 63, as for the first new LDPC codes of (64k, 7/15), (64k, 9/15), (64k, 11/15) and (64k, 13/15), excellent BER/FER are obtained. Accordingly, it can confirm that a good communication quality is ensured in the data transmission using the first new LDPC codes of (64k, 7/15), (64k, 9/15), (64k, 11/15) and (64k, 13/15).

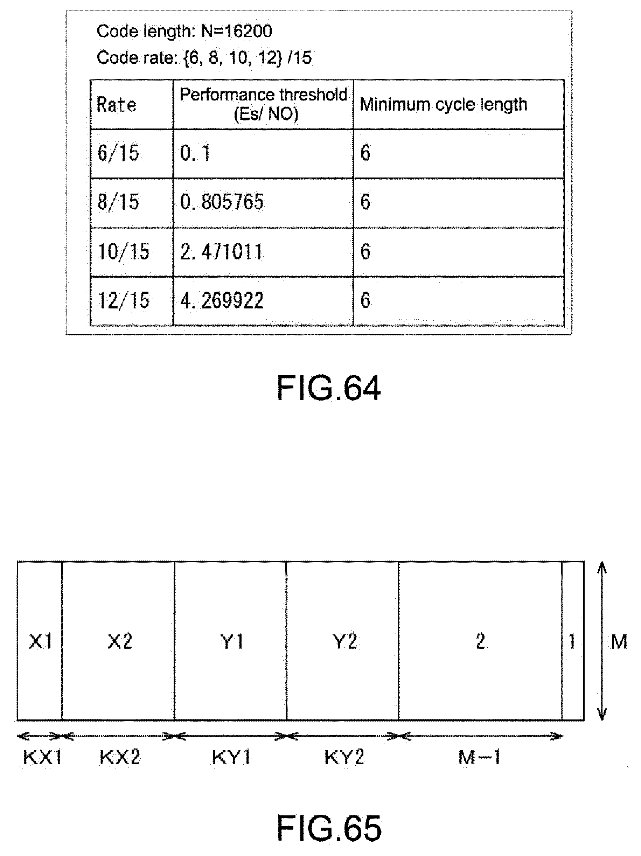

Fig. 64 is a view showing a minimum cycle length and a performance threshold of the parity check matrices H of the first new LDPC codes of (64k, 6/15), (64k, 8/15), (64k, 10/15) and (64k, 12/15) shown in Fig. 34 to Fig. 37.

The parity check matrices H of the first new LDPC codes of (16k, 6/15), (16k, 8/15), (16k, 10/15) and (16k, 12/15) have no cycle-4.

The performance threshold of the first new LDPC code of (16k, 6/15) is 0.01, the performance threshold of the first new LDPC code of (16k, 8/15) is 0.805765, the performance threshold of the first new LDPC code of (16k, 10/15) is 2.471011 and the performance threshold of the first new LDPC code of (16k, 12/15) is 4.269922.

Fig. 65 is a view illustrating the parity check matrices H of the first new LDPC codes of (16k, 6/15), (16k, 8/15), (16k, 10/15) and (16k, 12/15) in Fig. 34 to Fig. 37.

The column weight is X1 for first to KX1-th columns of the parity check matrices H of the first new LDPC codes of (16k, 6/15), (16k, 8/15), (16k, 10/15) and (16k, 12/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the first new LDPC codes of (16k, 6/15), (16k, 8/15), (16k, 10/15) and (16k, 12/15).

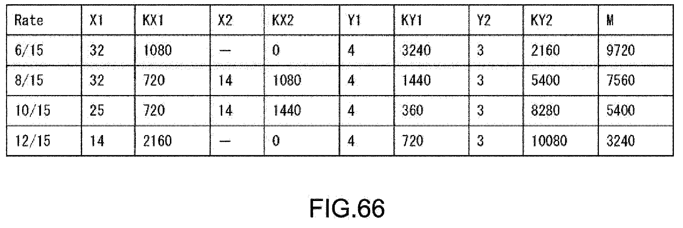

Fig. 66 is a view showing the numbers of columns KX1, KY2, KY1, KY2, and M, and the column weights X1, X2, Y1, and Y2 in Fig. 65 for the parity check matrices H of the first new LDPC codes of (16k, 6/15), (16k, 8/15), (16k, 10/15) and (16k, 12/15).

As for the parity check matrices H of the first new LDPC codes of (16k, 6/15), (16k, 8/15), (16k, 10/15) and (16k, 12/15), as is the case with the parity check matrix illustrated in Figs. 12 and 13, the column weight of the column closer to the top (left) column tends to be larger, so that the code bit closer to the top code bit of the new LDPC code tends to be more tolerant to error.

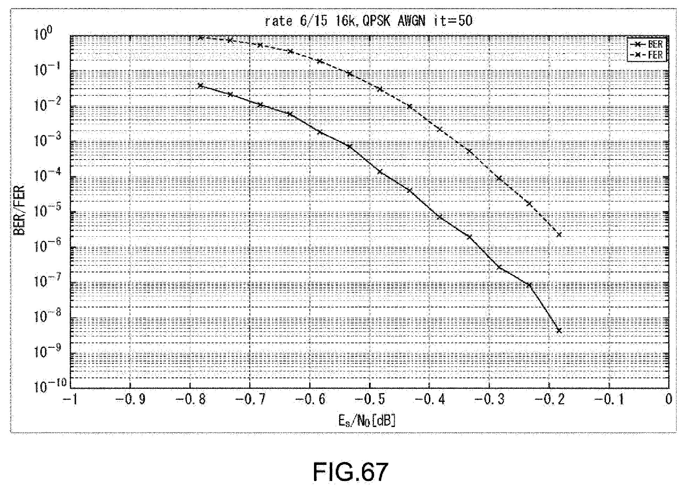

Fig. 67 is a view showing a simulation result of the BER/FER (bit error rate/frame error rate) of the first new LDPC code of (16k, 6/15) measured using the QPSK as the modulation scheme.

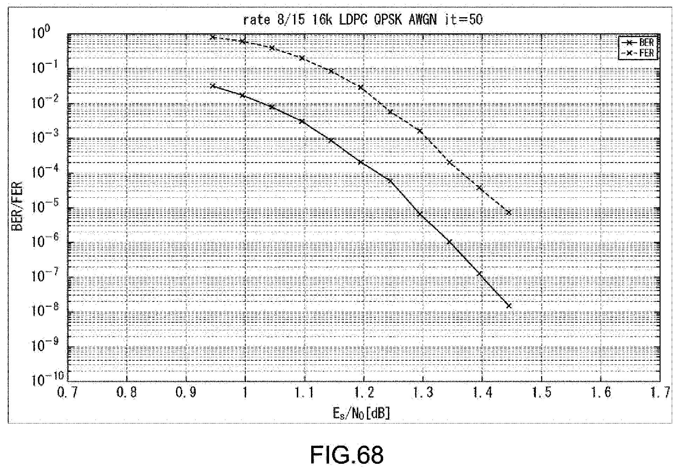

Fig. 68 is a view showing a simulation result of the BER/FER of the first new LDPC code of (16k, 8/15) measured using the QPSK as the modulation scheme.

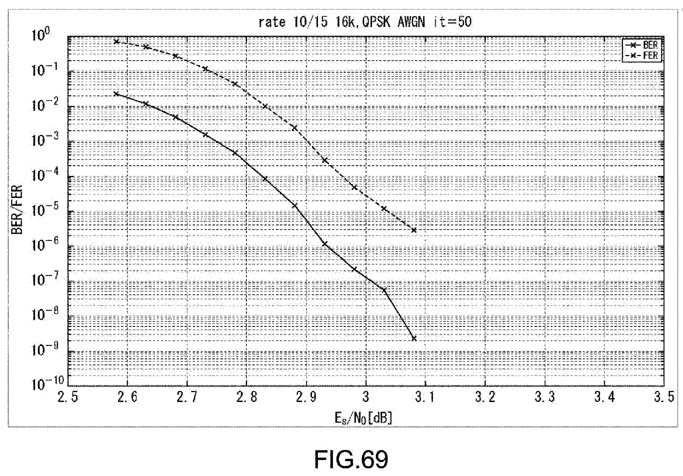

Fig. 69 is a view showing a simulation result of the BER/FER of the first new LDPC code of (16k, 10/15) measured using the QPSK as the modulation scheme.

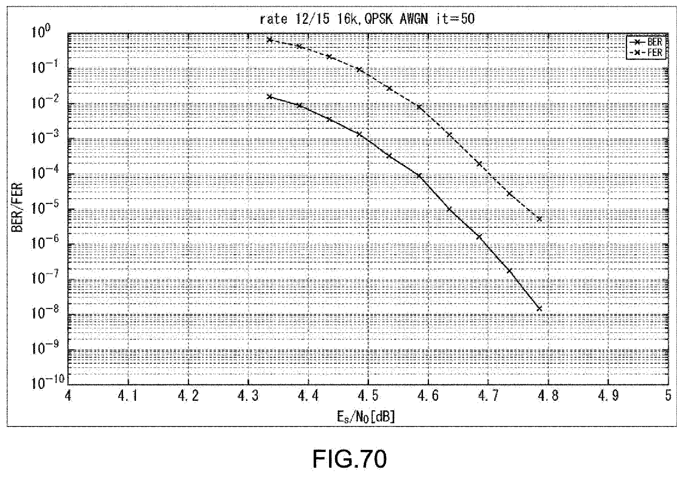

Fig. 70 is a view showing a simulation result of the BER/FER of the first new LDPC code of (16k, 12/15) measured using the QPSK as the modulation scheme.

In the simulation, the AWGN channel is supposed as the communication channel 13 (Fig. 7), and 50 times is adopted as the number of times of repetitive decoding C for decoding the LDPC code.

In Fig. 67 to Fig. 70, Es/No is plotted along the abscissa and the BER/FER is plotted along the ordinate. A solid line represents the BER, and a dotted line represents the FER.

According to Fig. 67 to Fig. 70, as for the first new LDPC codes of (16k, 6/15), (16k, 8/15), (16k, 10/15) and (16k, 12/15), excellent BER/FER are obtained. Accordingly, it can confirm that a good communication quality is ensured in the data transmission using the first new LDPC codes of (16k, 6/15), (16k, 8/15), (16k, 10/15) and (16k, 12/15).

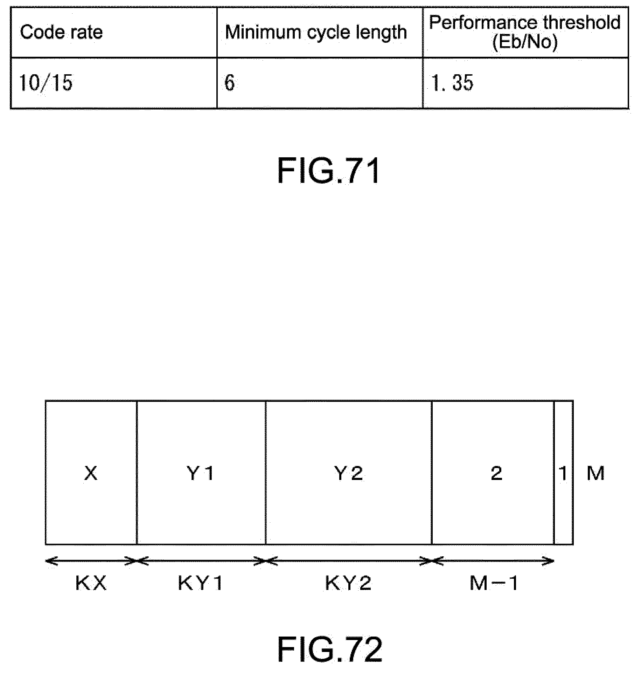

Fig. 71 is a view showing a minimum cycle length and a performance threshold of the parity check matrix H of the first new LDPC code of (16k, 10/15) shown in Fig. 38.

The parity check matrix H of the other first new LDPC code of (16k, 10/15) has no cycle-4.

The performance threshold of the first other new LDPC code of (16k, 10/15) is 1.35.

Fig. 72 is a view illustrating the parity check matrix H of the first other new LDPC code of (16k, 10/15) in Fig. 72.

The column weight is X for first to KX1-th columns of the parity check matrix H of the first other new LDPC code of (16k, 10/15), the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the first other new LDPC code of (16k, 10/15).

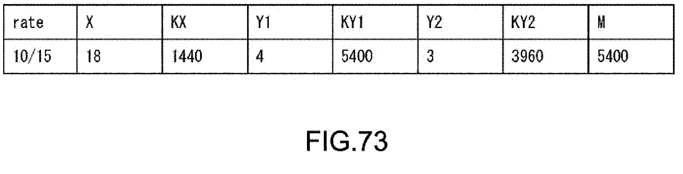

Fig. 73 is a view showing the numbers of columns KX, KY1, KY2, and M, and the column weights X1, X2, Y1, and Y2 in Fig. 72 for the code matrix H of the first other new LDPC code of (16k, 10/15).

As for the parity check matrix H of the first other new LDPC code of (16k, 10/15), as is the case with the parity check matrix illustrated in Figs. 12 and 13, the column weight of the column closer to the top (left) column tends to be larger, so that the code bit closer to the top code bit of the new LDPC code tends to be more tolerant to error.

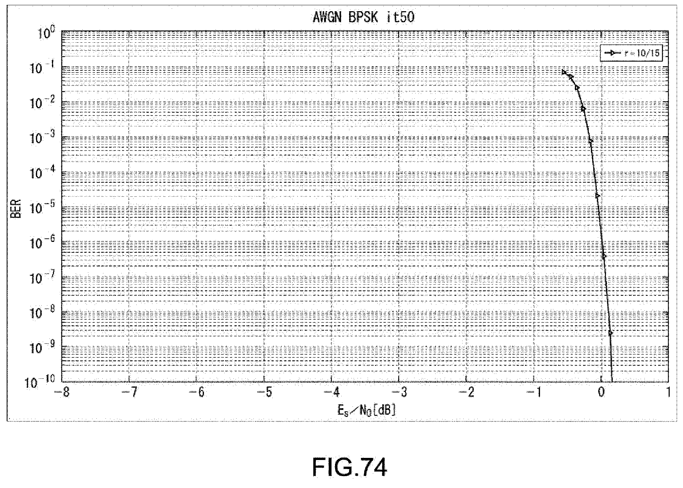

Fig. 74 is a view showing a simulation result of the BER of the first other new LDPC code of (16k, 10/15) measured using the BPSK as the modulation scheme.

In the simulation, the AWGN channel is supposed as the communication channel 13 (Fig. 7), and 50 times is adopted as the number of times of repetitive decoding C for decoding the LDPC code.

In Fig. 74, Es/No is plotted along the abscissa and the BER is plotted along the ordinate.

According to Fig. 74, as for the first other new LDPC code of (16k, 10/15), excellent BER is obtained. Accordingly, it can confirm that a good communication quality is ensured in the data transmission using the first other new LDPC code of (16k, 10/15).

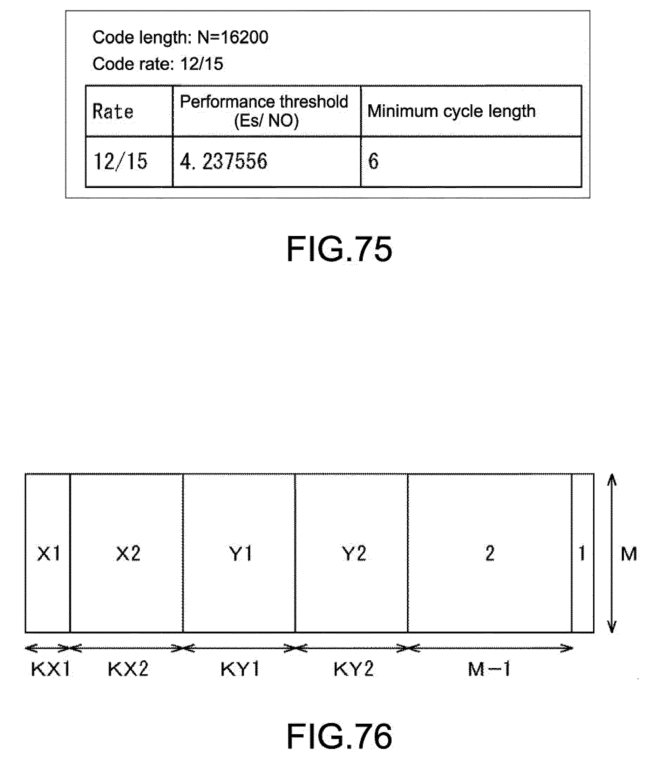

Fig. 75 is a view showing a minimum cycle length and a performance threshold of the parity check matrix H of the other first new LDPC code of (16k, 12/15) shown in Fig. 39.

The parity check matrices H of the first other new LDPC code of (16k, 12/15) has no cycle-4.

The performance threshold of the first other new LDPC code of (16k, 12/15) is 4.237556.

Fig. 76 is a view illustrating the parity check matrix H of the first other new LDPC code of (16k, 12/15) in Fig. 39.

The column weight is X1 for first to KX1-th columns of the parity check matrix H of the first other new LDPC code of (16k, 12/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the first other new LDPC code of (16k, 12/15).

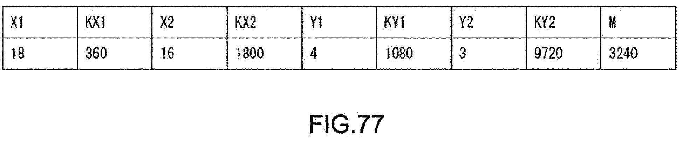

Fig. 77 is a view showing the numbers of columns KX1, KX2, KY1, KY2 and M, and the column weights X1, X2, Y1, and Y2 in Fig. 76 for the code matrix H of the first other new LDPC code of (16k, 12/15).

As for the parity check matrix H of the first other new LDPC code of (16k, 12/15), as is the case with the parity check matrix illustrated in Figs. 12 and 13, the column weight of the column closer to the top (left) column tends to be larger, so that the code bit closer to the top code bit of the new LDPC code tends to be more tolerant to error.

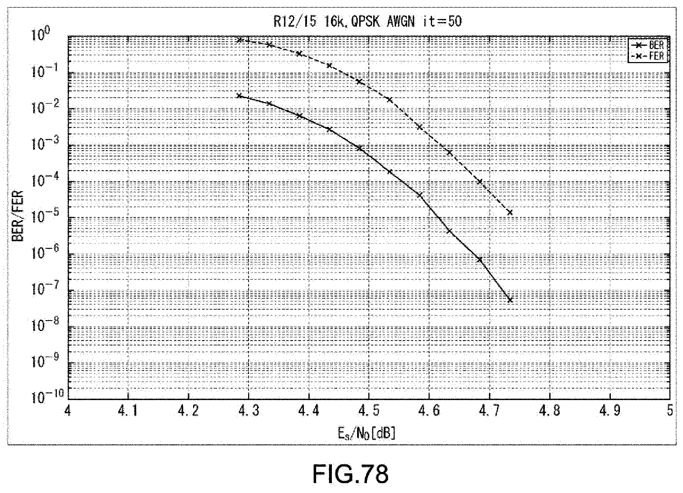

Fig. 78 is a view showing a simulation result of the BER/FER (bit error rate/frame error rate) of the first other new LDPC code of (16k, 12/15) measured using the QPSK as the modulation scheme.

In the simulation, the AWGN channel is supposed as the communication channel 13 (Fig. 7), and 50 times is adopted as the number of times of repetitive decoding C for decoding the LDPC code.

In Fig. 78, Es/No is plotted along the abscissa and the BER is plotted along the ordinate. A solid line represents the BER, and a dotted line represents the FER.

According to Fig. 78, as for the first other new LDPC code of (16k, 12/15), excellent BER/FER is obtained. Accordingly, it can confirm that a good communication quality is ensured in the data transmission using the first other new LDPC code of (16k, 12/15).

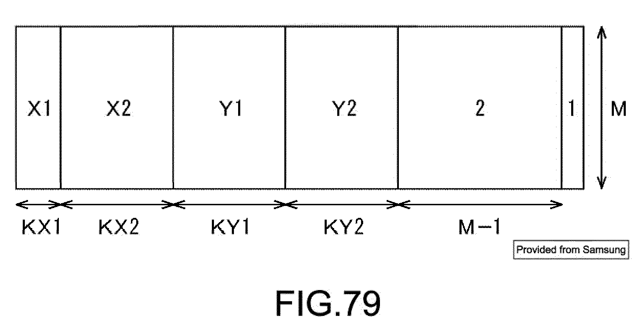

Fig. 79 is a view illustrating the parity check matrices H of the second new LDPC codes of (64k, 6/15), (64k, 8/15), (64k, 10/15) and (64k, 12/15) in Fig. 40 to Fig. 50.

The column weight is X1 for first to KX1-th columns of the parity check matrices H of the second new LDPC codes of (64k, 6/15), (64k, 8/15), (64k, 10/15) and (64k, 12/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 64800 bits of the second new LDPC codes of (64k, 6/15), (64k, 8/15), (64k, 10/15) and (64k, 12/15).

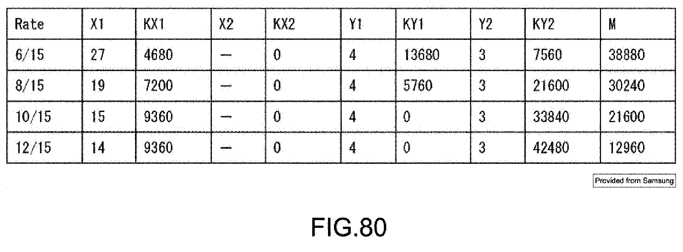

Fig. 80 is a view showing the numbers of columns KX1, KX2, KY1, KY2, and M, and the column weights X1, X2, Y1, and Y2 in Fig. 79 for the parity check matrices H of the second new LDPC codes of (64k, 6/15), (64k, 8/15), (64k, 10/15) and (64k, 12/15).

As for the parity check matrices H of the second new LDPC codes of (64k, 6/15), (64k, 8/15), (64k, 10/15) and (64k, 12/15), as is the case with the parity check matrix illustrated in Figs. 12 and 13, the column weight of the column closer to the top (left) column tends to be larger, so that the code bit closer to the top code bit of the new LDPC code tends to be more tolerant to error.

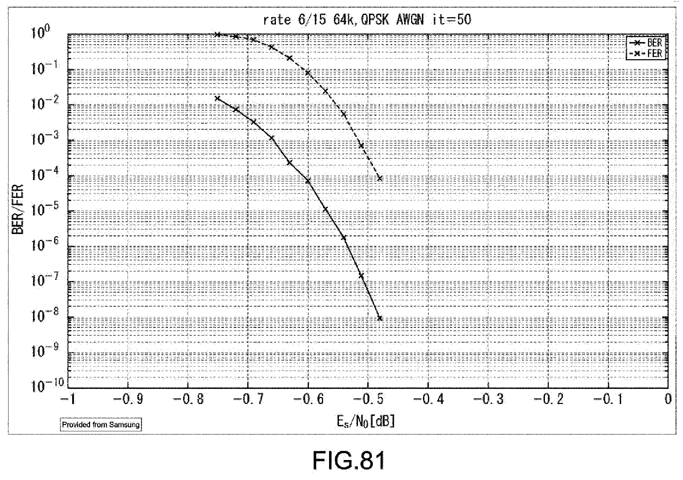

Fig. 81 is a view showing a simulation result of the BER/FER of the second new LDPC code of (64k, 6/15) measured using the QPSK as the modulation scheme.

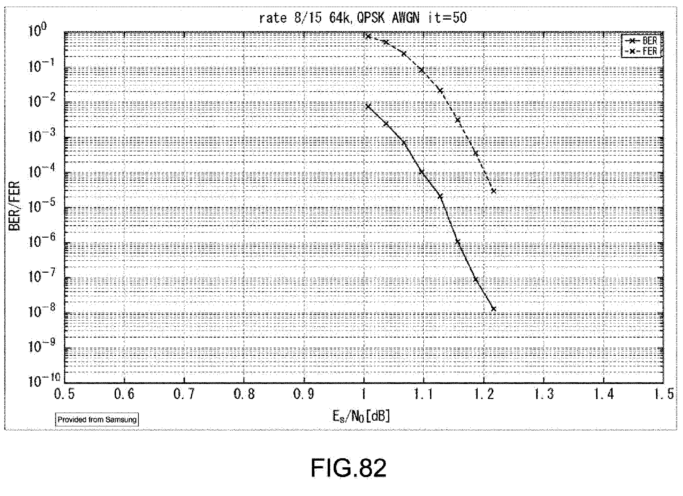

Fig. 82 is a view showing a simulation result of the BER/FER of the second new LDPC code of (64k, 8/15) measured using the QPSK as the modulation scheme.

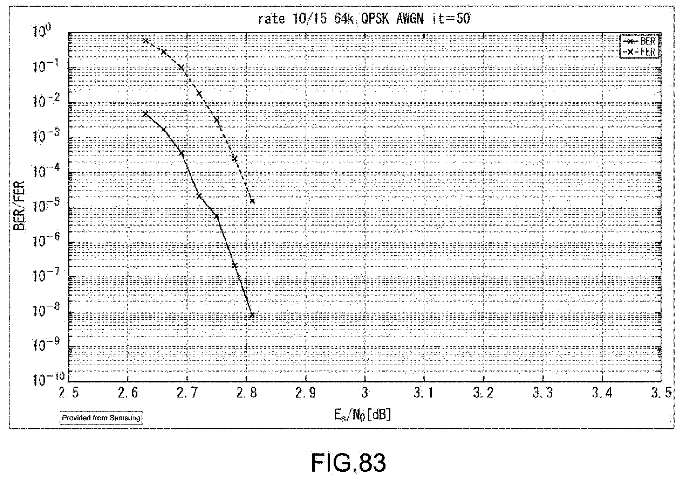

Fig. 83 is a view showing a simulation result of the BER/FER of the second new LDPC code of (64k, 10/15) measured using the QPSK as the modulation scheme.

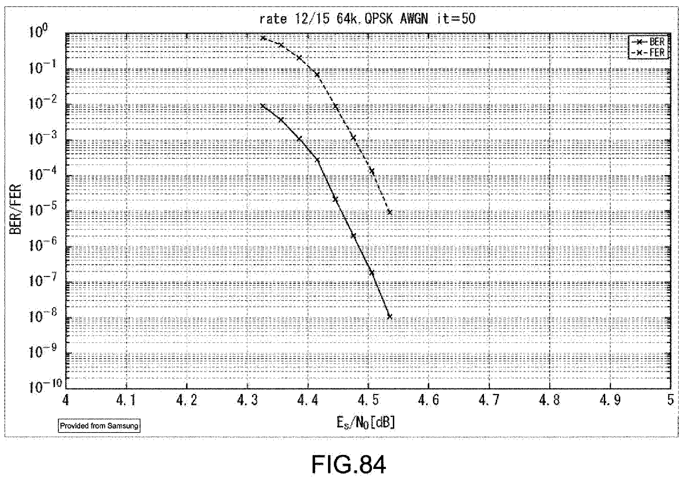

Fig. 84 is a view showing a simulation result of the BER/FER of the second new LDPC code of (64k, 12/15) measured using the QPSK as the modulation scheme.

In the simulation, the AWGN channel is supposed, and 50 times is adopted as the number of times of repetitive decoding C for decoding the LDPC code.

In Fig. 81 to Fig. 84, Es/No is plotted along the abscissa and the BER/FER is plotted along the ordinate. A solid line represents the BER, and a dotted line represents the FER.

According to Fig. 81 to Fig. 84, as for the second new LDPC codes of (64k, 6/15), (64k, 8/15), (64k, 10/15) and (64k, 12/15), excellent BER/FER are obtained. Accordingly, it can confirm that a good communication quality is ensured in the data transmission using the second new LDPC codes of (64k, 6/15), (64k, 8/15), (64k, 10/15) and (64k, 12/15).

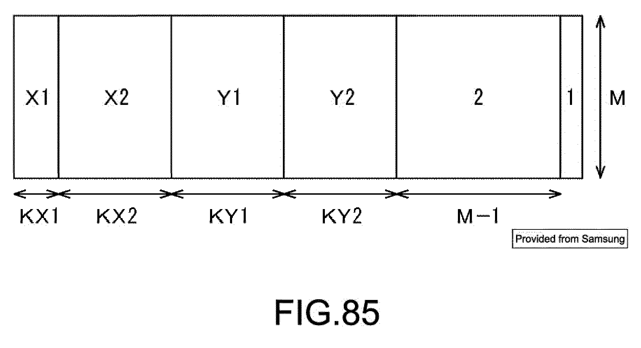

Fig. 85 is a view illustrating the parity check matrices H of the second new LDPC codes of (64k, 7/15), (64k, 9/15), (64k, 11/15) and (64k, 13/15) shown in Fig. 51 to Fig. 54.

The column weight is X1 for first to KX1-th columns of the parity check matrices H of the second new LDPC codes of (64k, 7/15), (64k, 9/15), (64k, 11/15) and (64k, 13/15), the column weight is X2 for next KY2 columns, the column weight is Y1 for next KY1 columns, the column weight is Y2 for next KY2 columns, the column weight is 2 for next M-1 columns, and the column weight is 1 for a last column, respectively.

Herein, KX1 + KX2 + KY1 + KY2 + M-1 + 1 is equal to the code length N = 16200 bits of the second new LDPC codes of (16k, 7/15), (16k, 9/15), (16k, 11/15) and (16k, 13/15).

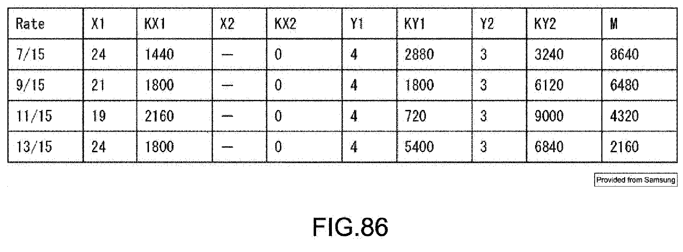

Fig. 86 is a view showing the numbers of columns KX1, KX2, KY1, KY2, and M, and the column weights X1, X2, Y1, and Y2 in Fig. 85 for the parity check matrices H of the second new LDPC codes of (16k, 7/15), (16k, 9/15), (16k, 11/15) and (16k, 13/15).

As for the parity check matrices H of the second new LDPC codes of (16k, 7/15), (16k, 9/15), (16k, 11/15) and (16k, 13/15), as is the case with the parity check matrix illustrated in Figs. 12 and 13, the column weight of the column closer to the top (left) column tends to be larger, so that the code bit closer to the top code bit of the new LDPC code tends to be more tolerant to error.

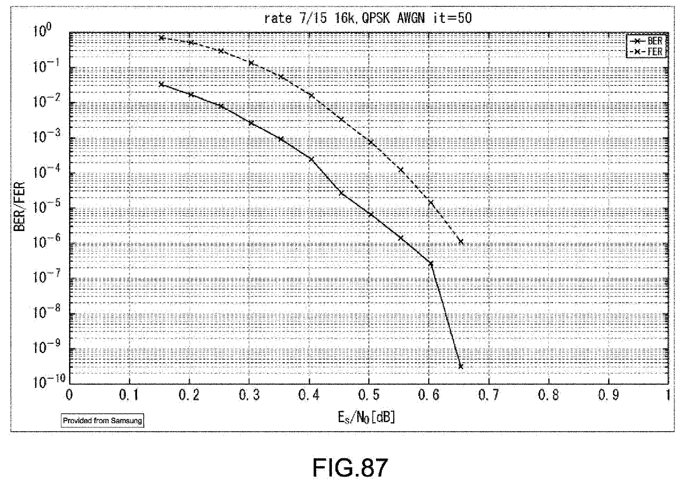

Fig. 87 is a view showing a simulation result of the BER/FER of the second new LDPC code of (16k, 7/15) measured using the QPSK as the modulation scheme.

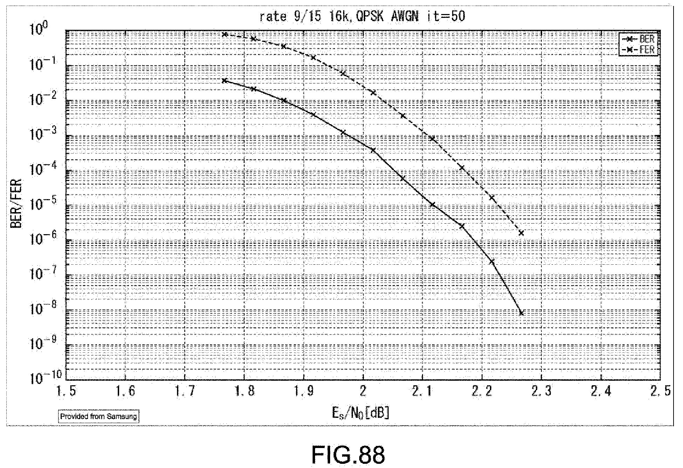

Fig. 88 is a view showing a simulation result of the BER/FER of the second new LDPC code of (16k, 9/15) measured using the QPSK as the modulation scheme.

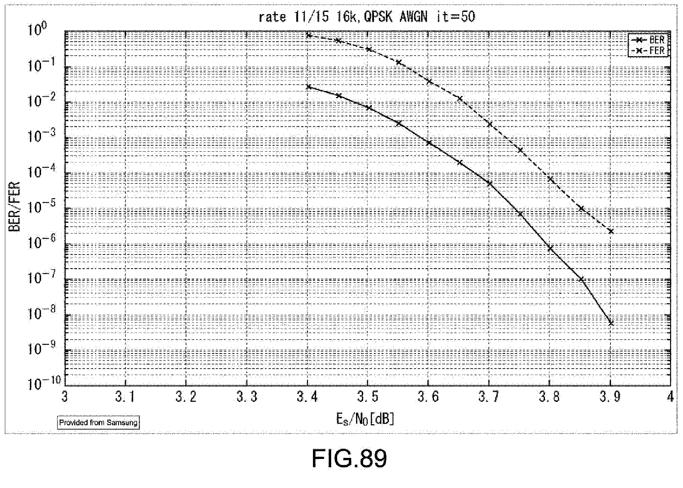

Fig. 89 is a view showing a simulation result of the BER/FER of the second new LDPC code of (16k, 11/15) measured using the QPSK as the modulation scheme.

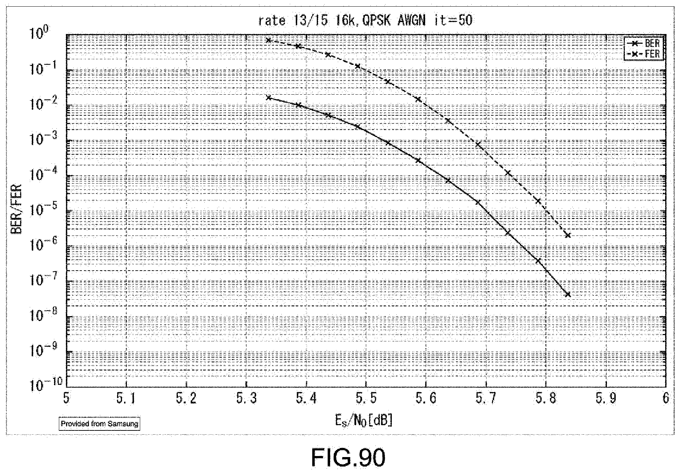

Fig. 90 is a view showing a simulation result of the BER/FER of the second new LDPC code of (16k, 13/15) measured using the QPSK as the modulation scheme.

In the simulation, the AWGN channel is supposed as the communication channel 13 (Fig. 7), and 50 times is adopted as the number of times of repetitive decoding C for decoding the LDPC code.

In Fig. 87 to Fig. 90, Es/No is plotted along the abscissa and the BER/FER is plotted along the ordinate. A solid line represents the BER, and a dotted line represents the FER.

According to Fig. 87 to Fig. 90, as for the second new LDPC codes of (16k, 7/15), (16k, 9/15), (16k, 11/15) and (16k, 13/15), excellent BER/FER are obtained. Accordingly, it can confirm that a good communication quality is ensured in the data transmission using the first new LDPC codes of (16k, 7/15), (16k, 9/15), (16k, 11/15) and (16k, 13/15).

Fig. 79 to Fig. 90 are data provided from Samsung.

### <Constellation>

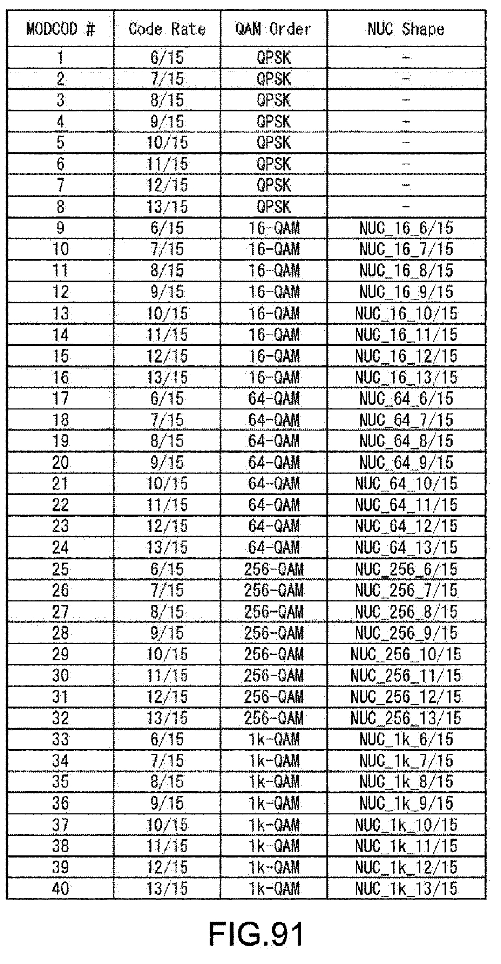

Fig. 91 is a diagram showing illustrative types of the constellation used in the transmission system in Fig. 7.

In the transmission system in Fig. 7, the constellation expected to be specified by ATSC3.0 may be used.

Fig. 91 shows illustrative types of the constellation expected to be used by ATSC3.0.

In the ATSC3.0, the constellation used in the MODCOD that is a combination of the modulation scheme and the LDPC code is set.

In the ATSC3.0, it is expected to use five modulation schemes, i.e., , QPSK, 16QAM, 64QAM, 256QAM and 1024QAM (1kQAM).

In the ATSC3.0, it is expected to use 16 types of the LDPC codes whose code rates r of eight types of 6/15, 7/15, 8/15, 9/15, 10/15, 11/15, 12/15 and 13/15 for each of two types of code lengths N of 16k bits and 64k bits.

In the ATSC3.0, 16 types of the LDPC codes are classified into 8 types (not depending on the code lengths N) by the code rates r, and it is expected that 40 (= 8 x 5) combinations of 8 types of the LDPC codes (each LDPC code whose code rate r is 6/15, 7/15, 8/15, 9/15, 10/15, 11/15, 12/15 or 13/15) and 5 types of the modulation schemes are used as a MODCOD capable of setting the constellation.

Accordingly, in the ATSC3.0, the MODCOD represents the combination of the 8 types of the code rates r of the LDPC codes and 5 types of the modulation schemes.

In Fig. 91, "NUC_16_6/15" described in the column "NUC Shape" represents the constellation used in the MODCOD corresponding to the row of the column "NUC Shape".

Herein, for example, the "NUC_16_6/15" represents the constellation used in the MODCOD where the modulation scheme is 16QAM and code rate r is the LDPC code is 6/15.

As shown in Fig. 91, if the modulation scheme is QPSK, the same constellation is used for the 8 types of the code rates r of the LDPC code.

Also as shown in Fig. 91, if the modulation scheme is 16QAM, 64QAM, 256QAM or 1024QAM, different constellations are used for the 8 types of the code rates r of the LDPC code.

Accordingly, in the ATSC3.0, one constellation is prepared for QPSK, and eight constellations are prepared each for 16QAM, 64QAM, 256QAM and 1024QAM.

There are a UC (Uniform Constellation) where a constellation of signal points is uniform and a NUC (Non Uniform Constellation) where a constellation is not uniform.

Also, there are constellations called as 1D NUC (1-dimensional M² - QAM non-uniform constellation), 2D NUC (2-dimensional QQAM non-uniform constellation) and the like.

As the constellation of QPSK, UC is used. As the constellations of 16QAM, 64QAM and 256QAM, 2D NUC is used, for example. As the constellations of 1024QAM, 1D NUC is used, for example.

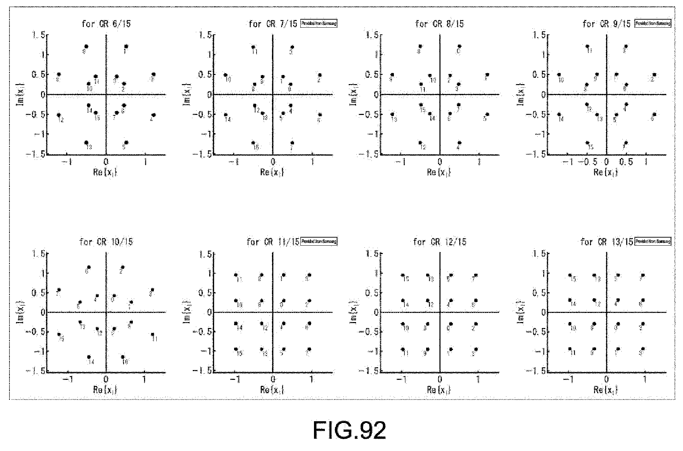

Fig. 92 is a diagram showing an example of the constellation for the eight code rates r of the LDPC code when the modulation scheme is 16QAM.

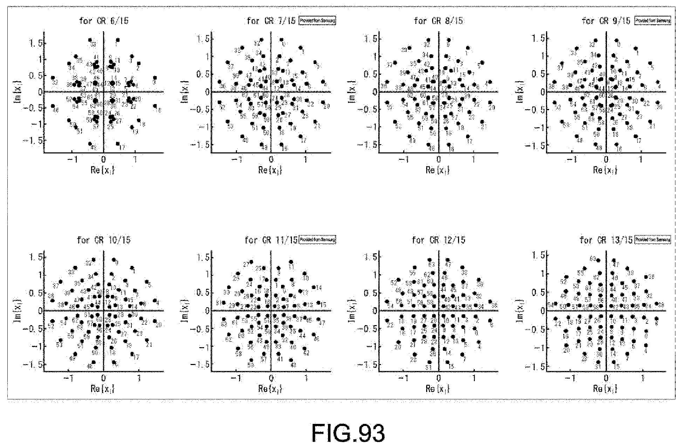

Fig. 93 is a diagram showing an example of the constellation for the eight code rates r of the LDPC code when the modulation scheme is 64QAM.

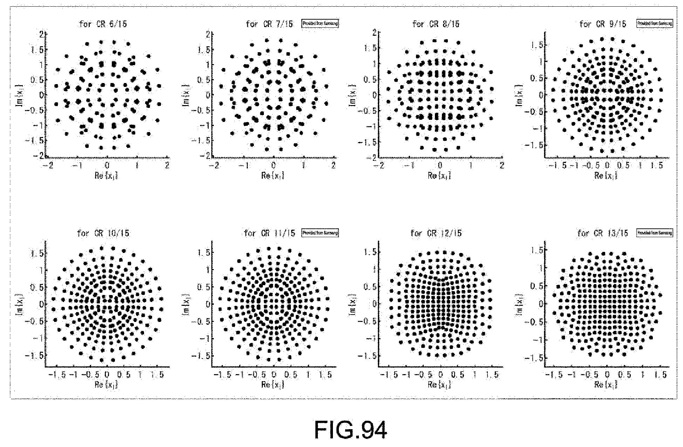

Fig. 94 is a diagram showing an example of the constellation for the eight code rates r of the LDPC code when the modulation scheme is 256QAM.

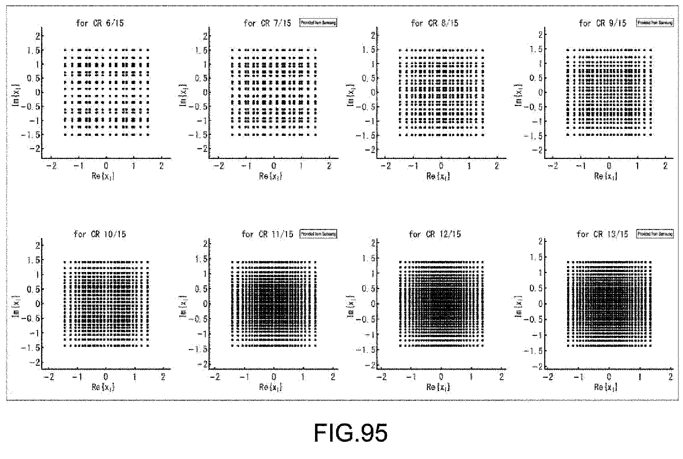

Fig. 95 is a diagram showing an example of the constellation for the eight code rates r of the LDPC code when the modulation scheme is 1024QAM.

In Fig. 92 to Fig. 95, each abscissa and each ordinate are an I axis and a Q axis, Re{xl} and Im{xl} represent a real part and an imaginary part of a signal point xl as a coordinates of the signal point xl.

In Fig. 92 to Fig. 95, the numerical values followed by "for CR" represent the code rates r of the LDPC code.

The constellations where the code rates r of the LDPC code are 7/15, 9/15, 11/15 and 13/15 are based on the data provided from Samsung.

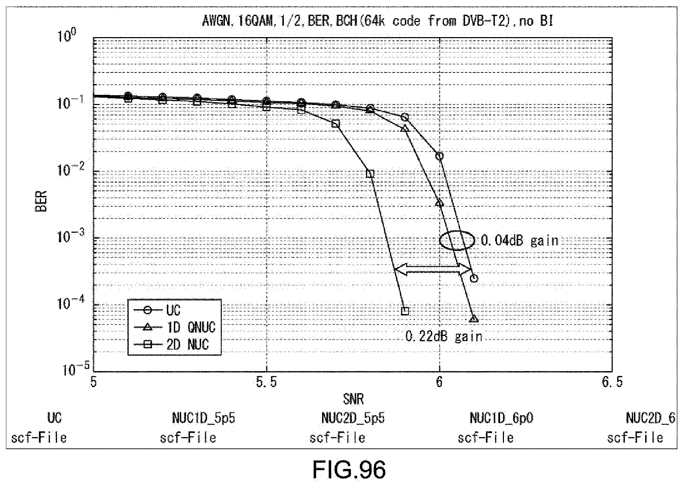

Fig. 96 is a view showing a simulation result of measurement of BER when UC, 1D NUC or 2D NUC is used as the constellation in the case of the modulation scheme of 16QAM.

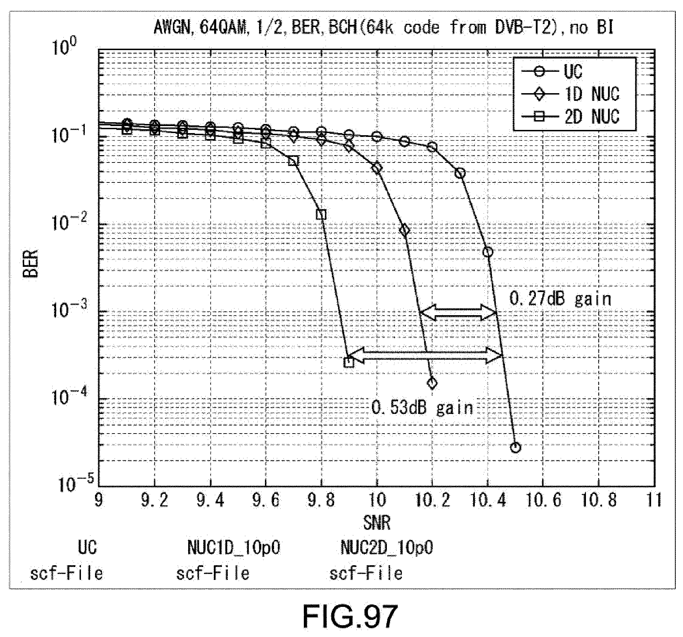

Fig. 97 is a view showing a simulation result of measurement of BER when UC, 1D NUC or 2D NUC is used as the constellation in the case of the modulation scheme of 64QAM.

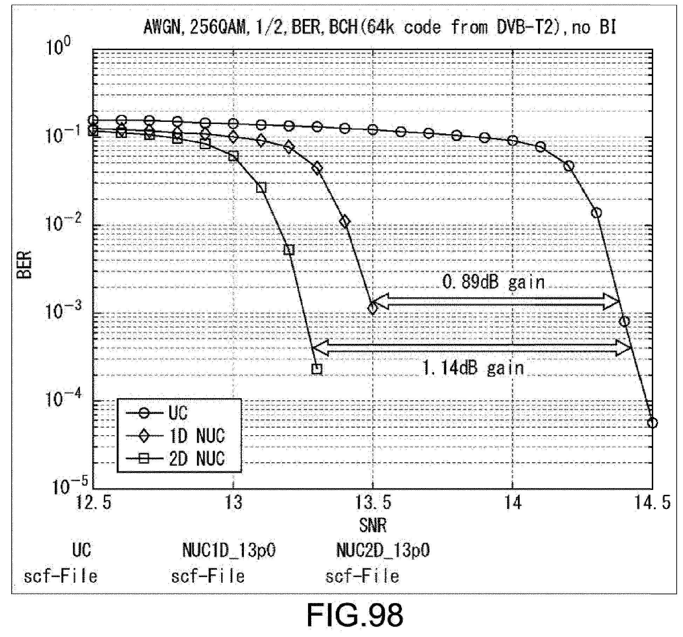

Fig. 98 is a view showing a simulation result of measurement of BER when UC, 1D NUC or 2D NUC is used as the constellation in the case of the modulation scheme of 256QAM.

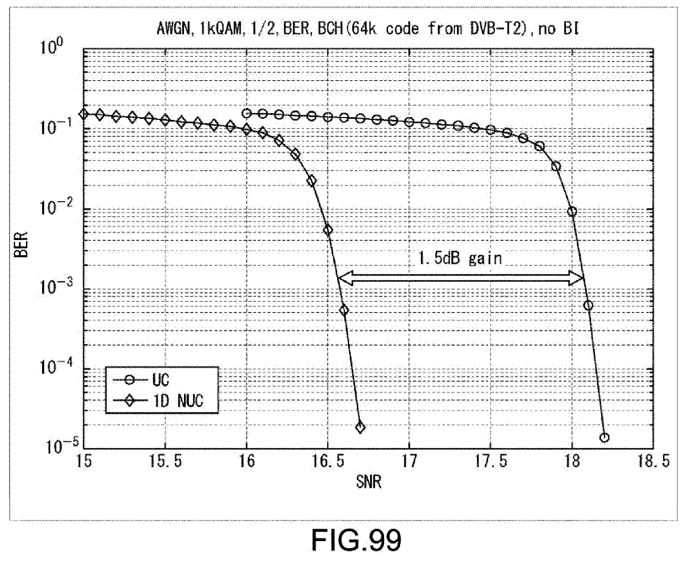

Fig. 99 is a view showing a simulation result of measurement of BER when UC, 1D NUC or 2D NUC is used as the constellation in the case of the modulation scheme of 1024QAM.

In Fig. 96 to Fig. 99, SNR (Signal to Noise Ratio) is plotted along the abscissa and the BER is plotted along the ordinate.

If the modulation scheme is 16QAM, 64QAM or 256QAM, as shown in Fig. 96 to Fig. 98, it can confirm that the BER is much improved by 1D NUC than by UC, and that the BER is further much improved by 2D NUC than by 1D NUC.

If the modulation scheme is 1024QAM, as shown in Fig. 99, it can confirm that the BER is much improved by 1D NUC than by UC.

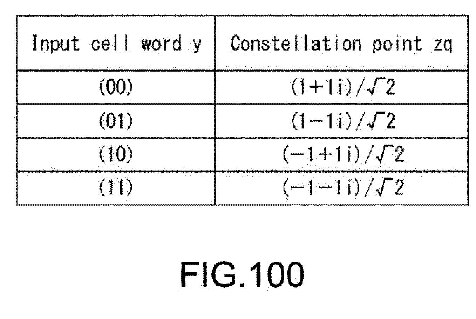

Fig. 100 is a diagram showing coordinates of the signal points of UC commonly used for eight code rates r (= 6/15, 7/15, 8/15, 9/15, 10/15, 11/15, 12, 15 and 13/15) of the LDPC code when the modulation scheme is QPSK.

In Fig. 100, "Input cell word y" represents 2-bit symbol of mapping by UC of the QPSK, and "Constellation point z_{q}" represents a coordinate of a signal point z_{q}. The index q of the signal point z_{q} represents a discrete-time of symbols (a time interval between one symbol and the next symbol).

In Fig. 100, the coordinates of the signal point z_{q} are represented by a complex number, and i represents the imaginary unit $\left(\sqrt{\left(-1\right)}\right) .$

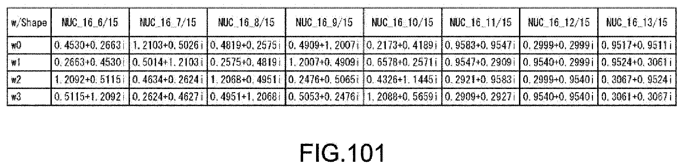

Fig. 101 is a diagram showing coordinates of the signal points of 2D NUC commonly used for eight code rates r of the LDPC code when the modulation scheme is 16QAM.

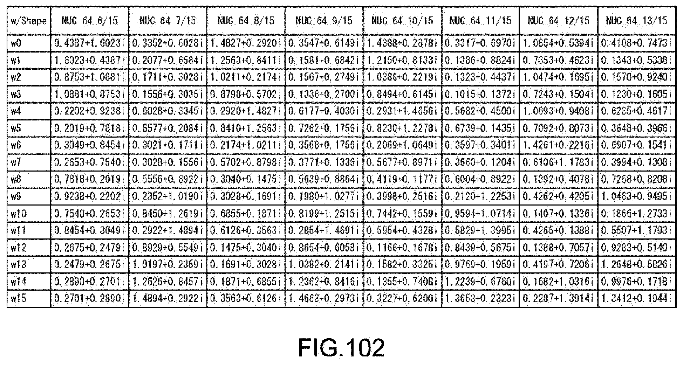

Fig. 102 is a diagram showing coordinates of the signal points of 2D NUC commonly used for eight code rates r of the LDPC code when the modulation scheme is 64QAM.

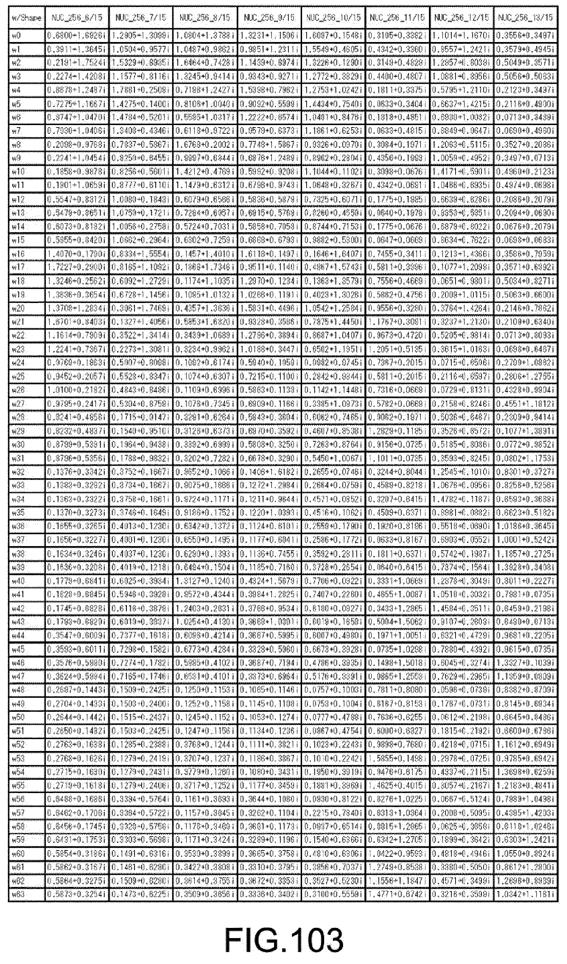

Fig. 103 is a diagram showing coordinates of the signal points of 2D NUC commonly used for eight code rates r of the LDPC code when the modulation scheme is 256QAM.

In Fig. 101 to Fig. 103, NUC_2^{m}_r represents a coordinate of a signal point of 2D NUC used if the modulation method is 2^{m}QAM and the code rate of the LDPC code is r.

In Fig. 101 to Fig. 103, as in Fig. 100, the coordinate of the signal point z_{q} is represented by a complex number, and i represents the imaginary unit.

In Fig. 101 to Fig. 103, w#k represents a coordinate of a signal point in a first quadrant of the constellation.

In 2D NUC, a signal point of a second quadrant of the constellation is arranged at a position where the signal point of the first quadrant is moved symmetrically with respect to the Q axis, and a signal point of a third quadrant of the constellation is arranged at a position where the signal point of the first quadrant is moved symmetrically with respect to the origin. A signal point of a fourth quadrant of the constellation is arranged at a position where the signal point of the first quadrant is moved symmetrically with respect to the I axis.

Herein, if the modulation scheme is 2^{m} QAM, m bits are taken as one symbol, and one symbol is mapped to signal points corresponding to the symbol.

The symbol of the m bit symbol is represented, for example, by 0 to 2^{m}-1 integer values. If b = 2^{m}/4, the symbols y(0), y(1), ···, y (2m-1) represented by 0 to 2^{m}-1 integer values may be classified into four: symbols y(0) to y(b-1), y(b) to y(2b-1), y(2b) to y(3b-1) and y(3b) to (4b-1).

In Fig. 101 to Fig. 103, the suffix k of w#k represents an integer value of 0 to b-1, and w#k represents the coordinate of the signal point corresponding to the symbol y(k) from the symbols y(0) to y(b-1).

The coordinate of the signal point corresponding to the symbol y(k+b) from the symbols y(b) to y(2b-1) is represented by -conj(w#k). The coordinate of the signal point corresponding to the symbol y(k+2b) from the symbols y(2b) to y(3b-1) is represented by conj(w#k). The coordinate of the signal point corresponding to the symbol y(k+3b) from the symbols y(3b) to y(4b-1) is represented by conj(w#k).

The conj(w#k) represents a complex conjugate of w#k.

For example, if the modulation scheme is 16QAM, m = 4 bit symbols; y(0), y(1), ···, y(15) are classified into four; symbols y(0) to y(3), y(4) to y(7), y(8) to y(11) and y(12) to y(15) as b = 2⁴/4/4 = 4.

For example, as the symbol y(12) from the symbols y(0) to y(15) is a symbol y(k+3b)y(0+3x4) from the symbols y(3b) to y(4b-1) and k = 0, the coordinate of the signal point corresponding to the symbol y(12) will be -w#k = -w0.

If the code rate r of the LDPC code, for example, is 9/15, according to Fig. 101, w0 of (NUC_16_9/15) where the modulation scheme is 16QAM and the code rate r is 9/15 is 0.4909 + 1.2007i. So, a coordinate -w0 of the signal point corresponding to the symbol y(12) is -(0.4909 + 1.2007i).

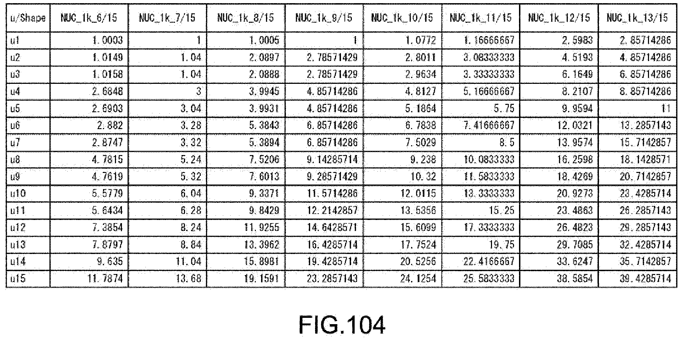

Fig. 104 is a diagram showing coordinates of the signal points of 1D NUC used for eight code rates r of the LDPC code when the modulation scheme is 1024QAM.

In Fig. 104, the columns of NUC_1k_r represent values of u#k of the coordinates of the signal points of 1D NUC used when the modulation scheme is 1024QAM and the code rate of the LDPC code is r.

u#k represents a real part Re(z_{q}) and an imaginary part Im(z_{q}) of the complex number as a coordinate of the signal point z_{q} of 1D NUC.

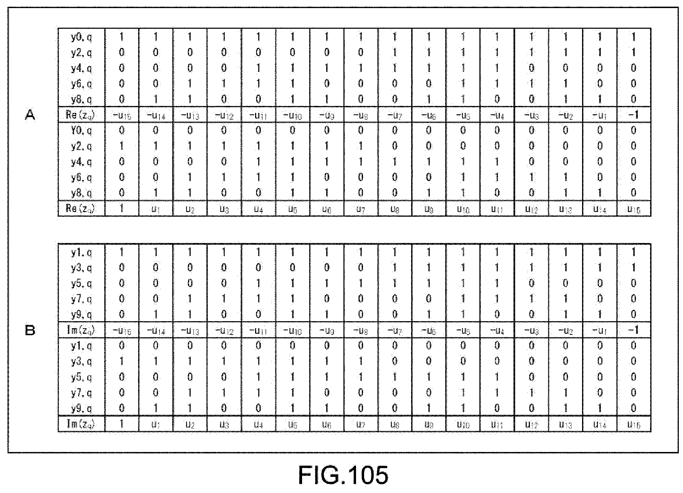

Fig. 105 is a diagram showing a relationship between the real part Re(z_{q}) and the imaginary part Im(z_{q}) of the complex number as the coordinate of the signal point z_{q} of 1D NUC corresponding to the symbol y.

The 10-bit symbol y of 1024QAM is represented by y₀, _{q}, y₁, _{q}, y₂, _{q}, y₃, _{q}, y₄, _{q}, y₅, _{q}, y₆, _{q}, y₇, _{q}, y₈, _{q} and y₉, _{q} fro the head bit (Most Significant Bit).

Fig. 105A represents a corresponding relationship between odd numbered 5-bit symbol y; y₀, _{q}, y₂, _{q}, y₄, _{q}, y₆, _{q} and y₈, _{q} and the u#k representing the real part Re(z_{q}) of (the coordinate) of the signal point z_{q} corresponding to the symbol y.

Fig. 105B represents a corresponding relationship between even numbered 5-bit symbol y; y₁, _{q}, y₃, _{q}, y₅, _{q}, y₇, _{q} and y₉, _{q} and the u#k representing the imaginary part Im(z_{q}) of (the coordinate) of the signal point z_{q} corresponding to the symbol y.

If the 10-bit symbol y = (y₀, _{q}, y₁, _{q}, y₂, _{q}, y₃, _{q}, y_{4, q}, y₅, _{q}, y_{6, q}, y₇, _{q}, y₈, _{q} and y₉, _{q}) of 1024QAM is, for example, (0, 0, 1, 0, 0, 1, 1, 1, 0, 0), odd-numbered 5 bits (y₀, _{q}, y₂, _{q}, y₄, _{q}, y₆, _{q} and y₈, _{q}) are (0, 1, 0, 1, 0) and the even-numbered 5 bits (y₁, _{q}, y₃, _{q}, y₅, _{q}, y₇, q and y₉, _{q}) are (0, 0, 1, 1, 0).

In Fig. 105A, the odd-numbered 5 bits (0, 1, 0, 1, 0) are correlated with u3, and therefore, the real part Re(z_{q}) of the signal point z_{q} corresponding to the symbol y = (0, 0, 1, 0, 0, 1, 1, 1, 0, 0) is u3.

In Fig. 105B, the even-numbered 5 bits (0, 1, 0, 1, 0) are correlated with u11, and therefore, the imaginary part Im(z_{q}) of the signal point z_{q} corresponding to the symbol y = (0, 0, 1, 0, 0, 1, 1, 1, 0, 0) is u11.

If the code rate r of the LDPC code, for example, is 7/15, according to Fig. 104 as described above, as to 1D NUC (NUC_1k_7/15) where the modulation scheme is 1024QAM and code rate r is the LDPC coding is 7/15, u3 is 1.04 and u11 is 6.28.

Accordingly, in the real part Re(z_{q}) of the signal point z_{q} corresponding to the symbol y = (0, 0, 1, 0, 0, 1, 1, 1, 0, 0), u3 = 1.04, in Im(z_{q}), u11 = 6.28. As a result, the coordinate of the signal point z_{q} corresponding to the symbol y = (0, 0, 1, 0, 0, 1, 1, 1, 0, 0) is represented by 1.04 + 6.28i.

The signal points of 1D NUC are arranged in a matrix on a straight line parallel to the I axis or a straight line parallel to the Q-axis. However, spaces between signal points are not constant. Upon transmission of (data mapped to) the signal points, the average power of the signal points on the constellation is normalized. Normalization is performed by multiplying each signal point z_{q} on the constellation by a reciprocal $1 / \left(\sqrt{{P}_{ave}}\right)$ of a square root $\sqrt{{P}_{ave}}$ of a root mean square value Pₐᵥₑ, where the root mean square of absolute values of (coordinates of) all signal points on the constellation is represented by Pₐᵥₑ.

By the constellations illustrated in Fig. 92 to Fig. 105, it can confirm that good error rates are obtained.

### <Block interleaver 25>

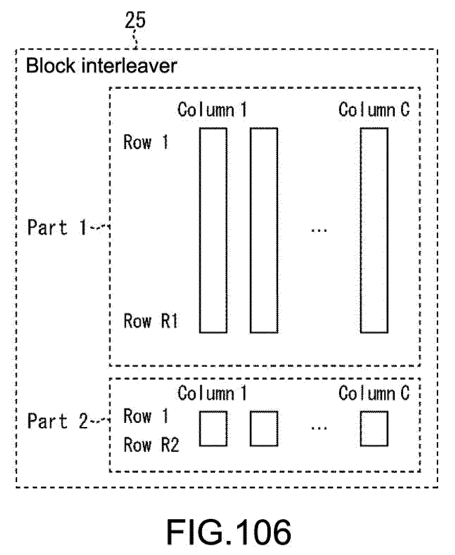

Fig. 106 is a block diagram showing a configuration example of a block interleaver 25 in Fig. 9.

The block interleaver 25 has a storage region called as Part 1 and a storage region called as Part 2.

The Parts 1 and 2 store one bit in a row (horizontal) direction. The number C of columns that are the storage regions for storing the predetermined number of bits in a column (vertical) direction are arranged. The number C is equal to the number of bits m of the symbols.

When the number of bits that are stored by the part 1 columns in the column direction (hereinafter, also referred to as a part-column length) is expressed as R1, and the part column length of the part 2 columns is expressed as R2, (R1 + R2) x C equals to the code length N of the target of the LDPC code to be block-interleaved (in the present embodiment, 64800 bits, or 16200 bits).

In addition, a part column length R1 is equal to a multiple of 360 bits that are the number of columns P being the unit of the cyclic structure. A part column length R2 is equal to a remainder when the sum of the part column length R1 of the part 1 and the part column length R2 of the part 2 (hereinafter also referred to as a column length) R1 + R2 is divided by 360 bits that are the number of columns P being the unit of the cyclic structure.

Here, the column length R1 + R2 is equal to a value when the code length N of the LDPC code to be block-interleaved is divided by the bit number m of symbols.

For example, concerning the LDPC code whose code length N is 16200 bits, if 16QAM is used as the modulation method, the bit number m of symbols is four bits, and the column length R1 + R2 will be 4050 (= 16200/4) bits.

Furthermore, as the remainder when the column length R1 + R2 = 4050 is divided by 360 bits that are the number of columns P being the unit of the cyclic structure is 90, the part column length R2 will be 90 bits.

The part column length R1 of the part 1 will be R1 + R2 - R2 = 4050-90 = 3960 bits.

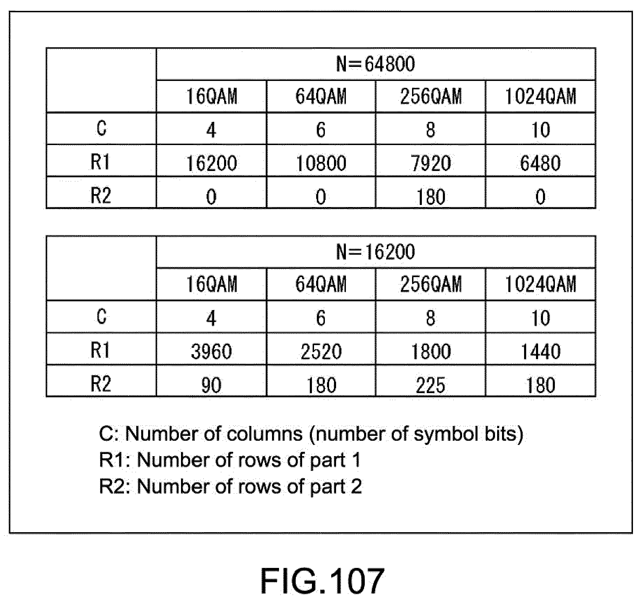

Fig. 107 is a diagram showing the column number C of the parts 1 and 2 for a combination of the code length N and the modulation scheme and the part column lengths (row numbers) R1 and R2.

Fig. 107 shows the column number C of the parts 1 and 2 and the part column lengths R1 and R2 for a combination of the code length N of the LDPC code being 16200 bits and 64800 bits and the modulation schemes of 16QAM, 64QAM, 256QAM, and 1024QAM.

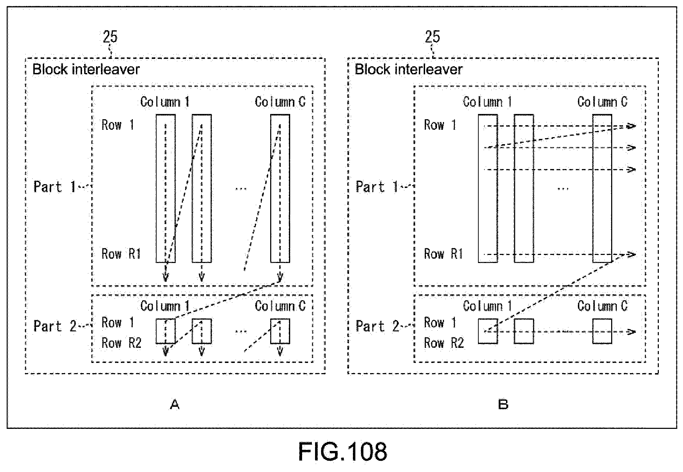

Fig. 108 is a diagram for illustrating a block interleave performed in the block interleaver 25.

The block interleaver 25 preforms the block interleave to the parts 1 and 2 by writing and reading the LDPC code.

In other words, in the block interleave, as shown in Fig. 108A, the code bits of the LDPC code of one code word are written from a top to down direction (column direction) of the part 1 columns and from left to right directions of the columns.

When writing of the code bits to the bottom of the right-most column of the part 1 columns (C-th column) is finished, the rest of the code bits is written from a top to down direction (column direction) of the part 2 columns and from left to right directions of the columns.

After that, when the writing of the code bits to the bottom of the right-most column of the part 2 columns (C-th column) is finished, as shown in Fig. 108B, the code bits are read in a C = m bit unit in the row direction from all first columns of the number C of the part 1.

The code bits for all columns of the number C of the part 1 are read sequentially to the lower rows. When the reading is finished for the last R1th row, the code bits are read in a C = m bit unit in the row direction from all first columns of the number C of the part 2.

The code bits for all columns of the number C of the part 2 are read sequentially to the lower rows for the last R2th row.

As described above, the code bits read from the parts 1 and 2 for m-bit unit are supplied to the mapper 117 (Fig. 8) as the symbols.

### <Group-wise interleave>

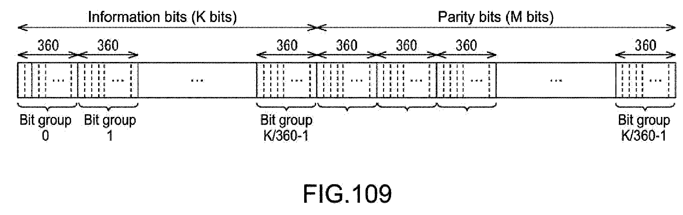

Fig. 109 is a diagram for illustrating group-wise interleave performed in the group-wise interleaver 24 in Fig. 9.

In the group-wise interleave, the LDPC code for one code word is divided into a 360-bit unit equal to the number of columns P being the unit of the cyclic structure from the beginning. One division, i.e., 360-bit, is considered as a bit group. The LDPC code of one code word is interleaved in a bit group unit according to a predetermined pattern (hereinafter also referred to as a GW pattern).

Here, the i + 1th bit group from the beginning at the time of dividing the one code word of the LDPC code to the bit group is hereinafter also described as a bit group i.

For example, the LDPC code whose code length N of 1800 bits is divided into 5 (= 1800/360) bit groups: 0, 1, 2, 3, 4. Further, for example, the LDPC codes whose code length N of 16200 bits is divided into 45 (= 16200/360) bit groups: 0, 1, ..., 44. The LDPC whose code length N of 64800 bits is divided into 180 (= 64800/360) bit groups: 0, 1, ..., 179.

In the following, the GW pattern will be represented by a sequence of numbers representing the bit groups. For example, for the LDPC code whose code length N of 1800 bits, the GW pattern 4, 2, 0, 3, 1 represents that a sequence of the bit groups 0, 1, 2, 3, 4, is interleaved (changed) to a sequence of the bit groups 4, 2, 0, 3, 1.

The GW pattern can be set for, at least, each code length N of the LDPC code.

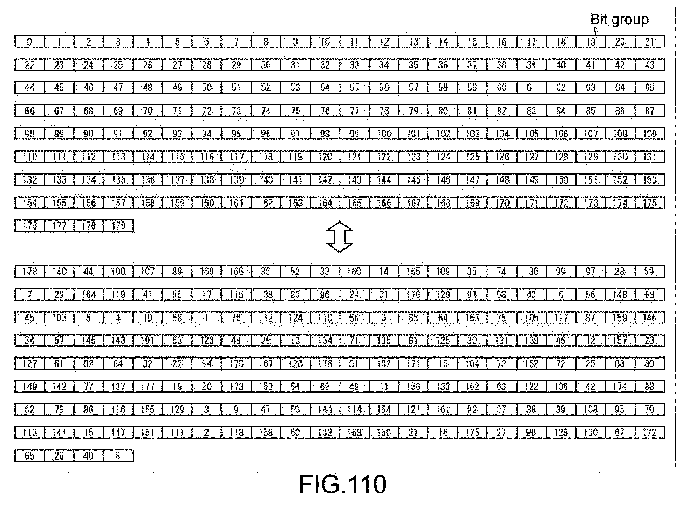

Fig. 110 is a diagram showing a first example of a GW pattern for the LDPC code whose code length N of 64k bits.

According to the GW pattern in Fig. 110, a sequence of the bit groups 0 to 179 having the LDPC code of 64k bits is interleaved to a sequence of a bit group of
178, 140, 44, 100, 107, 89, 169, 166, 36, 52, 33, 160, 14, 165, 109, 35, 74, 136, 99, 97, 28, 59, 7, 29, 164, 119, 41, 55, 17, 115, 138, 93, 96, 24, 31, 179, 120, 91, 98, 43, 6, 56, 148, 68, 45, 103, 5, 4, 10, 58, 1, 76, 112, 124, 110, 66, 0, 85, 64, 163, 75, 105, 117, 87, 159, 146, 34, 57, 145, 143, 101, 53, 123, 48, 79, 13, 134, 71, 135, 81, 125, 30, 131, 139, 46, 12, 157, 23, 127, 61, 82, 84, 32, 22, 94, 170, 167, 126, 176, 51, 102, 171, 18, 104, 73, 152, 72, 25, 83, 80, 149, 142, 77, 137, 177, 19, 20, 173, 153, 54, 69, 49, 11, 156, 133, 162, 63, 122, 106, 42, 174, 88, 62, 78, 86, 116, 155, 129, 3, 9, 47, 50, 144, 114, 154, 121, 161, 92, 37, 38, 39, 108, 95, 70, 113, 141, 15, 147, 151, 111, 2, 118, 158, 60, 132, 168, 150, 21, 16, 175, 27, 90, 128, 130, 67, 172, 65, 26, 40, 8.

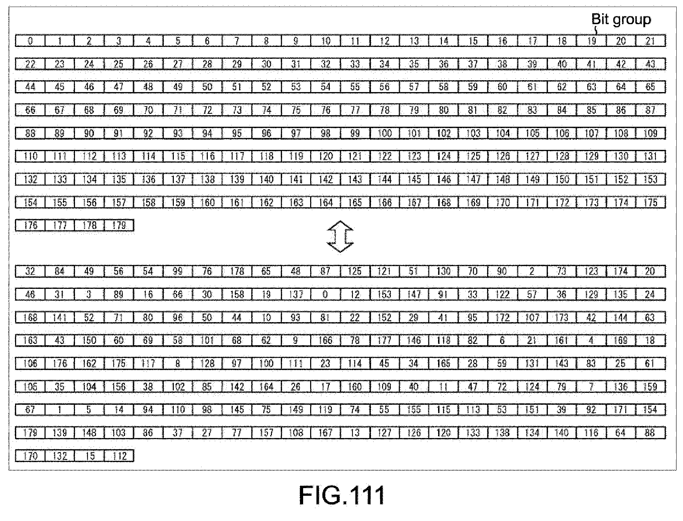

Fig. 111 is a diagram showing a second example of the GW pattern for the LDPC code whose code length N of 64k bits.

According to the GW pattern in Fig. 111, a sequence of the bit groups 0 to 179 having the LDPC code of 64k bits is interleaved to a sequence of a bit group of
32, 84, 49, 56, 54, 99, 76, 178, 65, 48, 87, 125, 121, 51, 130, 70, 90, 2, 73, 123, 174, 20, 46, 31, 3, 89, 16, 66, 30, 158, 19, 137, 0, 12, 153, 147, 91, 33, 122, 57, 36, 129, 135, 24, 168, 141, 52, 71, 80, 96, 50, 44, 10, 93, 81, 22, 152, 29, 41, 95, 172, 107, 173, 42, 144, 63, 163, 43, 150, 60, 69, 58, 101, 68, 62, 9, 166, 78, 177, 146, 118, 82, 6, 21, 161, 4, 169, 18, 106, 176, 162, 175, 117, 8, 128, 97, 100, 111, 23, 114, 45, 34, 165, 28, 59, 131, 143, 83, 25, 61, 105, 35, 104, 156, 38, 102, 85, 142, 164, 26, 17, 160, 109, 40, 11, 47, 72, 124, 79, 7, 136, 159, 67, 1, 5, 14, 94, 110, 98, 145, 75, 149, 119, 74, 55, 155, 115, 113, 53, 151, 39, 92, 171, 154, 179, 139, 148, 103, 86, 37, 27, 77, 157, 108, 167, 13, 127, 126, 120, 133, 138, 134, 140, 116, 64, 88, 170, 132, 15, 112.

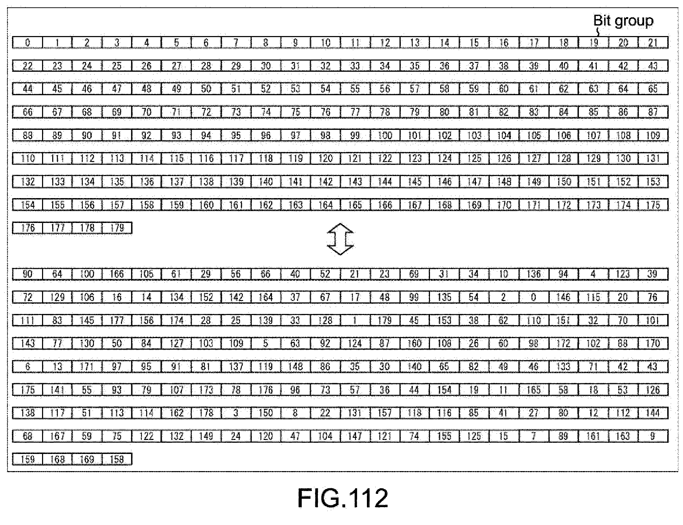

Fig. 112 is a diagram showing a third example of the GW pattern for the LDPC code whose code length N of 64k bits.

According to the GW pattern in Fig. 112, a sequence of the bit groups 0 to 179 having the LDPC code of 64k bits is interleaved to a sequence of a bit group of
90, 64, 100, 166, 105, 61, 29, 56, 66, 40, 52, 21, 23, 69, 31, 34, 10, 136, 94, 4, 123, 39, 72, 129, 106, 16, 14, 134, 152, 142, 164, 37, 67, 17, 48, 99, 135, 54, 2, 0, 146, 115, 20, 76, 111, 83, 145, 177, 156, 174, 28, 25, 139, 33, 128, 1, 179, 45, 153, 38, 62, 110, 151, 32, 70, 101, 143, 77, 130, 50, 84, 127, 103, 109, 5, 63, 92, 124, 87, 160, 108, 26, 60, 98, 172, 102, 88, 170, 6, 13, 171, 97, 95, 91, 81, 137, 119, 148, 86, 35, 30, 140, 65, 82, 49, 46, 133, 71, 42, 43, 175, 141, 55, 93, 79, 107, 173, 78, 176, 96, 73, 57, 36, 44, 154, 19, 11, 165, 58, 18, 53, 126, 138, 117, 51, 113, 114, 162, 178, 3, 150, 8, 22, 131, 157, 118, 116, 85, 41, 27, 80, 12, 112, 144, 68, 167, 59, 75, 122, 132, 149, 24, 120, 47, 104, 147, 121, 74, 155, 125, 15, 7, 89, 161, 163, 9, 159, 168, 169, 158.

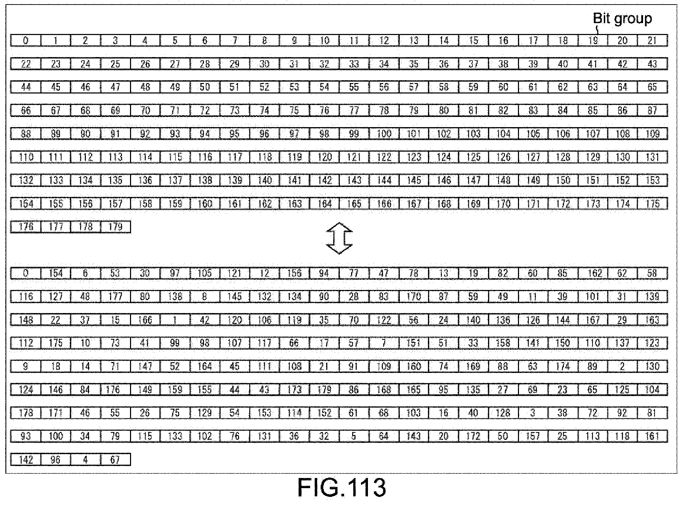

Fig. 113 is a diagram showing a fourth example of the GW pattern for the LDPC code whose code length N of 64k bits.

According to the GW pattern in Fig. 113, a sequence of the bit groups 0 to 179 having the LDPC code of 64k bits is interleaved to a sequence of a bit group of
0, 154, 6, 53, 30, 97, 105, 121, 12, 156, 94, 77, 47, 78, 13, 19, 82, 60, 85, 162, 62, 58, 116, 127, 48, 177, 80, 138, 8, 145, 132, 134, 90, 28, 83, 170, 87, 59, 49, 11, 39, 101, 31, 139, 148, 22, 37, 15, 166, 1, 42, 120, 106, 119, 35, 70, 122, 56, 24, 140, 136, 126, 144, 167, 29, 163, 112, 175, 10, 73, 41, 99, 98, 107, 117, 66, 17, 57, 7, 151, 51, 33, 158, 141, 150, 110, 137, 123, 9, 18, 14, 71, 147, 52, 164, 45, 111, 108, 21, 91, 109, 160, 74, 169, 88, 63, 174, 89, 2, 130, 124, 146, 84, 176, 149, 159, 155, 44, 43, 173, 179, 86, 168, 165, 95, 135, 27, 69, 23, 65, 125, 104, 178, 171, 46, 55, 26, 75, 129, 54, 153, 114, 152, 61, 68, 103, 16, 40, 128, 3, 38, 72, 92, 81, 93, 100, 34, 79, 115, 133, 102, 76, 131, 36, 32, 5, 64, 143, 20, 172, 50, 157, 25, 113, 118, 161, 142, 96, 4, 67.

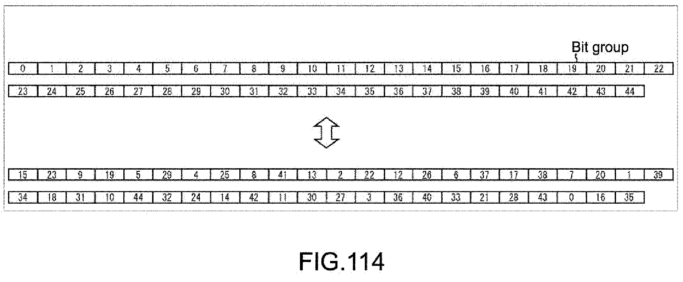

Fig. 114 is a diagram showing a first example of a GW pattern for the LDPC code whose code length N of 16k bits.

According to the GW pattern in Fig. 114, a sequence of the bit groups 0 to 44 having the LDPC code of 16k bits is interleaved to a sequence of a bit group of
15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

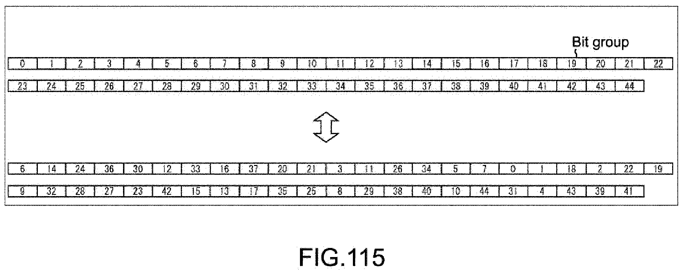

Fig. 115 is a diagram showing a second example of the GW pattern for the LDPC code whose code length N of 16k bits.

According to the GW pattern in Fig. 115, a sequence of the bit groups 0 to 44 having the LDPC code of 16k bits is interleaved to a sequence of a bit group of 6, 14, 24, 36, 30, 12, 33, 16, 37, 20, 21, 3, 11, 26, 34, 5, 7, 0, 1, 18, 2, 22, 19, 9, 32, 28, 27, 23, 42, 15, 13, 17, 35, 25, 8, 29, 38, 40, 10, 44, 31, 4, 43, 39, 41.

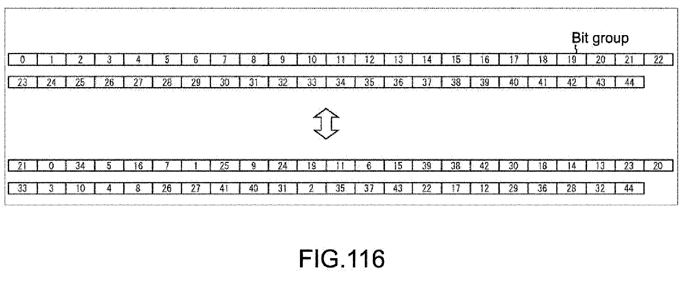

Fig. 116 is a diagram showing a third example of the GW pattern for the LDPC code whose code length N of 16k bits.

According to the GW pattern in Fig. 116, a sequence of the bit groups 0 to 44 having the LDPC code of 16k bits is interleaved to a sequence of a bit group of
21, 0, 34, 5, 16, 7, 1, 25, 9, 24, 19, 11, 6, 15, 39, 38, 42, 30, 18, 14, 13, 23, 20, 33, 3, 10, 4, 8, 26, 27, 41, 40, 31, 2, 35, 37, 43, 22, 17, 12, 29, 36, 28, 32, 44.

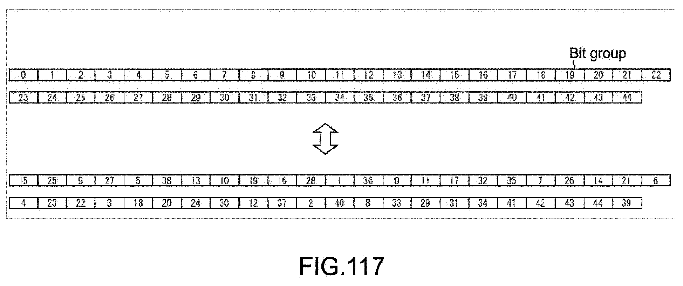

Fig. 117 is a diagram showing a fourth example of the GW pattern for the LDPC code whose code length N of 16k bits.

According to the GW pattern in Fig. 117, a sequence of the bit groups 0 to 44 having the LDPC code of 16k bits is interleaved to a sequence of a bit group of
15, 25, 9, 27, 5, 38, 13, 10, 19, 16, 28, 1, 36, 0, 11, 17, 32, 35, 7, 26, 14, 21, 6, 4, 23, 22, 3, 18, 20, 24, 30, 12, 37, 2, 40, 8, 33, 29, 31, 34, 41, 42, 43, 44, 39.

For the group-wise interleave, the GW pattern is set for each combination of the code rate r of the LDPC code and the modulation scheme other than the code length N of the LDPC code, thereby improving the bit error rate for each combination.

However, if the GW pattern is set individually for all combination of the code length N and code rate r is the LDPC code and the modulation scheme, the GW pattern should be changed every time the LDPC code and the modulation scheme used in the transmitting device 11 are changed. As a result, the processing becomes complex.

For the group-wise interleave, for example, the code rate r of the LDPC code is classified into a low rate (e.g., 6/15, 7/15, 8/15, 9/15) and a high rate (e. g., 10/15, 11/15, 12/15, 13/15). The GW pattern can be set for each combination of the code length N of the LDPC code of 16k bits or 64k bits, the code rate r of the LDPC code of the low rate or the high rate, and the modulation scheme of 16QAM, 64QAM, 256QAM or 1024QAM.

When the above-described combination of the code length N, the code rate r and the modulation scheme is expressed by (the code length N, the code rate r, the modulation scheme), 16 combinations of the code length N, the code rate r and the modulation scheme can be supposed: (16k, low rate, 16QAM), (16k, low rate, 64QAM), (16k, low rate, 256QAM), (16k, low rate, 1024QAM), (16k, high rate, 16QAM), (16k, high rate, 64QAM), (16k, high rate, 256QAM), (16k, high rate, 1024QAM), (64k, low rate, 16QAM), (64k, low rate, 64QAM), (64k, low rate, 256QAM), (64k, low rate, 1024QAM), (64k, high rate, 16QAM), (64k, high rate, 64QAM), (64k, high rate, 256QAM) and (64k, high rate, 1024QAM), for example.

For the combination of code length N of the LDPC code set to 64k: (64k, low rate, 16QAM), (64k, low rate, 64QAM), (64k, low rate, 256QAM), (64k, low rate, 1024QAM), (64k, high rate, 16QAM), (64k, high rate, 64QAM), (64k, high rate, 256QAM) and (64k, high rate, 1024QAM), the GW pattern that most improves the error rate can be applied among the four GW patterns shown in Fig. 110 to Fig. 113.

For example, the GW pattern in Fig. 110 can be applied to the combination (64k, high rate, 16QAM), the GW pattern in Fig. 111 can be applied to the combination (64k, low rate, 64QAM), the GW pattern in Fig. 112 can be applied to the combination (64k, high rate, 256QAM), the GW pattern in Fig. 113 can be applied to the combination (64k, low rate, 1024QAM), respectively.

For the combination of code length N of the LDPC code is set to 16k: (16k, low rate, 16QAM), (16k, low rate, 64QAM), (16k, low rate, 256QAM), (16k, low rate, 1024QAM), (16k, high rate, 16QAM), (16k, high rate, 64QAM), (16k, high rate, 256QAM) and (16k, high rate, 1024QAM), the GW pattern that most improves the error rate can be applied among the four GW patterns shown in Fig. 114 to Fig. 117.

For example, the GW pattern in Fig. 114 can be applied to the combination (16k, low rate, 16QAM), the GW pattern in Fig. 115 can be applied to the combination (16k, high-rate, 64QAM), the GW pattern in Fig. 116 can be applied to the combination (16k, low rate, the 256QAM), and the GW pattern in Fig. 117 can be applied to the combination (16k, high rate, in 1024QAM), respectively.

According to simulation by the present inventors, for the GW pattern in Fig. 110, it was confirmed that it is especially possible to achieve good error rate in the combination of each of the second new LDPC code of (64k, 10/15), the first new LDPC code of (64k, 11/15), the second new LDPC code of (64k, 12/15) and the first new LDPC code of (64k, 13/15) and the modulation scheme 16QAM of which the constellation is illustrated in Fig. 92 to Fig. 105.

For the GW pattern in Fig. 111, it was confirmed that it is especially possible to achieve good error rate in the combination of each of the second new LDPC code of (64k, 6/15), the first new LDPC code of (64k, 7/15), the second new LDPC code of (64k, 8/15) and the first new LDPC code of (64k, 9/15) and the modulation scheme 64QAM of which the constellation is illustrated in Fig. 92 to Fig. 105.

For the GW pattern in Fig. 112, it was confirmed that it is especially possible to achieve good error rate in the combination of each of the second new LDPC code of (64k, 10/15), the first new LDPC code of (64k, 11/15), the second new LDPC code of (64k, 12/15) and the first new LDPC code of (64k, 13/15) and the modulation scheme 256QAM of which the constellation is illustrated in Fig. 92 to Fig. 105.

For the GW pattern in Fig. 113, it was confirmed that it is especially possible to achieve good error rate in the combination of each of the second new LDPC code of (64k, 6/15), the first new LDPC code of (64k, 7/15), the second new LDPC code of (64k, 8/15) and the first new LDPC code of (64k, 9/15) and the modulation scheme 1024QAM of which the constellation is illustrated in Fig. 92 to Fig. 105.

For the GW pattern in Fig. 114, it was confirmed that it is especially possible to achieve good error rate in the combination of each of the first new LDPC code of (16k, 6/15), the second new LDPC code of (16k, 7/15), the first new LDPC code of (16k, 8/15) and the second new LDPC code of (16k, 9/15) and the modulation scheme 16QAM of which the constellation is illustrated in Fig. 92 to Fig. 105.

For the GW pattern in Fig. 115, it was confirmed that it is especially possible to achieve good error rate in the combination of each of the first new LDPC code of (16k, 10/15), the second new LDPC code of (16k, 11/15), the first new LDPC code of (16k, 12/15) and the second new LDPC code of (16k, 13/15) and the modulation scheme 64QAM of which the constellation is illustrated in Fig. 92 to Fig. 105.

For the GW pattern in Fig. 116, it was confirmed that it is especially possible to achieve good error rate in the combination of each of the first new LDPC code of (16k, 6/15), the second new LDPC code of (16k, 7/15), the first new LDPC code of (16k, 8/15) and the second new LDPC code of (16k, 9/15) and the modulation scheme 256QAM of which the constellation is illustrated in Fig. 92 to Fig. 105.

For the GW pattern in Fig. 117, it was confirmed that it is especially possible to achieve good error rate in the combination of each of the first new LDPC code of (16k, 10/15), the second new LDPC code of (16k, 11/15), the first new LDPC code of (16k, 12/15) and the second new LDPC code of (16k, 13/15) and the modulation scheme 1024QAM of which the constellation is illustrated in Fig. 92 to Fig. 105.

### <Configuration Example of Receiving Apparatus 12>

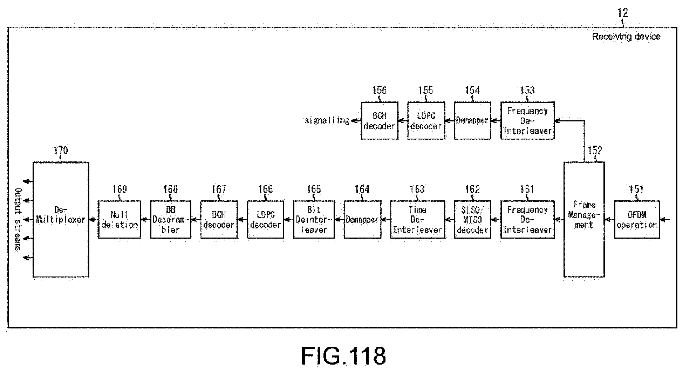

Fig. 118 is a block diagram showing a configuration example of the receiving device 12 in Fig. 7.

An OFDM operation 151 receives the OFDM signal from the transmitting device 11 (Fig. 7) and performs signal processing of the OFDM signal. The data obtained by the signal processing by the OFDM operation 151 is supplied to a frame management 152.

The frame management 152 performs processing of the frame (frame interpretation) configured of the data supplied from the OFDM operation 151 and supplies the signal of the target data and the signal of the control data obtained as a result to frequency deinterleavers 161 and 153.

The frequency deinterleaver 153 performs frequency deinterleave in a symbol unit for the data from the frame management 152 to supply to a demapper 154.

The demapper 154 demaps (performs signal point constellation decoding) the data (data on the constellation) from the frequency deinterleaver 153 based on the signal arrangement (constellation) determined by the orthogonal modulation performed at the transmitting device 11 to perform the orthogonal demodulation thereof and supplies the data ((likelihood) of the LDPC code) obtained as a result to a LDPC decoder 155.

The LDPC decoder 155 performs LDPC decoding of the LDPC code from the demapper 154 and supplies the LDPC target data (herein, a BCH code) obtained as a result to a BCH decoder 156.

The BCH decoder 156 performs BCH decoding of the LDPC target data from the LDPC decoder 155 and outputs the control data (signaling) obtained as a result.

On the other hand, the frequency deinterleaver 161 performs the frequency deinterleave in a symbol unit for the data from the frame management 152 to supply to a SISO/MISO decoder 162.

The SISO/MISO decoder 162 performs time-space decoding of the data from the frequency deinterleaver 161 to supply to a time deinterleaver 163.

The time deinterleaver 163 performs time deinterleave of the data from the SISO/MISO decoder 162 in a symbol unit to supply to a demapper 164.

The demapper 164 demaps (performs signal point constellation decoding) the data (data on the constellation) from the time deinterleaver 163 based on the signal point arrangement (constellation) determined by the orthogonal modulation performed at the transmitting device 11 to perform the orthogonal demodulation thereof and supplies the data obtained as a result to a bit deinterleaver 165.

The bit deinterleaver 165 performs bit deinterleave of the data from the demapper 164 and supplies (the likelihood of) the LDPC code obtained as a result to an LDPC decoder 166.

The LDPC decoder 166 performs the LDPC decoding of the LDPC code from the bit deinterleaver 165 and supplies the LDPC target data (herein, the BCH code) obtained as a result to a BCH decoder 167.

The BCH decoder 167 performs the BCH decoding of the LDPC target data from the LDPC decoder 155 and supplies the data obtained as a result to a BB descrambler 168.

The BB descrambler 168 applies a BB descramble to the data from the BCH decoder 167 and supplies the data obtained as a result to a null deletion 169.

The null deletion 169 deletes the null inserted by the padder 112 in Fig. 8 from the data from the BB descrambler 168 and supplies the same to a demultiplexer 170.

The demultiplexer 170 separates one or more streams (target data) multiplexed into the data from the null deletion 169 and outputs the same as output streams.

The receiving device 12 may be configured without including some of the blocks shown in Fig. 48. In other words, if the transmitting device 11 (Fig. 8) is configured without including the time interleaver 118, the SISO/MISO encoder 119, the frequency interleaver 120, and frequency interleaver 124, for example, the receiving device 12 may be configured without including the time deinterleaver 163, the SISO/MISO decoder 162, the frequency deinterleaver 161, and frequency deinterleaver 153 that are the blocks corresponding to the time interleaver 118, the SISO/MISO encoder 119, the frequency interleaver 120, and frequency interleaver 124 of the transmitting device 11, respectively.

### <Configuration Example of Bit Deinterleaver>

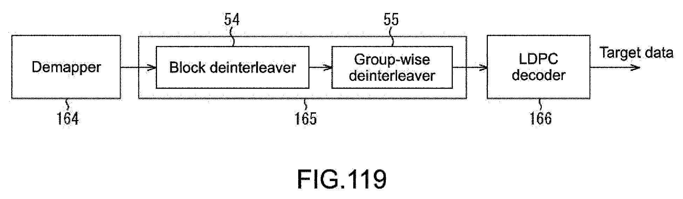

Fig. 119 is a block diagram showing a configuration example of the bit deinterleaver 165 in Fig. 118.

The bit deinterleaver 165 configured of a block deinterleaver 54 and a group-wise deinterleaver 55 and performs the (bit) deinterleave of the symbol bit of the data from the demapper 164 (Fig. 118).

That is to say, the block deinterleaver 54 performs a block deinterleave (an inverse process of block interleave) corresponding to the block interleave performed by the block interleaver 25 in Fig. 9, that is to say, the block deinterleave to return the positions of (the likelihood of) the code bits of the LDPC code interchanged by the block interleave to the original positions to the symbol bit of the symbol from the demapper 164 and supplies the LDPC code obtained as a result to the group-wise deinterleaver 55.

The group-wise deinterleaver 55 performs group-wise deinterleave (inverse process of the group-wise interleave) corresponding to the group-wise interleave performed by the group-wise interleaver 24 in Fig. 9, that is to say, the group-wise deinterleave to return the code bits of the LDPC code of which arrangement is changed by the group-wise interleave illustrated in Fig. 110 to Fig. 117 in a bit group unit are rearranged in a bit group unit to the original arrangement to the LDPC code from the block deinterleaver 54.

If the parity interleave, the group-wise interleave, and the block interleave are applied to the LDPC code supplied from the demapper 164 to the bit deinterleaver 165, the bit deinterleaver 165 may perform all of parity deinterleave (inverse process of the parity interleave, that is to say, the parity deinterleave to return the code bits of the LDPC code, the arrangement of which is changed by the parity interleave, to the original arrangement) corresponding to the parity interleave, the block deinterleave corresponding to the block interleave, and the group-wise deinterleave corresponding to the group-wise interleave.

Note that the bit deinterleaver 165 in Fig. 119 includes the block deinterleaver 54 that performs the block deinterleave corresponding to the block interleave, and the group-wise deinterleaver 55 that performs the group-wise deinterleave corresponding to the group-wise interleave, but includes no block for performing the parity deinterleave corresponding to the parity interleave, and the parity deinterleave is not performed.

Therefore, the LDPC code, to which the block deinterleave and the group-wise deinterleave are applied and the parity deinterleave is not applied, is supplied from (the group-wise deinterleaver 55 of) the bit deinterleaver 165 to the LDPC decoder 166.

The LDPC decoder 166 performs the LDPC decoding of the LDPC code from the bit deinterleaver 165 using the conversion parity check matrix obtained by at least applying the column permutation corresponding to the parity interleave to the parity check matrix H used by the LDPC encoder 115 in Fig. 8 in the LDPC encoding and outputs the data obtained as a result as a decoding result of the LDPC target data.

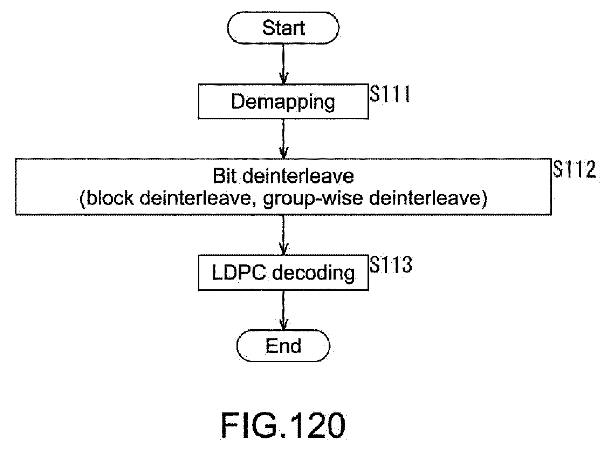

Fig. 120 is a flowchart illustrating processes performed by the demapper 164, the bit deinterleaver 165, and the LDPC decoder 166 in Fig. 119.

At step S111, the demapper 164 demaps the data from the time deinterleaver 163 (data mapped onto the signal point on the constellation) to perform the orthogonal demodulation and supplies the same to the bit deinterleaver 165, then the process shifts to S112.

At step S112, the bit deinterleaver 165 performs the deinterleave (bit deinterleave) from the demapper 164 and the process shifts to step S113.

That is to say, at step S112, the block deinterleaver 54 performs in the bit deinterleaver 165 the block deinterleave of the data (symbol) from the demapper 164 and supplies the code bit of the LDPC code obtained as a result to the group-wise deinterleaver 55.

The group-wise deinterleaver 55 performs the group-wise deinterleave to the LDPC code from the block deinterleaver 54 and supplies (the likelihood of) the LDPC code obtained as a result to the LDPC decoder 166.

At step S113, the LDPC decoder 166 performs the LDPC decoding of the LDPC code from the group-wise deinterleaver 55 using the conversion parity check matrix H used by the LDPC encoder 115 in Fig. 8 in the LDPC encoding, i.e., using the conversion parity check matrix obtained by at least applying the column permutation corresponding to the parity interleave to the parity check matrix H and outputs the data obtained as a result to the BCH decoder 167 as the decoding result of the LDPC target data.

Although the block deinterleaver 54, which performs the block deinterleave, and the group-wise deinterleaver 55, which performs the group-wise deinterleave, are separately formed also in Fig. 119 as in Fig. 9 for convenience of description, the block deinterleaver 54 and the group-wise deinterleaver 55 may be integrally formed.

### <LDPC decoding>

The LDPC decoding performed by the LDPC decoder 166 in Fig. 188 is further described.

The LDPC decoder 166 in Fig. 118 performs the LDPC decoding of the LDPC code to which the block deinterleave and the group-wide deinterleave are applied and the parity interleave is not applied from the group-wise deinterleaver 55 using the conversion parity check matrix obtained by at least applying the column permutation corresponding to the parity interleave to the parity check matrix H used by the LDPC encoder 115 in Fig. 8 in the LDPC encoding as described above.

Herein, the LDPC decoding capable of limiting an operation frequency within a sufficiently feasible range while limiting a circuit size by performing the LDPC decoding using the conversion parity check matrix is conventionally suggested (refer to Patent No. 4224777, for example).

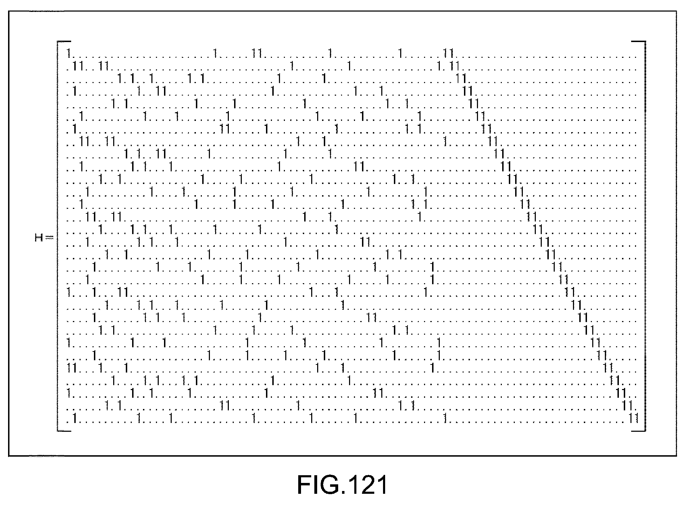

Firstly, the LDPC decoding using the conversion parity check matrix conventionally suggested is first described with reference to Fig. 121 to Fig. 124.

Fig. 121 illustrates an example of the parity check matrix H of the LDPC code whose code length N is 90 and code rate is 2/3.

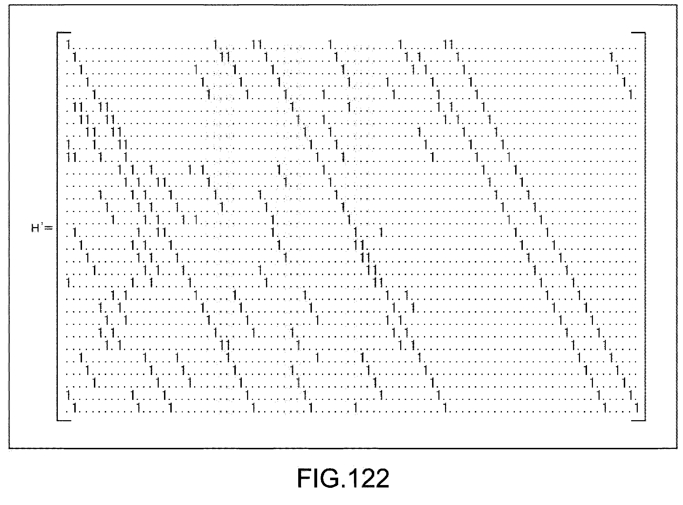

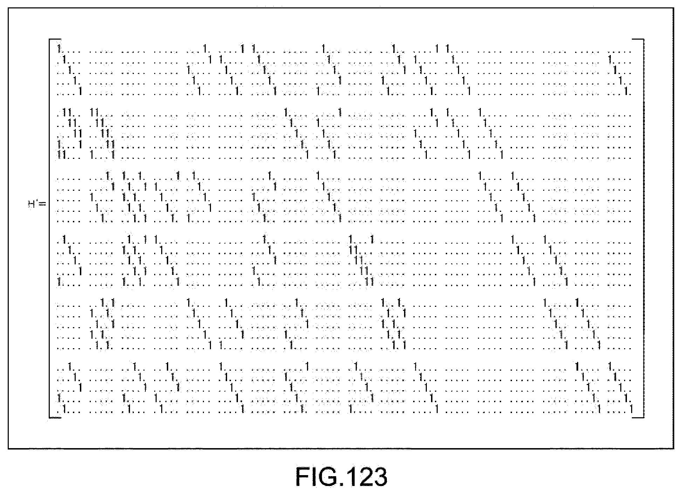

In Fig. 121 (also in Fig. 122 and Fig. 123 to be described later), 0 is represented by a period (.).

In the parity check matrix H in Fig. 121, the parity matrix has the stepwise structure.

Fig. 122 illustrates a parity check matrix H' obtained by applying the row permutation in equation (11) and the column permutation in equation (12) to the parity check matrix H in Fig. 121.$Row permulation : 6 s + t + first row - > t + s + first row$ $Column permutation : 6 x + y + 61 th row - > 5 y + x + 61 th row$

In equations (11) and (12), s, t, x, and y are integers within a range satisfying 0 ≤ s < 5, 0 ≤ t < 6, 0 ≤ x < 5, and 0 ≤ t < 6, respectively.

According to the row permutation in equation (11), it is permutated such that 1st, 7th, 13th, 19th, and 25th rows, which leave a remainder of 1 when divided by 6, are made 1st, 2nd, 3rd, 4th, and 5th rows, and 2nd, 8th, 14th, 20th, and 26th rows, which leave a remainder of 2 when divided by 6, are made 6th, 7th, 8th, 9th, and 10th rows, respectively.

Also, according to the column permutation in equation (12), it is permutated such that 61st, 67th, 73rd, 79th, and 85th columns, which leave a remainder of 1 when divided by 6, are made 61st, 62nd, 63rd, 64th, and 65th columns, and 62nd, 68th, 74th, 80th, and 86th columns, which leave a remainder of 2 when divided by 6, are made 66th, 67th, 68th, 69th, and 70th columns, respectively, for the 61st and subsequent columns (parity matrix).

The matrix obtained by performing the row permutation and the column permutation of the parity check matrix H in Fig. 121 in this manner is the parity check matrix H' in Fig. 1222.

Herein, the row permutation of the parity check matrix H does not affect the arrangement of the code bits of the LDPC code.

The column permutation in equation (12) corresponds to the parity interleave when the information length K, the number of columns P being the unit of the cyclic structure, and the submultiple q (= M/P) of the parity length M (herein, 30) of the above-described parity interleave to interleave the K + qx + y + 1-th code bit to the position of the K + Py + x + 1-th code bit are set to 60, 5, and 6, respectively.

Accordingly, the parity check matrix H' in Fig. 122 is the conversion parity check matrix obtained by at least applying the column permutation that the K + qx + y + 1-th column is permutated with the K + Py + x + 1-th column of the parity check matrix H in Fig. 121 (hereinafter, appropriately referred to as the original parity check matrix).

By multiplying the parity check matrix H' in Fig. 122 by the LDPC code of the parity check matrix H in Fig. 121 to which the same permutation as equation (12) is applied, a 0 vector is output. That is to say, when a row vector obtained by applying the column permutation in equation (12) to the row vector c as the LDPC code (one code word) of the original parity check matrix H is represented as c', Hc^{T} becomes the 0 vector from the nature of the parity check matrix, so that H'c'^{T} naturally becomes the 0 vector.

From above, the conversion parity check matrix H' in Fig. 122 is the parity check matrix of the LDPC code c' obtained by applying the column permutation in equation (12) to the LDPC code c of the original parity check matrix H.

Therefore, by applying the column permutation in equation (12) to the LDPC code c of the original parity check matrix H, decoding (LDPC decoding) the LDPC code c' after the column permutation using the conversion parity check matrix H' in Fig. 122, and applying inverse permutation in the column permutation in equation (12) to the decoding result, it is possible to obtain the decoding result similar to that in a case in which the LDPC code of the original parity check matrix H is decoded using the parity check matrix H.

Fig. 123 shows the conversion parity check matrix H' in Fig. 122 with an interval between the units of 5 × 5 matrix.

In Fig. 123, the conversion parity check matrix H' is represented by a combination of the 5 × 5 (= P x P) unit matrix, a matrix in which one or more 1 of the unit matrix is set to 0 (hereinafter, appropriately referred to as a quasi-unit matrix), a matrix obtained by the cyclic shift of the unit matrix or the quasi-unit matrix (hereinafter, appropriately referred to as a shift matrix), a sum of two or more of the unit matrix, the quasi-unit matrix, and the shift matrix (hereinafter, appropriately referred to as a sum matrix), and a 5 × 5 0 matrix.

It may be said that the conversion parity check matrix H' in Fig. 123 is configured of the 5 × 5 unit matrix, quasi-unit matrix, shift matrix, sum matrix, and 0 matrix. Therefore, the 5 × 5 matrices (the unit matrix, the quasi-unit matrix, the shift matrix, the sum matrix, and the 0 matrix) constitute the conversion parity check matrix H' are hereinafter appropriately referred to as constitutive matrices.

An architecture to simultaneously perform P check node operations and P variable node operations may be used to decode the LDPC code of the parity check matrix represented by a P × P constitutive matrix.

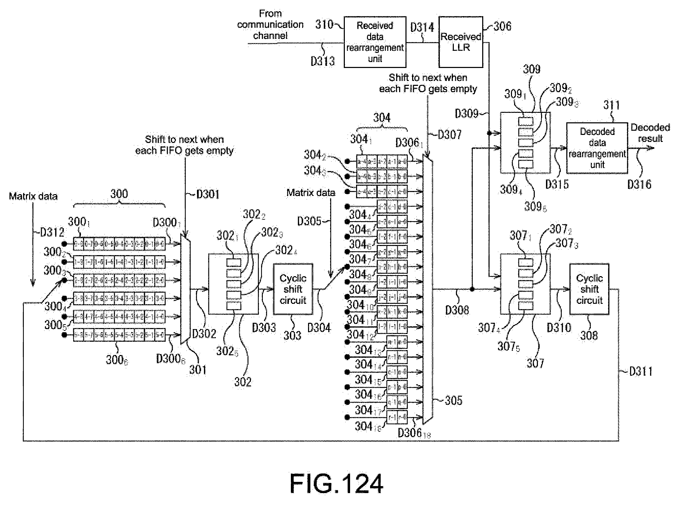

Fig. 124 is a block diagram showing a configuration example of the decoding device, which performs such decoding.

That is to say, Fig. 124 shows the configuration example of the decoding device, which decodes the LDPC code using the conversion parity check matrix H' in Fig. 123 obtained by at least applying the column permutation in equation (12) to the original parity check matrix H in Fig. 121.

The decoding device in Fig. 124 is configured of an edge data storage memory 300 configured of 6 FIFOs 300₁ to 300₆, a selector 301, which selects from the FIFOs 300₁ to 300₆, a check node calculation unit 302, two cyclic shift circuits 303 and 308, an edge data storage memory 304 configured of 18 FIFOs 304₁ to 304₁₈, a selector 305, which selects from the FIFOs 304₁ to 304₁₈, a received data memory 306, which stores received data, a variable node calculation unit 307, a decoded word calculation unit 309, a received data rearrangement unit 310, and a decoded data rearrangement unit 311.

A method of storing the data in the edge data storage memories 300 and 304 is first described.

The edge data storage memory 300 is configured of six FIFOs 300₁ to 300₆, the number of which is obtained by dividing the number of rows 30 of the conversion parity check matrix H' in Fig. 123 by the number of rows (the number of columns P being the unit of the cyclic structure) 5 of the constitutive matrix. The FIFOs 300y (y = 1, 2, ..., 6) are formed of a plurality of stages of storage regions and messages corresponding to five edges, the number of which is equal to the number of rows and the number of columns of the constitutive matrix (the number of columns P being the unit of the cyclic structure), may be read and written at the same time from and to the storage region of each stage. The number of stages of the storage regions of the FIFO 300y is set to nine being a maximum number of 1 in the row direction of the conversion parity check matrix in Fig. 123 (Hamming weight).

The data corresponding to the position of 1 from first to fifth rows of the conversion parity check matrix H' in Fig. 123 (a message vᵢ from the variable node) is stored in the FIFO 300₁ in a form closed up in a horizontal direction for each row (ignoring 0). That is to say, when the j-th row i-th column is represented as (j, i), the data corresponding to the position of 1 of the 5 × 5 unit matrix from (1, 1) to (5, 5) of the conversion parity check matrix H' is stored in the storage region of a first stage of the FIFO 300₁. The data corresponding to the position of 1 of the shift matrix from (1, 21) to (5, 25) of the conversion parity check matrix H' (shift matrix obtained by the cyclic shift of the 5 × 5 unit matrix by three rightward) is stored in the storage region of a second stage. The data is similarly stored in the storage regions of third to eighth stages in association with the conversion parity check matrix H'. Then, the data corresponding to the position of 1 of the shift matrix (shift matrix obtained by replacement of 1 in the first row of the 5 × 5 unit matrix with 0 and the cyclic shift thereof by one leftward) from (1, 86) to (5, 90) of the conversion parity check matrix H' is stored in the storage region of a ninth stage.

The data corresponding to the position of 1 from 6th to 10th rows of the conversion parity check matrix H' in Fig. 123 is stored in the FIFO 300₂. That is to say, the data corresponding to the position of 1 of a first shift matrix configuring the sum matrix from (6, 1) to (10, 5) of the conversion parity check matrix H' (the sum matrix obtained by summing the first shift matrix obtained by the cyclic shift of the 5 × 5 unit matrix by one rightward and a second shift matrix obtained by the cyclic shift thereof by two rightward) is stored in the storage region of a first stage of the FIFO 300₂. The data corresponding to the position of 1 of the second shift matrix configuring the sum matrix from (6, 1) to (10, 5) of the conversion parity check matrix H' is stored in the storage region of a second stage.

That is to say, as for the constitutive matrix whose weight is 2 or larger, the data corresponding to the position of 1 of the unit matrix, the quasi-unit matrix, and the shift matrix whose weight is 1 (message corresponding to the edge belonging to the unit matrix, the quasi-unit matrix, or the shift matrix) when the constitutive matrix is represented as the sum of a plurality of the P × P unit matrix whose weight is 1, the quasi-unit matrix in which one or more of the elements 1 of the unit matrix is set to 0, and the shift matrix obtained by the cyclic shift of the unit matrix or the quasi-unit matrix is stored in the same address (same FIFO out of the FIFOs 300₁ to 300₆).

The data is hereinafter stored in association with the conversion parity check matrix H' also in the storage regions of third to ninth stages.

The data is stored in association with the conversion parity check matrix H' also in the FIFOs 300₃ to 300₆.

The edge data storage memory 304 is configured of 18 FIFOs 304₁ to 304₁₈, the number of which is obtained by dividing the number of columns 90 of the conversion parity check matrix H' by the number of columns 5 of the constitutive matrix (the number of columns P being the unit of the cyclic structure). The FIFO 304x (x = 1, 2, ..., 18) is formed of a plurality of stages of storage regions, and the messages corresponding to the five edges, the number of which is the number of rows and the number of columns of the constitutive matrix (the number of columns P being the unit of the cyclic structure) may be simultaneously read and written from and to the storage region of each stage.

In the FIFO 304₁, the data corresponding to the position of 1 from first to fifth columns of the conversion parity check matrix H' in Fig. 123 (message uⱼ from the check node) is stored in a form closed up in a vertical direction for each column (ignoring 0). That is to say, the data corresponding to the position of 1 of the 5 × 5 unit matrix from (1, 1) to (5, 5) of the conversion parity check matrix H' is stored in the storage region of a first stage of the FIFO 304₁. The data corresponding to the position of 1 of the first shift matrix configuring the sum matrix from (6, 1) to (10, 5) of the conversion parity check matrix H' (the sum matrix obtained by summing the first shift matrix obtained by the cyclic shift of the 5 × 5 unit matrix by one rightward and the second shift matrix obtained by the cyclic shift thereof by two rightward) is stored in the storage region of the second stage. The data corresponding to the position of 1 of a second shift matrix configuring the sum matrix from (6, 1) to (10, 5) of the conversion parity check matrix H' is stored in the storage region of a third stage.

That is to say, as for the constitutive matrix whose weight is 2 or larger, the data corresponding to the position of 1 of the unit matrix, the quasi-unit matrix, and the shift matrix whose weight is 1 (the message corresponding to the edge belonging to the unit matrix, the quasi-unit matrix, or the shift matrix) when the constitutive matrix is represented as the sum of a plurality of the P × P unit matrix whose weight is 1, the quasi-unit matrix in which one or more of the elements 1 of the unit matrix is set to 0, and the shift matrix obtained by the cyclic shift of the unit matrix or the quasi-unit matrix is stored in the same address (same FIFO out of the FIFOs 304₁ to 304₁₈).

Hereinafter, the data is stored in the storage regions of fourth and fifth stages in association with the conversion parity check matrix H'. The number of stages of the storage regions of the FIFO 304₁ is five being the maximum number of the number of 1 in the row direction from the first to fifth columns of the conversion parity check matrix H' (Hamming weight).

The data is similarly stored in association with the conversion parity check matrix H' in the FIFOs 304₂ and 304₃, the length (the number of stages) of which is five. The data is similarly stored in association with the conversion parity check matrix H' in the FIFOs 304₄ to 304₁₂, the length of which is three. The data is similarly stored in association with the conversion parity check matrix H' in the FIFOs 304₁₃ to 304₁₈, the length of which is two.

Next, operation of the decoding device in Fig. 124 is described.

The edge data storage memory 300 is configured of the six FIFOs 300₁ to 300₆, selects the FIFO in which the data is stored from the FIFOs 300₁ to 300₆ according to information (matrix data) D312 indicating the row of the conversion parity check matrix H' in Fig. 123 to which five messages D311 supplied from the cyclic shift circuit 308 in a preceding stage belong, and collectively stores the five messages D311 in the selected FIFO in sequence. When reading the data, the edge data storage memory 300 reads five messages D300₁ from the FIFO 300₁ in sequence to supply to the selector 301 in a subsequent stage. The edge data storage memory 300 reads the message also from the FIFOs 300₂ to 300₆ in sequence after finishing reading the message from the FIFO 300₁ to supply to the selector 301.

The selector 301 selects the five messages from the FIFO from which the data is currently read out of the FIFOs 300₁ to 300₆ according to a select signal D301 and supplies the same as a message D302 to the check node calculation unit 302.

The check node calculation unit 302 configured of five check node calculators 302₁ to 302₅ performs the check node operation according to equation (7) using the messages D302 (D302₁ to D302₅) supplied through the selector 301 (message vᵢ in equation (7)) and supplies five messages D303 (D303₁ to D303₅) obtained as a result of the check node operation (message uⱼ in equation (7)) to the cyclic shift circuit 303.

The cyclic shift circuit 303 performs the cyclic shift of the five messages D303₁ to D303₅ obtained by the check node calculation unit 302 based on information (matrix data) D305 indicating the value by which the cyclic shift of the original unit matrix (or the quasi-unit matrix) in the conversion parity check matrix H' is performed to obtain the corresponding edge and supplies a result to the edge data storage memory 304 as a message D304.

The edge data storage memory 304 is configured of 18 FIFOs 304₁ to 304₁₈, selects the FIFO in which the data is stored from the FIFOs 304₁ to 304₁₈ according to the information D305 indicating the row of the conversion parity check matrix H' to which the five messages D304 supplied from the cyclic shift circuit 303 in the preceding stage belongs, and collectively stores the five messages D304 in the selected FIFO in sequence. When reading the data, the edge data storage memory 304 reads the five messages D306₁ in sequence from the FIFO 304₁ to supply to the selector 305 in the subsequent stage. The edge data storage memory 304 reads the message in sequence also from the FIFOs 304₂ to 304₁₈ after finishing reading the data from the FIFO 304₁ to supply to the selector 305.

The selector 305 selects the five messages from the FIFO from which the data is currently read out of the FIFOs 304₁ to 304₁₈ according to a select signal D307 and supplies the same to the variable node calculation unit 307 and the decoded word calculation unit 309 as a message D308.

On the other hand, the received data rearrangement unit 310 rearranges an LDPC code D313 received through the communication channel 13 corresponding to the parity check matrix H in Fig. 121 by the column permutation in equation (12) and supplies the same to the received data memory 306 as received data D314. The received data memory 306 calculates a received LLR (log likelihood ratio) from the received data D314 supplied from the received data rearrangement unit 310 to store and collectively supplies the five received LLRs to the variable node calculation unit 307 and the decoded word calculation unit 309 as received value D309.

The variable node calculation unit 307 is configured of five variable node calculators 307₁ to 307₅, performs the variable node operation according to equation (1) using the messages D308 (D308₁ to D308₅) supplied through the selector 305 (message uⱼ in equation (1) and the five received values D309 supplied from the received data memory 306 (received value u₀ᵢ in equation (1)) and supplies messages D310 (D310₁ to D310₅) obtained as a result of the operation (message vᵢ in equation (1)) to the cyclic shift circuit 308.

The cyclic shift circuit 308 performs the cyclic shift of the messages D310₁ to D310₅ calculated by the variable node calculation unit 307 based on the information indicating the value by which the cyclic shift of the original unit matrix (or the quasi-unit matrix) in the conversion parity check matrix H' is performed to obtain the corresponding edge and supplies a result to the edge data storage memory 300 as a message D311.

Single decoding (variable node operation and check node operation) of the LDPC code may be performed by single round of the above-described operation. The decoding device in Fig. 124 decodes the LDPC code a predetermined number of times, and then obtains a final decoding result by the decoded word calculation unit 309 and the decoded data rearrangement unit 311 to output.

That is to say, the decoded word calculation unit 309 is configured of five decoded word calculators 309₁ to 309₅, calculates the decoding result (decoded word) based on equation (5) as a final stage of a plurality of times of decoding using the five messages D308 (D308₁ to D308₅) (message uⱼ in equation (5)) output by the selector 305 and the five received values D309 (received value u₀ᵢ in equation (5)) supplied from the received data memory 306, and supplies decoded data D315 obtained as a result to the decoded data rearrangement unit 311.

The decoded data rearrangement unit 311 applies the inverse permutation of the column permutation in equation (12) to the decoded data D315 supplied from the decoded word calculation unit 309, thereby rearranging an order thereof and outputs the same as a final decoded result D316.

As described above, by applying any one or both of the row permutation and the column permutation to the parity check matrix (original parity check matrix) and converting the same to the parity check matrix (conversion parity check matrix) represented by the combination of the P × P unit matrix, the quasi-unit matrix in which one or more of the elements of 1 of the unit matrix is set to 0, the shift matrix obtained by the cyclic shift of the unit matrix or the quasi-unit matrix, the sum matrix obtained by summing a plurality of the unit matrix, the quasi-unit matrix, and the shift matrix, and the P × P 0 matrix, that is to say, the combination of the constitutive matrices, it becomes possible to adopt the architecture to simultaneously perform the P check node operations and the P variable node operations as the decoding of the LDPC code where P is fewer than the numbers of the columns and rows in the parity. When it adopts the architecture to simultaneously perform the P check node operations and the P variable node operations as the decoding of the LDPC code where P is fewer than the numbers of the columns and rows in the parity check matrix, the operation frequency may be limited within the feasible range to perform a great number of times of repetitive decoding, as compared to a case that the node operations are performed at the same time for the same numbers of the numbers of the columns and rows in the parity check matrix.

The LDPC decoder 166, which configures the receiving device 12 in Fig. 118, performs the LDPC decoding by simultaneously performing the P check node operations and the P variable node operations as is the case with the decoding device in Fig. 124.

That is to say, in order to simplify the description, supposing that the parity check matrix of the LDPC code output by the LDPC encoder 115 configuring the transmitting device 11 in Fig. 8 is the parity check matrix H in which the parity matrix has the stepwise structure illustrated in Fig. 121, for example, the parity interleaver 23 of the transmitting device 11 performs the parity interleave to interleave the K + qx + y + 1-th code bit to the position of the K + Py + × + 1-th code bit by setting the information length K, the number of columns being the unit of the cyclic structure, and the submultiple q (= M/P) of the parity length M to 60, 5, and 6, respectively.

The parity interleave corresponds to the column permutation in equation (12) as described above, so that the LDPC decoder 166 is not required to perform the column permutation in equation (12).

Therefore, in the receiving device 12 in Fig. 118, as described above, the LDPC code to which the parity deinterleave is not applied, that is to say, the LDPC code in a state in which the column permutation in equation (12) is performed is supplied from the column twist deinterleaver 55 to the LDPC decoder 166, and the LDPC decoder 166 performs the process similar to that of the decoding device in Fig. 124 except that this does not perform the column permutation in equation (12).

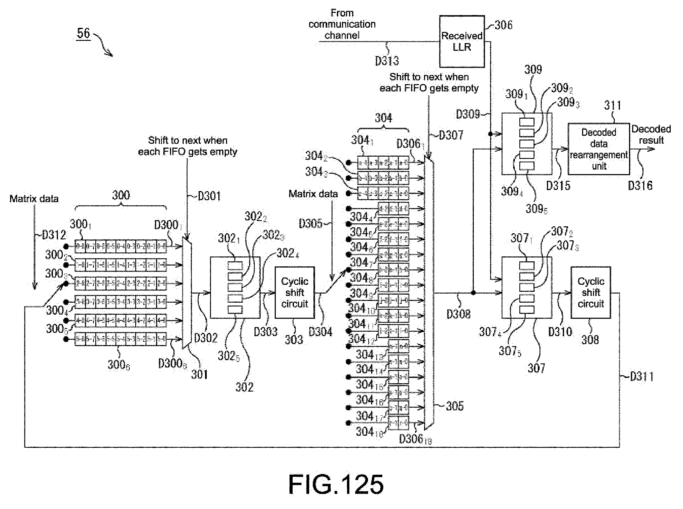

That is to say, Fig. 125 shows a configuration example of the LDPC decoder 166 in Fig. 118.

In Fig. 125, the LDPC decoder 166 is configured as the decoding device in Fig. 124 except that the received data rearrangement unit 310 in Fig. 124 is not provided, and this performs the process similar to that of the decoding device in Fig. 124 except that the column permutation in equation (12) is not performed, so that the description thereof is omitted.

As described above, the LDPC decoder 166 may be configured without the received data rearrangement unit 310, so that a scale thereof may be made smaller than that of the decoding device in Fig. 124.

Although the code length N in the LDPC code, the information length K, the number of columns (the number of rows and the number of columns of the constitutive matrix) being the unit of the cyclic structure P, and the submultiple q (= M/P) of the parity length M in the LDPC code are set to 90, 60, 5, and 6, respectively, in Fig. 121 to Fig. 125 in order to simplify the description, the code length N, the information length K, the number of columns P being the unit of the cyclic structure, and the submultiple q (= M/P) are not limited to the above-described values.

That is to say, in the transmitting device 11 in Fig. 8, the LDPC encoder 115 outputs the LDPC code of the code length N of 64800, 16200 and the like, the information length K of N - Pq (= N - M), the number of columns P being the unit of the cyclic structure of 360, and the submultiple q of M/P, for example, the LDPC decoder 166 in Fig. 125 may also be applied to a case in which the LDPC decoding is performed by simultaneously performing the P check node operations and the P variable node operations to such LDPC code.

### <Block diagram showing configuration example of block deinterleaver 54>

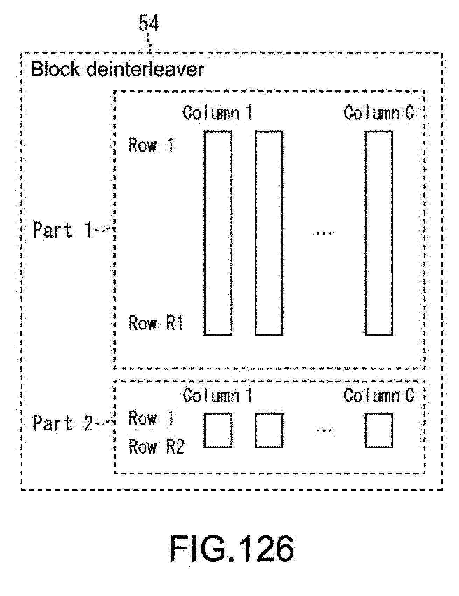

Fig. 126 is a block diagram showing a configuration example of a block deinterleaver 54.

The block deinterleaver 54 is configured similar to the block deinterleaver 25 illustrated in Fig. 106.

The block deinterleaver 54 has a storage region called as Part 1 and a storage region called as Part 2. The Parts 1 and 2 store one bit in a row direction. The number C of columns that are the storage regions for storing the predetermined number of bits in a column direction are arranged. The number C is equal to the number of bits m of the symbols.

The block deinterleaver 54 preforms the block deinterleave to the parts 1 and 2 by writing and reading the LDPC code.

In the block deinterleave, the LDPC code (as the symbol) is written in an order that the block interleaver in Fig. 106 reads the LDPC code.

Further, in the block deinterleave, the LDPC code is read in an order that the block interleaver 25 in Fig. 106 writes the LDPC code.

That is to say, in the block interleave by the block interleaver 25 in Fig. 106, the LDPC code is written to the parts 1 and 2 in the column direction and is read in the row direction. In the block deinterleave by the block deinterleaver 54 in Fig. 126, the LDPC code is written to the parts 1 and 2 in the row direction and is read in the column direction.

### <Another configuration example of bit deinterleaver 165>

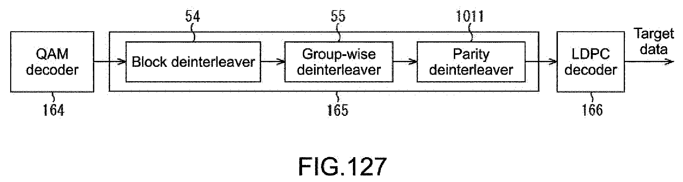

Fig. 127 is a block diagram illustrating another configuration example of the bit deinterleaver 165 in Fig. 118.

In the drawing, the same reference numeral is assigned to a part corresponding to that in Fig. 119 and the description thereof is hereinafter appropriately omitted.

That is to say, the bit deinterleaver 165 in Fig. 127 is configured in the same manner as that in Fig. 119 except that a parity deinterleaver 1011 is newly provided.

In Fig. 127, the bit deinterleaver 165 is configured of the block deinterleaver 54, the group-wise deinterleaver 55, and the parity deinterleaver 1011 and performs the bit deinterleave of the code bit of the LDPC code from the demapper 164.

That is to say, the block deinterleaver 54 performs the block deinterleave (inverse process of the block interleave) corresponding to the block interleave performed by the block interleaver 25 of the transmitting device 11 for the LDPC code from the demapper 164, i.e., the block deinterleave to return the position of the code bit interchanged by the block interleave to the original position, and supplies the LDPC code obtained as a result to the group-wise deinterleaver 55.

The group-wise deinterleaver 55 applies the group-wise deinterleave corresponding to the group-wise interleave as the rearranging process performed by the group-wise interleaver 24 of the transmitting device 11 to the LDPC code from the block deinterleaver 54.

The LDPC code obtained as a result of the group-wise deinterleave is supplied from the group-wise deinterleaver 55 to the parity deinterleaver 1011.

The parity deinterleaver 1011 applies the parity deinterleave (inverse process of the parity interleave) corresponding to the parity interleave performed by the parity interleaver 23 of the transmitting device 11, that is to say, the parity deinterleave to return the code bit of the LDPC code, the arrangement of which is changed by the parity interleave, to the original arrangement for the code bit after the group-wise deinterleave by the group-wise deinterleaver 55.

The LDPC code obtained as a result of the parity deinterleave is supplied from the parity deinterleaver 1011 to the LDPC decoder 166.

Therefore, in the bit deinterleaver 165 in Fig. 127, the LDPC code to which the block deinterleave, the group-wise deinterleave, and the parity deinterleave are applied, that is to say, the LDPC code obtained by the LDPC encoding according to the parity check matrix H is supplied to the LDPC decoder 166.

The LDPC decoder 166 performs the LDPC decoding of the LDPC code from the bit deinterleaver 165 using the parity check matrix H used by the LDPC encoder 115 of the transmitting device 11. That is to say, the LDPC decoder 166 performs the LDPC decoding of the LDPC code from the bit deinterleaver 165 using the parity check matrix H itself used by the LDPC encoder 115 of the transmitting device 11 in the LDPC encoding or the conversion parity check matrix obtained by at least applying the column permutation corresponding to the parity interleave to the parity check matrix H.

Herein, in Fig. 127, since the LDPC code obtained by the LDPC encoding according to the parity check matrix H is supplied from (the parity deinterleaver 1011 of) the bit deinterleaver 165 to the LDPC decoder 166, the LDPC decoder 166 may be configured of the decoding device, which performs the LDPC decoding by a full serial decoding scheme to sequentially perform the operation of the message (check node message and the variable node message) one node after another, and the decoding device, which performs the LDPC decoding by a full parallel decoding scheme to simultaneously perform the operation of the message (in parallel) for all the nodes, for example, when the LDPC decoding of the LDPC code is performed using the parity check matrix H itself used by the LDPC encoder 115 of the transmitting device 11 in the LDPC encoding.

Also, when the LDPC decoder 166 performs the LDPC decoding of the LDPC code using the conversion parity check matrix obtained by at least performing the column permutation corresponding to the parity interleave of the parity check matrix H used by the LDPC encoder 115 of the transmitting device 11 in the LDPC encoding, the LDPC decoder 166 may be configured of the decoding device of the architecture to simultaneously perform the P (or submultiple of P other than 1) check node operations and variable node operations being the decoding device (Fig. 124) including the received data rearrangement unit 310 to rearrange the code bits of the LDPC code by applying the column permutation similar to the column permutation for obtaining the conversion parity check matrix to the LDPC code.

Although the block deinterleaver 54, which performs the block deinterleave, the group-wise deinterleaver 55, which performs the group-wise deinterleave, and the parity deinterleaver 1011, which performs the parity deinterleave, are separately formed for convenience of description in Fig. 127, two or more of the block deinterleaver 54, the group-wise deinterleaver 55, and the parity deinterleaver 1011 may be integrally formed as the parity interleaver 23, the group-wise interleaver 24, and the block interleaver 25 of the transmitting device 11.

### <Configuration example of receiving system>

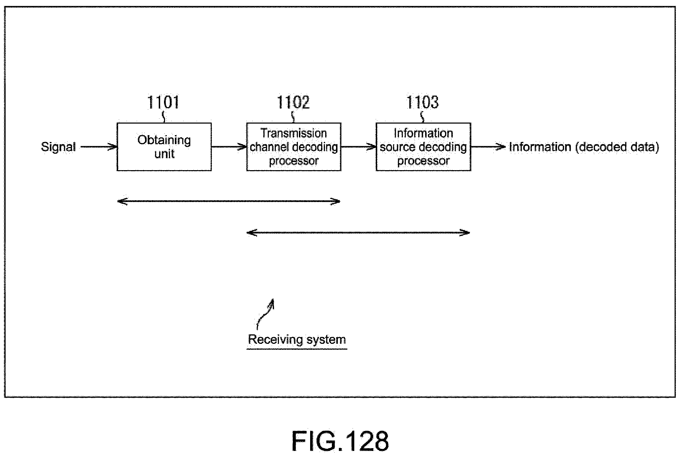

Fig. 128 is a block diagram showing a first configuration example of a receiving system to which the receiving device 12 may be applied.

In Fig. 128, the receiving system is configured of an obtaining unit 1101, a transmission channel decoding processor 1102, and an information source decoding processor 1103.

The obtaining unit 1101 obtains a signal including the LDPC code obtained by at least the LDPC encoding of the LDPC target data such as the image data and the audio data of the program through a transmission channel (communication channel) (not shown) such as digital terrestrial broadcasting, digital satellite broadcasting, and a network such as a CATV network, the Internet and the like, for example, to supply to the transmission channel decoding processor 1102.

Herein, if the signal obtained by the obtaining unit 1101 is broadcasted from a broadcasting station through the terrestrial wave, a satellite wave, the CATV (cable television) network and the like, for example, the obtaining unit 1101 is configured of a tuner, an STB (set top box) and the like. When the signal obtained by the obtaining unit 1101 is multicast-transmitted from a web server such as IPTV (Internet protocol television), for example, the obtaining unit 1101 is configured of a network I/F (interface) such as an NIC (network interface card), for example.

The transmission channel decoding processor 1102 corresponds to the receiving device 12. The transmission channel decoding processor 1102 applies a transmission channel decoding process at least including a process to correct the error occurring in the transmission channel to the signal obtained by the obtaining unit 1101 through the transmission channel and supplies the signal obtained as a result to the information source decoding processor 1103.

That is to say, the signal obtained by the obtaining unit 1101 through the transmission channel is the signal obtained by at least the error correction encoding for correcting the error occurring in the transmission channel and the transmission channel decoding processor 1102 applies the transmission channel decoding process such as an error correction process, for example, to such signal.

Herein, the error correction encoding includes the LDPC encoding, BCH encoding and the like, for example. Herein, the LDPC encoding is at least performed as the error correction encoding.

Also, the transmission channel decoding process may include demodulation of a modulated signal and the like.

The information source decoding processor 1103 applies an information source decoding process at least including a process to expand compressed information to original information to the signal to which the transmission channel decoding process is applied.

That is to say, there is a case in which compression encoding to compress the information is applied to the signal obtained by the obtaining unit 1101 through the transmission channel so as to decrease a data volume of the image and the audio as the information, and in this case, the information source decoding processor 1103 applies the information source decoding process such as the process to expand the compressed information to the original information (expanding process) to the signal to which the transmission channel decoding process is applied.

If the compression encoding is not applied to the signal obtained by the obtaining unit 1101 through the transmission channel, the information source decoding processor 1103 does not perform the process to expand the compressed information to the original information.

Herein, the expanding process includes MPEG decoding and the like, for example. Also, the transmission channel decoding process might include descrambling and the like in addition to the expanding process.

In the receiving system configured as above, the obtaining unit 1101 applies the compression encoding such as MPEG encoding to the data of the image and the audio, for example, and obtains the signal to which the error correction encoding such as the LDPC encoding is applied through the transmission channel to supply to the transmission channel decoding processor 1102.

The transmission channel decoding processor 1102 applies the process similar to that performed by the receiving device 12 and the like to the signal from the obtaining unit 1101 as the transmission channel decoding process, for example, and the signal obtained as a result is supplied to the information source decoding processor 1103.

The information source decoding processor 1103 applies the information source decoding process such as the MPEG decoding to the signal from the transmission channel decoding processor 1102 and outputs the image or the audio obtained as a result.

The receiving system in Fig. 128 as described above may be applied to a television tuner and the like, which receives television broadcasting as the digital broadcasting, for example.

It is possible to form each of the obtaining unit 1101, the transmission channel decoding processor 1102, and the information source decoding processor 1103 as one independent device (hardware (IC (integrated circuit) and the like) or a software module).

Also, as for the obtaining unit 1101, the transmission channel decoding processor 1102, and the information source decoding processor 1103, it is possible to form a set of the obtaining unit 1101 and the transmission channel decoding processor 1102, a set of the transmission channel decoding processor 1102 and the information source decoding processor 1103, and a set of the obtaining unit 1101, the transmission channel decoding processor 1102, and the information source decoding processor 1103 as one independent device.

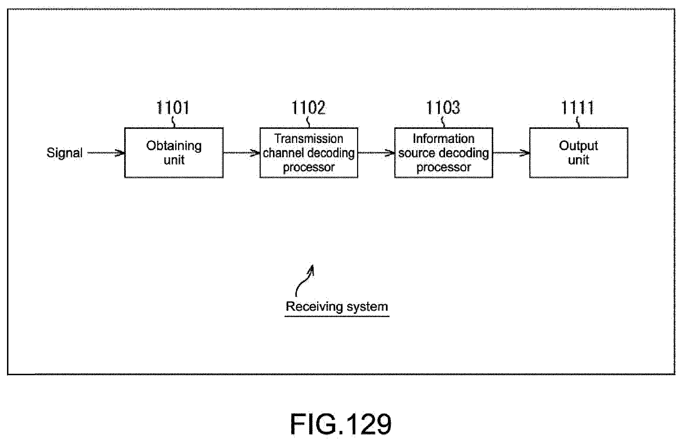

Fig. 129 is a block diagram illustrating a second configuration example of the receiving system to which the receiving device 12 may be applied.

Meanwhile, in the drawing, the same reference numeral is assigned to a part corresponding to that in Fig. 128 and the description thereof is hereinafter appropriately omitted.

The receiving system in Fig. 129 is the same as that in Fig. 128 in that this includes the obtaining unit 1101, the transmission channel decoding processor 1102, and the information source decoding processor 1103 and is different from that in Fig. 128 in that an output unit 1111 is newly provided.

The output unit 1111 is a display device, which displays the image, and a speaker, which outputs the audio, for example, and this outputs the image, the audio and the like as the signal output from the information source decoding processor 1103. That is to say, the output unit 1111 displays the image or outputs the audio.

The receiving system in Fig. 129 as described above may be applied to a TV (television receiver), which receives the television broadcasting as the digital broadcasting, a radio receiver, which receives radio broadcasting, and the like, for example.

If the compression encoding is not applied to the signal obtained by the obtaining unit 1101, the signal output by the transmission channel decoding processor 1102 is supplied to the output unit 1111.

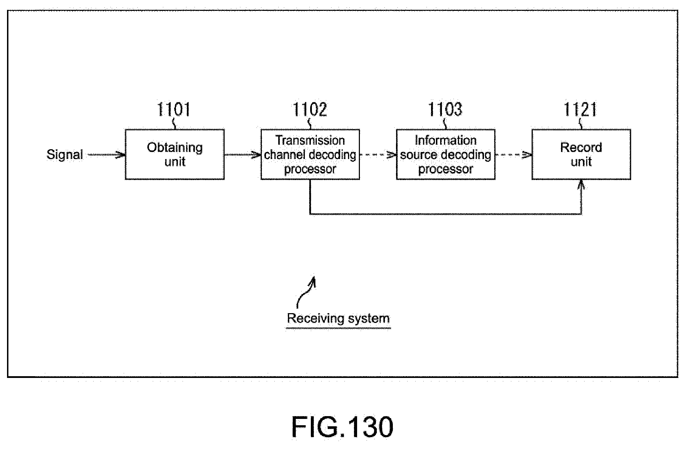

Fig. 130 is a block diagram showing a third configuration example of the receiving system to which the receiving device 12 may be applied.

In the drawing, the same reference numeral is assigned to a part corresponding to that in Fig. 128 and the description thereof is hereinafter appropriately omitted.

The receiving system in Fig. 130 is the same as that in Fig. 128 in that this includes the obtaining unit 1101 and the transmission channel decoding processor 1102.

However, the receiving system in Fig. 130 is different from that in Fig. 128 in that the information source decoding processor 1103 is not provided and a record unit 1121 is newly provided.

The record unit 1121 records (stores) the signal output from the transmission channel decoding processor 1102 (for example, a TS packet of MPEG TS) in a recording (storage) medium such as an optical disk, a hard disk (magnetic disk), and a flash memory.

The receiving system in Fig. 130 as described above may be applied to a recorder and the like, which records the television broadcasting.

In Fig. 130, the receiving system may be provided with the information source decoding processor 1103 and the information source decoding processor 1103 may record the signal to which the information source decoding process is applied, that is to say, the image and the audio obtained by the decoding in the record unit 1121.

### [One embodiment of computer]

A series of processes described above may be performed by hardware or by software. When a series of processes is performed by the software, a program, which configures the software, is installed on a multipurpose computer and the like.

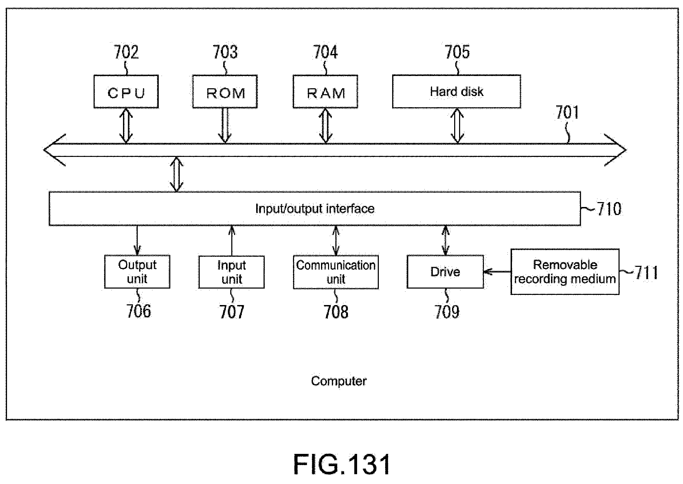

Fig. 131 shows a configuration example of one embodiment of the computer on which the program, which executes a series of processes described above, is installed.

The program may be recorded in advance in a hard disk 705 and a ROM 703 as a recording medium stored in the computer.

Alternatively, the program may be temporarily or permanently stored (recorded) in a removable recording medium 711 such as a flexible disk, a CD-ROM (compact disc read only memory), an MO (magnetooptical) disk, a DVD (digital versatile disc), the magnetic disk, and a semiconductor memory. Such removable recording medium 711 may be provided as so-called packaged software.

In addition to installation from the above-described removable recording medium 711 on the computer, the program may be transferred from a downloading site to the computer by wireless through a satellite for the digital satellite broadcasting or transferred to the computer by wire through the network such as a LAN (local area network) and the Internet, and the computer may receive the program transferred in this manner by a communication unit 708 to install on an internal hard disk 705.

The computer has a CPU (central processing unit) 702 built-in. An input/output interface 710 is connected to the CPU 702 through a bus 701 and, when an instruction is input through the input/output interface 710 by operation and the like of the input unit 707 configured of a keyboard, a mouse, a microphone and the like by a user, the CPU 702 executes the program stored in the ROM (read only memory) 703 according to the same. Alternatively, the CPU 702 loads the program stored in the hard disk 705, the program transferred from the satellite or the network to be received by the communication unit 708 and installed on the hard disk 705, or the program read from the removable recording medium 711 mounted on a drive 709 to be installed on the hard disk 705 on a RAM (random access memory) 704 to execute. According to this, the CPU 702 performs the process according to the above-described flowchart or the process performed by the configuration of the above-described block diagram. Then, the CPU 702 outputs a processing result from an output unit 706 configured of an LCD (liquid crystal display), a speaker and the like, or transmits the same from the communication unit 708, or records the same in the hard disk 705 through the input/output interface 710, for example, as needed.

Herein, in this specification, a processing step to write the program to allow the computer to perform various processes is not necessarily required to be processed in chronological order along order described in the flowchart and this also includes the process executed in parallel or individually executed (for example, a parallel process or a process by an object).

Also, the program may be processed by one computer or distributedly processed by a plurality of computers. Further, the program may be transferred to a remote computer to be executed.

The embodiment of the present technology is not limited to the above-described embodiment and various modifications may be made without departing from the scope of the present technology.

For example, (the parity check matrix initial value table of) the above-described new LDPC code may be through the communication channel 13 (Fig. 7), any of which is a satellite circuit, a terrestrial wave, and a cable (wire circuit). Furthermore, the new LDPC code may be used for data transmission other than the digital broadcasting.

The above-described GW patterns may be applied to any other than the new LDPC code. Furthermore, the modulation scheme to which the above-described GW patterns are applied is not limited to 16QAM, 64QAM, 256QAM and 1024QAM.

Effects described herein are not limited only to be illustrative, there may be effects other than those described herein.

### Description of reference numerals

11 transmitting device
12 receiving device
23 parity interleave
24 group-wise interleaver
25 block interleaver
31 memory
32 interchange unit
54 block deinterleaver
55 group-wise interleaver
111 mode adaptation/multiplexer
112 padder
113 BB scrambler
114 BCH encoder
115 LDPC encoder
116 bit interleaver
117 mapper
118 time interleaver
119 SISO/MISO encoder
120 frequency interleaver
121 BCH encoder
122 LDPC encoder
123 mapper
124 frequency interleaver
131 frame builder & resource allocation
132 OFDM generation
151 OFDM processor
152 frame management
153 frequency deinterleaver
154 demapper
155 LDPC decoder
156 BCH decoder
161 frequency deinterleaver
162 SISO/MISO decoder
163 time deinterleaver
164 demapper
165 bit deinterleaver
166 LDPC decoder
167 BCH decoder
168 BB descrambler
169 null deletion
170 demultiplexer
300 edge data storage memory
301 selector
302 check node calculation unit
303 cyclic shift circuit
304 edge data storage memory
305 selector
306 received data memory
307 variable node calculation unit
308 cyclic shift circuit
309 decoded word calculation unit
310 received data rearrangement unit
311 decoded data rearrangement unit
601 encoding processor
602 storage unit
611 code rate set unit
612 initial value table read unit
613 parity check matrix generation unit
614 information bit read unit
615 encoding parity operation unit
616 controller
701 bus
702 CPU
703 ROM
704 RAM
705 hard disk
70 output unit
707 input unit
708 communication unit
709 drive
710 input/output interface
711 removable recording medium
1001 inverse interchange unit
1002 memory
1011 parity deinterleaver
1101 obtaining unit
1101 transmitting channel decoding processor
1103 information source decoding processor
1111 output unit
1121 record unit

## Claims

1. A data processing device, comprising:
a group-wise interleave unit of performing group-wise interleave of interleaving in a 360-bit group unit an LDPC code whose code length is 16200 bits and code rate is 6/15, 7/15, 8/15 or 9/15,
the (i + 1)th bit group from the beginning of the LDPC code of the 16200 bits being as a bit group i, and
in the group-wise interleave, a sequence of bit group 0 to 44 of the 16200 bits of the LDPC code being interleaved into the following sequence of the bit group:
15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

2. The data processing device according to claim 1, further comprising:
a mapping unit of mapping the LDPC code onto any of 16 signal points defined by a modulation scheme in a 4 bits unit.

3. The data processing device, according to claim 1, further comprising:
an encoder, which performs LDPC encoding based on a parity check matrix of an LDPC code whose code length is 16200 bits and code rate is 6/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as 13 88 136 188 398 794 855 918 954 1950 2762 2837 2847 4209 4342 5092 5334 5498 5731 5837 6150 6942 7127 7402 7936 8235 8307 8600 9001 9419 9442 9710 619 792 1002 1148 1528 1533 1925 2207 2766 3021 3267 3593 3947 4832 4873 5109 5488 5882 6079 6097 6276 6499 6584 6738 6795 7550 7723 7786 8732 9060 9270 9401 499 717 1551 1791 2535 3135 3582 3813 4047 4309 5126 5186 5219 5716 5977 6236 6406 6586 6591 7085 7199 7485 7726 7878 8027 8066 8425 8802 9309 9464 9553 9671 658 4058 7824 8512
3245 4743 8117 9369
465 6559 8112 9461
975 2368 4444 6095
4128 5993 9182 9473
9 3822 5306 5320
4 8311 9571 9669
13 8122 8949 9656
3353 4449 5829 8053
7885 9118 9674
7575 9591 9670
431 8123 9271
4228 7587 9270
8847 9146 9556
11 5213 7763.

4. The data processing device, according to claim 1, further comprising:
an encoder, which performs LDPC encoding based on a parity check matrix of an LDPC code whose code length is 16200 bits and code rate is 7/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as 432 655 893 942 1285 1427 1738 2199 2441 2565 2932 3201 4144 4419 4678 4963 5423 5922 6433 6564 6656 7478 7514 7892
220 453 690 826 1116 1425 1488 1901 3119 3182 3568 3800 3953 4071 4782 5038 5555 6836 6871 7131 7609 7850 8317 8443
300 454 497 930 1757 2145 2314 2372 2467 2819 3191 3256 3699 3984 4538 4965 5461 5742 5912 6135 6649 7636 8078 8455
24 65 565 609 990 1319 1394 1465 1918 1976 2463 2987 3330 3677 4195 4240 4947 5372 6453 6950 7066 8412 8500 8599
1373 4668 5324 7777
189 3930 5766 6877
3 2961 4207 5747
1108 4768 6743 7106
1282 2274 2750 6204
2279 2587 2737 6344
2889 3164 7275 8040
133 2734 5081 8386
437 3203 7121
4280 7128 8490
619 4563 6206
2799 6814 6991
244 4212 5925
1719 7657 8554
53 1895 6685
584 5420 6856
2958 5834 8103.

5. The data processing device, according to claim 1, further comprising:
an encoder, which performs LDPC encoding based on a parity check matrix of an LDPC code whose code length is 16200 bits and code rate is 8/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
5 519 825 1871 2098 2478 2659 2820 3200 3294 3650 3804 3949 4426 4460 4503 4568 4590 4949 5219 5662 5738 5905 5911 6160 6404 6637 6708 6737 6814 7263 7412 81 391 1272 1633 2062 2882 3443 3503 3535 3908 4033 4163 4490 4929 5262 5399 5576 5768 5910 6331 6430 6844 6867 7201 7274 7290 7343 7350 7378 7387 7440 7554 105 975 3421 3480 4120 4444 5957 5971 6119 6617 6761 6810 7067 7353
6 138 485 1444 1512 2615 2990 3109 5604 6435 6513 6632 6704 7507
20 858 1051 2539 3049 5162 5308 6158 6391 6604 6744
7071 7195 7238
1140 5838 6203 6748
6282 6466 6481 6638
2346 2592 5436 7487
2219 3897 5896 7528
2897 6028 7018
1285 1863 5324
3075 6005 6466
5 6020 7551
2121 3751 7507
4027 5488 7542
2 6012 7011
3823 5531 5687
1379 2262 5297
1882 7498 7551
3749 4806 7227
2 2074 6898
17 616 7482
9 6823 7480
5195 5880 7559.

6. The data processing device, according to claim 1, further comprising:
an encoder, which performs LDPC encoding based on a parity check matrix of an LDPC code whose code length is 16200 bits and code rate is 9/15,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as 350 462 1291 1383 1821 2235 2493 3328 3353 3772 3872 3923 4259 4426 4542 4972 5347 6217 6246 6332 6386 177 869 1214 1253 1398 1482 1737 2014 2161 2331 3108 3297 3438 4388 4430 4456 4522 4783 5273 6037 6395 347 501 658 966 1622 1659 1934 2117 2527 3168 3231 3379 3427 3739 4218 4497 4894 5000 5167 5728 5975 319 398 599 1143 1796 3198 3521 3886 4139 4453 4556 4636 4688 4753 4986 5199 5224 5496 5698 5724 6123 162 257 304 524 945 1695 1855 2527 2780 2902 2958 3439 3484 4224 4769 4928 5156 5303 5971 6358 6477 807 1695 2941 4276
2652 2857 4660 6358
329 2100 2412 3632
1151 1231 3872 4869
1561 3565 5138 5303
407 794 1455
3438 5683 5749
1504 1985 3563
440 5021 6321
194 3645 5923
1217 1462 6422
1212 4715 5973
4098 5100 5642
5512 5857 6226
2583 5506 5933
784 1801 4890
4734 4779 4875
938 5081 5377
127 4125 4704
1244 2178 3352
3659 6350 6465
1686 3464 4336.

7. A data processing method, comprising:
a step of group-wise interleaving, which group-wise interleaves an LDPC code whose code length is 16200 bits and code rate is 6/15, 7/15, 8/15 or 9/15 in a 360-bit group unit,
the (i + 1)th bit group from the beginning of the LDPC code of the 16200 bits being as a bit group i, and
in the group-wise interleave, a sequence of bit group 0 to 44 of the 16200 bits of the LDPC code being interleaved into the following sequence of the bit group:
15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

8. A data processing device, comprising:
a group-wise interleave unit of performing group-wise interleave of interleaving in a 360-bit group unit an LDPC code whose code length is 16200 bits and code rate is 6/15, 7/15, 8/15 or 9/15, and
of returning a sequence of the LDPC code after the group-wise interleave obtained from data transmitted from a transmitting device to the original sequence,
the (i + 1)th bit group from the beginning of the LDPC code of the 16200 bits being as a bit group i, and
in the group-wise interleave, a sequence of bit group 0 to 44 of the 16200 bits of the LDPC code being interleaved into the following sequence of the bit group:
15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.

9. The data processing device according to claim 8, further comprising:
a demapping unit of demapping the mapped data obtained from the data transmitted from the transmitting device further comprising a mapping unit of mapping the LDPC code onto any of 16 signal points defined by a modulation scheme in a 4 bits unit.

10. The data processing device, according to claim 8, further comprising:
an encoder, which performs LDPC encoding based on a parity check matrix of an LDPC code whose code length is 16200 bits and code rate is 6/15, and
a decoder, which decodes the LDPC code provided from the data transmitted from the transmitting device,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as
13 88 136 188 398 794 855 918 954 1950 2762 2837 2847 4209 4342 5092 5334 5498 5731 5837 6150 6942 7127 7402 7936 8235 8307 8600 9001 9419 9442 9710
619 792 1002 1148 1528 1533 1925 2207 2766 3021 3267 3593 3947 4832 4873 5109 5488 5882 6079 6097 6276 6499 6584 6738 6795 7550 7723 7786 8732 9060 9270 9401
499 717 1551 1791 2535 3135 3582 3813 4047 4309 5126 5186 5219 5716 5977 6236 6406 6586 6591 7085 7199 7485 7726 7878 8027 8066 8425 8802 9309 9464 9553 9671 658 4058 7824 8512
3245 4743 8117 9369
465 6559 8112 9461
975 2368 4444 6095
4128 5993 9182 9473
9 3822 5306 5320
4 8311 9571 9669
13 8122 8949 9656
3353 4449 5829 8053
7885 9118 9674
7575 9591 9670
431 8123 9271
4228 7587 9270
8847 9146 9556
11 5213 7763.

11. The data processing device, according to claim 8, further comprising:
an encoder, which performs LDPC encoding based on a parity check matrix of an LDPC code whose code length is 16200 bits and code rate is 7/15, and
a decoder, which decodes the LDPC code provided from the data transmitted from the transmitting device,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as 432 655 893 942 1285 1427 1738 2199 2441 2565 2932 3201 4144 4419 4678 4963 5423 5922 6433 6564 6656 7478 7514 7892
220 453 690 826 1116 1425 1488 1901 3119 3182 3568 3800 3953 4071 4782 5038 5555 6836 6871 7131 7609 7850 8317 8443
300 454 497 930 1757 2145 2314 2372 2467 2819 3191 3256 3699 3984 4538 4965 5461 5742 5912 6135 6649 7636 8078 8455
24 65 565 609 990 1319 1394 1465 1918 1976 2463 2987 3330 3677 4195 4240 4947 5372 6453 6950 7066 8412 8500 8599
1373 4668 5324 7777
189 3930 5766 6877
3 2961 4207 5747
1108 4768 6743 7106
1282 2274 2750 6204
2279 2587 2737 6344
2889 3164 7275 8040
133 2734 5081 8386
437 3203 7121
4280 7128 8490
619 4563 6206
2799 6814 6991
244 4212 5925
1719 7657 8554
53 1895 6685
584 5420 6856
2958 5834 8103.

12. The data processing device, according to claim 8, further comprising:
an encoder, which performs LDPC encoding based on a parity check matrix of an LDPC code whose code length is 16200 bits and code rate is 8/15, and
a decoder, which decodes the LDPC code provided from the data transmitted from the transmitting device,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as 5 519 825 1871 2098 2478 2659 2820 3200 3294 3650 3804 3949 4426 4460 4503 4568 4590 4949 5219 5662 5738 5905 5911 6160 6404 6637 6708 6737 6814 7263 7412 81 391 1272 1633 2062 2882 3443 3503 3535 3908 4033 4163 4490 4929 5262 5399 5576 5768 5910 6331 6430 6844 6867 7201 7274 7290 7343 7350 7378 7387 7440 7554 105 975 3421 3480 4120 4444 5957 5971 6119 6617 6761 6810 7067 7353
6 138 485 1444 1512 2615 2990 3109 5604 6435 6513 6632 6704 7507
20 858 1051 2539 3049 5162 5308 6158 6391 6604 6744 7071 7195 7238
1140 5838 6203 6748
6282 6466 6481 6638
2346 2592 5436 7487
2219 3897 5896 7528
2897 6028 7018
1285 1863 5324
3075 6005 6466
5 6020 7551
2121 3751 7507
4027 5488 7542
2 6012 7011
3823 5531 5687
1379 2262 5297
1882 7498 7551
3749 4806 7227
2 2074 6898
17 616 7482
9 6823 7480
5195 5880 7559.

13. The data processing device, according to claim 8, further comprising:
an encoder, which performs LDPC encoding based on a parity check matrix of an LDPC code whose code length is 16200 bits and code rate is 9/15, and
a decoder, which decodes the LDPC code provided from the data transmitted from the transmitting device,
the LDPC code including information bits and parity bits,
the parity check matrix including an information matrix part corresponding to the information bits and a parity matrix part corresponding to the parity bits,
the information matrix part being represented by a parity check matrix initial value table, and
the parity check matrix initial value table being a table indicating a position of an element 1 of the information matrix part for each 360 columns as 350 462 1291 1383 1821 2235 2493 3328 3353 3772 3872 3923 4259 4426 4542 4972 5347 6217 6246 6332 6386 177 869 1214 1253 1398 1482 1737 2014 2161 2331 3108 3297 3438 4388 4430 4456 4522 4783 5273 6037 6395 347 501 658 966 1622 1659 1934 2117 2527 3168 3231 3379 3427 3739 4218 4497 4894 5000 5167 5728 5975 319 398 599 1143 1796 3198 3521 3886 4139 4453 4556 4636 4688 4753 4986 5199 5224 5496 5698 5724 6123 162 257 304 524 945 1695 1855 2527 2780 2902 2958 3439 3484 4224 4769 4928 5156 5303 5971 6358 6477 807 1695 2941 4276
2652 2857 4660 6358
329 2100 2412 3632
1151 1231 3872 4869
1561 3565 5138 5303
407 794 1455
3438 5683 5749
1504 1985 3563
440 5021 6321
194 3645 5923
1217 1462 6422
1212 4715 5973
4098 5100 5642
5512 5857 6226
2583 5506 5933
784 1801 4890
4734 4779 4875
938 5081 5377
127 4125 4704
1244 2178 3352
3659 6350 6465
1686 3464 4336.

14. A data processing method, comprising:
a step of group-wise deinterleaving of returning a sequence of the LDPC code after group-wise interleave obtained from data transmitted from a transmitting device to the original sequence, the transmitting device comprising:
a group-wise interleave unit of performing group-wise interleave of interleaving in a 360-bit group unit an LDPC code whose code length is 16200 bits and code rate is 6/15, 7/15, 8/15 or 9/15,
the (i + 1)th bit group from the beginning of the LDPC code of the 16200 bits being as a bit group i, and in the group-wise interleave, a sequence of bit group 0 to 44 of the 16200 bits of the LDPC code being interleaved into the following sequence of the bit group:
15, 23, 9, 19, 5, 29, 4, 25, 8, 41, 13, 2, 22, 12, 26, 6, 37, 17, 38, 7, 20, 1, 39, 34, 18, 31, 10, 44, 32, 24, 14, 42, 11, 30, 27, 3, 36, 40, 33, 21, 28, 43, 0, 16, 35.
